(19) Europäisches Patentamt
European Patent Office
Office européen des brevets

(11) EP 3 070 756 B1

(12) EUROPEAN PATENT SPECIFICATION

(45) Date of publication and mention of the grant of the patent:
**14.07.2021 Bulletin 2021/28**

(51) Int Cl.:
***H01L 51/46*** *(2006.01)* ***H01L 51/54*** *(2006.01)*
***H01L 51/30*** *(2006.01)*

(21) Application number: **16000415.6**

(22) Date of filing: **19.02.2016**

(54) **SEMICONDUCTOR MIXTURES COMPRISING NANOPARTICLES**

HALBLEITERMISCHUNGEN MIT NANOPARTIKELN

MÉLANGES DE SEMI-CONDUCTEURS COMPRENANT DES NANOPARTICULES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.03.2015 EP 15000808**

(43) Date of publication of application:
**21.09.2016 Bulletin 2016/38**

(73) Proprietor: **Raynergy Tek Inc.**
**Hsinchu 30075 (TW)**

(72) Inventors:
- **Morse, Graham**
  **Southampton, SO14 5GP (GB)**
- **Lozman, Owen**
  **Southampton, SO31 5HL (GB)**

(74) Representative: **Lawrie IP Limited**
**310 St. Vincent Street**
**Glasgow G2 5RG (GB)**

(56) References cited:
**WO-A1-2015/006473** **WO-A1-2015/019941**
**US-A1- 2011 132 440** **US-A1- 2013 043 434**

- **Anonymous: "ORGANOSILICASOL (TM) - Nissan Chemical", , 3 July 2016 (2016-07-03), XP055285434, Retrieved from the Internet: URL:http://www.nissanchem-usa.com/products/organosilicasol/ [retrieved on 2016-07-04]**
- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 070 756 B1

## Description

### Technical Field

The invention relates to novel semiconductor mixtures comprising an electron donor, an electron acceptor, a nanoparticle and optionally a solvent, to their use in organic electronic (OE) devices, especially organic photovoltaic (OPV) devices and organic photodetectors (OPD) or organic field effect transistors (OFET), and to OE, OPV, OPD and OFET devices comprising these mixtures.

### Background

The photosensitive layer in an organic photovoltaic (OPV) or an organic photodetector (OPD) device is composed of at least two materials, a p-type semiconductor such as a polymer, an oligomer or a define molecular unit and a n-type semiconductor such as a fullerene or substituted fullerene, graphene, a metal oxide, or quantum dots. One of the remaining challenges in the research is to find a consistent strategy to create wellformed and stable bulk heterojunctions. Approaches to impact the performance and stability of OPV devices as described in the literature are limited, for example, to using specific solvents or additives in formulation as described in J. Am. Chem. Soc. 2008, 130, 3619-3623, using template assisted fabrication of structures as described in ACS Nano 2009, 3 (6), 1415-1422, using cross-linked active layer materials as described in J. Mater. Chem., 2012, 22, 24417-24423, using amorphous n-type materials as described in Chem. Mater. 2009, 21, 2598-2600, or using core-shell particles comprising a core particle, for example silica, that is coated with fullerenes as described in US8519262B2.

US 2011/132440 describes core shell particles and bulk-heterojunction organic photovoltaic devices using the core shell particles. In particular, core shell particles having a core particle and a shell of a second material and bulk-heterojunction organic photovoltaic devices using the core-shell particles are described. The core-shell particles can have a core particle with an electron donating material. Formation of a bulk-heterojunction organic photovoltaic device using such core-shell particles forming an interpenetrating network with the electron donating or electron accepting phase is also described.

WO 2015/006473 describes composite layers demonstrating phaseseparated architectures which, in some embodiments, can mitigate performance disadvantages of prior organic layers of optoelectronic devices.

However, there remains a need for a consistent and general approach to form a high performance and stable bulk heterojunction from viscous formulations to ensure adequate film formation properties. For example, when using core-shell particles coated with fullerene derivatives the particles are not easily dispersed in organic solvents preventing the formation of a traditional bulk heterojunction because the fullerene is localized onto the particles and in addition the core-shell particles themselves may seed unfavorable fullerene crystallization.

In particular there is a need for semiconducting mixtures and formulations comprising p-type and n-type organic semiconductors which are suitable for manufacturing OE devices, in particular BHJ OPV devices, which show good structural organization and film-forming properties, exhibit good electronic properties, especially high charge carrier mobility, a good processability, a high solubility in organic solvents, a high solution viscosity, and high light and thermal stability.

It was an aim of the present invention to provide new semiconducting mixtures and formulations comprising a p-type and an n-type semiconductor which can overcome the drawbacks of the mixtures used in prior art and can provide one or more of the above-mentioned advantageous properties. Another aim of the invention was to extend the pool of p-type/n-type semiconductor combinations available to the expert. Other aims of the present invention are immediately evident to the expert from the following detailed description.

The inventors of the present invention have found that one or more of the above aims can be achieved by providing a semiconducting mixture as disclosed and claimed hereinafter.

In particular, the inventors of the present invention have surprisingly found that the addition of inert high surface area hydrophobic particles to an organic semiconductor or organic semiconductor mixture provides a rigid active layer support to support bulk heterojunction formation and stabilization in OE devices, especially in OPV, OPD or OFET applications.

### Summary

According to a first aspect of the invention there is provided a mixture for use in forming a solution, the mixture comprising a p-type semiconductor, an n-type semiconductor, and one or more nanoparticles, wherein the nanoparticles are hydrophobic and comprise silica, zeolite carbon, activated carbon, silsesquioxane, polysilsesquioxane, clay, or any combination of the aforementioned, wherein the nanoparticles are substituted by one or more identical or different groups R, wherein

R is CN or an alkyl group with 1 to 50 C atoms, which is straight-chain, branched or cyclic, and in which one or more $CH_2$ groups are optionally replaced by -O-, -S-,-C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$, $-CR^0=N-$, -N=N- or -C≡C- in such a manner that O and/or S atoms are not linked directly to one another, and/or in which one or more H atoms are optionally replaced by F, Cl, Br, I or CN and/or in which one or more H is replaced by a cationic or anionic group, or R is a saturated or unsaturated, non-aromatic carbo- or heterocyclic group, or an aryl, heteroaryl, aryloxy or heteroaryloxy group, wherein each of the aforementioned cyclic groups has 5 to 20 ring atoms, is mono- or polycyclic, does optionally contain fused rings, and is optionally substituted by one or more identical or different groups L,

L is halogen, -CN, -NC, -NCO, -NCS, -OCN, -SCN, $-C(=O)NR^0R^{00}$, $-C(=O)X^0$, $-C(=O)R^0$, $-NH_2$, $-NR^0R^{00}$, -SH, $-SR^0$, $-SO_3H$, $-SO_2R^0$, -OH, $-NO_2$, $-CF_3$, $-SF_5$, optionally substituted silyl, or carbyl or hydrocarbyl with 1 to 40 C atoms that is optionally substituted and optionally comprises one or more hetero atoms, preferably alkyl, alkoxy, thioalkyl, alkylcarbonyl, alkylcarbonyloxy, alkoxycarbonyl or alkoxycarbonyloxy with 1 to 20 C atoms that is optionally fluorinated,

$R^0$, $R^{00}$ are independently of each other H or alkyl with 1 to 12 C atoms, or a silyl group with 1 to 20 Si atoms that is optionally alkylated,

$X^0$ is halogen, preferably F, Cl or Br,

and the n-type semiconductor and the nanoparticles contained in the mixture are not chemically linked to each other but are separate mixture components.

The invention relates to the mixture of the first aspect comprising
a semiconducting compound having electron donor property, or p-type semiconductor, which is preferably a conjugated polymer,
a semiconducting compound having electron acceptor property, or n-type semiconductor, which is preferably a fullerene or substituted fullerene,
one or more nanoparticles,
optionally a solvent, which is preferably an organic solvent.

The invention further relates to the mixture of the first aspect, further comprising one or more compounds which are selected from compounds having one or more of a semiconducting, charge transport, hole transport, electron transport, hole blocking, electron blocking, electrically conducting, photoconducting, photoactive and light emitting property.

The invention further relates to a semiconducting, charge transport, electrically conducting, photoconducting, photoactive, thermoelectric or light emitting material, which comprises or consists of the mixture of the first aspect.

The invention further relates to the use of the mixture of the first aspect as semiconducting, charge transport, electrically conducting,
photoconducting, photoactive, thermoelectric or light emitting material in an organic electronic (OE) device, or in a component of such an OE
device, or in an assembly comprising such an OE device or such a component.

The invention further relates to the mixture of the first aspect, additionally comprising one or more solvents, preferably selected from organic solvents, very preferably from non-chlorinated organic solvents, most preferably from non-halogenated organic solvents.

The invention further relates to an OE device, or a component thereof, or an assembly comprising it, which is prepared using the mixture of the first aspect.

The invention further relates to an OE device, or a component thereof, or an assembly comprising it, which comprises the mixture of the first aspect or a semiconducting, charge transport, electrically conducting, photoconducting, photoactive or light emitting material as described above and below.

The OE device is preferably an optical, electrooptical, electronic, photoactive, electroluminescent or photoluminescent device.

The OE device includes, without limitation, organic field effect transistors (OFET), organic thin film transistors (OTFT), organic light emitting diodes (OLED), organic light emitting transistors (OLET), organic photovoltaic devices (OPV), organic photodetectors (OPD), organic solar cells, dye sensitized solar cells (DSSC), perovskite-based solar cells, laser diodes, Schottky diodes, photoconductors, photodetectors and thermoelectric devices.

Preferred OE devices are OFETs, OTFTs, OPVs, OPDs and OLEDs, in particular bulk heterojunction (BHJ) OPVs or inverted BHJ OPVs.

Further preferred is the use of the mixture as described in the first aspect as dye in a DSSC or perovskite-based solar cell comprising the mixture of the first aspect.

The components of the above OE devices include, without limitation, charge injection layers, charge transport layers, interlayers, planarising layers, antistatic films, polymer electrolyte membranes (PEM), conducting substrates and conducting patterns.

The assemblies comprising such OE devices or components include, without limitation, integrated circuits (IC), radio frequency identification (RFID) tags or security markings or security devices containing them, flat panel displays or backlights thereof, electrophotographic devices, electrophotographic recording devices, organic memory devices, sensor devices, biosensors and biochips.

In addition the mixture of the present invention can be used as electrode material in batteries and in components or devices for detecting and discriminating DNA sequences.

The invention further relates to a bulk heterojunction (BHJ) which comprises, or is being formed from, the mixture of the first aspect, and to a BHJ OPV device, or an inverted BHJ OPV device, comprising such a bulk heterojunction.

Terms and Definitions

As used herein, any reference to a formula, like for example "formula 1", is understood to be inclusive of any specific subformula of said formula as shown hereinafter.

As used herein, the term "fullerene" will be understood to mean a compound composed of an even number of carbon atoms, which form a cage-like fused-ring having a surface which comprises six-membered rings and five-membered rings, usually with twelve five-membered rings and the rest six-membered rings, optionally with one or more atoms trapped inside. The surface of the fullerene may also contain hetero atoms like B or N.

As used herein, the term "endohedral fullerene" will be understood to mean a fullerene with one or more atoms trapped inside.

As used herein, the term "metallofullerene" will be understood to mean an endohedral fullerene wherein the atoms trapped inside are selected from metal atoms.

As used herein, the term "carbon based fullerene" will be understood to mean a fullerene without any atoms trapped inside, and wherein the surface is comprised only of carbon atoms.

The Brunauer-Emmett-Teller (BET) sorption surface area as referred to above and below is a method used to measure the surface area of a material by its sorption of a gas, preferably a non-corrosive gas (see J. Am. Chem. Soc. 1938, 60 (2), 309-319, J. Am. Chem. Soc. 1940, 62 (7), 1723-1732, and Langmuir 1998, 14, 2097-2111).

As used herein, the term "polymer" will be understood to mean a molecule of high relative molecular mass, the structure of which essentially comprises the multiple repetition of units derived, actually or conceptually, from molecules of low relative molecular mass *(*Pure Appl. Chem., 1996, 68, 2291). The term "oligomer" will be understood to mean a molecule of intermediate relative molecular mass, the structure of which essentially comprises a small plurality of units derived, actually or conceptually, from molecules of lower relative molecular mass *(*Pure Appl. Chem., 1996, 68, 2291). In a preferred meaning as used herein present invention a polymer will be understood to mean a compound having > 1, i.e. at least 2 repeat units, preferably ≥ 5 repeat units, and an oligomer will be understood to mean a compound with > 1 and < 10, preferably < 5, repeat units.

Further, as used herein, the term "polymer" will be understood to mean a molecule that encompasses a backbone (also referred to as "main chain") of one or more distinct types of repeat units (the smallest constitutional unit of the molecule) and is inclusive of the commonly known terms "oligomer", "copolymer", "homopolymer" and the like. Further, it will be understood that the term polymer is inclusive of, in addition to the polymer itself, residues from initiators, catalysts and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

As used herein, in a formula showing a polymer or a repeat unit, an asterisk (*) will be understood to mean a chemical linkage to an adjacent unit or to a terminal group in the polymer backbone. In a ring, like for example a benzene or thiophene ring, an asterisk (*) will be understood to mean a C atom that is fused to an adjacent ring.

As used herein, the terms "repeat unit", "repeating unit" and "monomeric unit" are used interchangeably and will be understood to mean the constitutional repeating unit (CRU), which is the smallest constitutional unit the repetition of which constitutes a regular macromolecule, a regular oligomer molecule, a regular block or a regular chain (Pure Appl. Chem., 1996, 68, 2291). As further used herein, the term "unit" will be understood to mean a structural unit which can be a repeating unit on its own, or can together with other units form a constitutional repeating unit.

As used herein, a "terminal group" will be understood to mean a group that terminates a polymer backbone. The expression "in terminal position in the backbone" will be understood to mean a divalent unit or repeat unit that is linked at one side to such a terminal group and at the other side to another repeat unit. Such terminal groups include endcap groups, or reactive groups that are attached to a monomer forming the polymer backbone which did not participate in the polymerisation reaction, like for example a group having the meaning of $R^{33}$ or $R^{34}$ as defined below.

As used herein, the term "endcap group" will be understood to mean a group that is attached to, or replacing, a terminal group of the polymer backbone. The endcap group can be introduced into the polymer by an endcapping

process. Endcapping can be carried out for example by reacting the terminal groups of the polymer backbone with a monofunctional compound ("endcapper") like for example an alkyl- or arylhalide, an alkyl- or arylstannane or an alkyl- or arylboronate. The endcapper can be added for example after the polymerisation reaction. Alternatively the endcapper can be added in situ to the reaction mixture before or during the polymerisation reaction. In situ addition of an endcapper can also be used to terminate the polymerisation reaction and thus control the molecular weight of the forming polymer. Typical endcap groups are for example H, phenyl and lower alkyl.

As used herein, the term "small molecule" will be understood to mean a monomeric compound which typically does not contain a reactive group by which it can be reacted to form a polymer, and which is designated to be used in monomeric form. In contrast thereto, the term "monomer" unless stated otherwise will be understood to mean a monomeric compound that carries one or more reactive functional groups by which it can be reacted to form a polymer.

As used herein, the terms "donor" or "donating" and "acceptor" or "accepting" will be understood to mean an electron donor or electron acceptor, respectively. "Electron donor" will be understood to mean a chemical entity that donates electrons to another compound or another group of atoms of a compound. "Electron acceptor" will be understood to mean a chemical entity that accepts electrons transferred to it from another compound or another group of atoms of a compound. See also International Union of Pure and Applied Chemistry, Compendium of Chemical Technology, Gold Book, Version 2.3.2, 19. August 2012, pages 477 and 480.

As used herein, the term "n-type" or "n-type semiconductor" will be understood to mean an extrinsic semiconductor in which the conduction electron density is in excess of the mobile hole density, and the term "p-type" or "p-type semiconductor" will be understood to mean an extrinsic semiconductor in which mobile hole density is in excess of the conduction electron density (see also, J. Thewlis, Concise Dictionary of Physics, Pergamon Press, Oxford, 1973).

As used herein, the term "leaving group" will be understood to mean an atom or group (which may be charged or uncharged) that becomes detached from an atom in what is considered to be the residual or main part of the molecule taking part in a specified reaction (see also Pure Appl. Chem., 1994, 66, 1134).

As used herein, the term "conjugated" will be understood to mean a compound (for example a polymer) that contains mainly C atoms with $sp^2$-hybridisation (or optionally also sp-hybridisation), and wherein these C atoms may also be replaced by hetero atoms. In the simplest case this is for example a compound with alternating C-C single and double (or triple) bonds, but is also inclusive of compounds with aromatic units like for example 1,4-phenylene. The term "mainly" in this connection will be understood to mean that a compound with naturally (spontaneously) occurring defects, or with defects included by design, which may lead to interruption of the conjugation, is still regarded as a conjugated compound.

As used herein, unless stated otherwise the molecular weight is given as the number average molecular weight $M_n$ or weight average molecular weight Mw, which is determined by gel permeation chromatography (GPC) against polystyrene standards in eluent solvents such as tetrahydrofuran, trichloromethane (TCM, chloroform), chlorobenzene or 1,2,4-trichlorobenzene. Unless stated otherwise, 1,2,4-trichlorobenzene is used as solvent. The degree of polymerization, also referred to as total number of repeat units, n, will be understood to mean the number average degree of polymerization given as $n = M_n/M_U$, wherein $M_n$ is the number average molecular weight and Mu is the molecular weight of the single repeat unit, see J. M. G. Cowie, Polymers: Chemistry & Physics of Modern Materials, Blackie, Glasgow, 1991.

As used herein, the term "carbyl group" will be understood to mean any monovalent or multivalent organic moiety which comprises at least one carbon atom either without any non-carbon atoms (like for example -C≡C-), or optionally combined with at least one non-carbon atom such as B, N, O, S, P, Si, Se, As, Te or Ge (for example carbonyl etc.).

As used herein, the term "hydrocarbyl group" will be understood to mean a carbyl group that does additionally contain one or more H atoms and optionally contains one or more hetero atoms like for example B, N, O, S, P, Si, Se, As, Te or Ge.

As used herein, the term "hetero atom" will be understood to mean an atom in an organic compound that is not a H- or C-atom, and preferably will be understood to mean B, N, O, S, P, Si, Se, As, Te or Ge.

A carbyl or hydrocarbyl group comprising a chain of 3 or more C atoms may be straight-chain, branched and/or cyclic, and may include spiro-connected and/or fused rings.

Preferred carbyl and hydrocarbyl groups include alkyl, alkoxy, thioalkyl, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms, wherein all these groups do optionally contain one or more hetero atoms, preferably selected from B, N, O, S, P, Si, Se, As, Te and Ge.

Further preferred carbyl and hydrocarbyl group include for example: a $C_1$-$C_{40}$ alkyl group, a $C_1$-$C_{40}$ fluoroalkyl group, a $C_1$-$C_{40}$ alkoxy or oxaalkyl group, a $C_2$-$C_{40}$ alkenyl group, a $C_2$-$C_{40}$ alkynyl group, a $C_3$-$C_{40}$ allyl group, a $C_4$-$C_{40}$ alkyldienyl group, a $C_4$-$C_{40}$ polyenyl group, a $C_2$-$C_{40}$ ketone group, a $C_2$-$C_{40}$ ester group, a $C_6$-$C_{18}$ aryl group, a $C_6$-$C_{40}$ alkylaryl group, a $C_6$-$C_{40}$ arylalkyl group, a $C_4$-$C_{40}$ cycloalkyl group, a $C_4$-$C_{40}$ cycloalkenyl group, and the like. Preferred

among the foregoing groups are a $C_1$-$C_{20}$ alkyl group, a $C_1$-$C_{20}$ fluoroalkyl group, a $C_2$-$C_{20}$ alkenyl group, a $C_2$-$C_{20}$ alkynyl group, a $C_3$-$C_{20}$ allyl group, a $C_4$-$C_{20}$ alkyldienyl group, a $C_2$-$C_{20}$ ketone group, a $C_2$-$C_{20}$ ester group, a $C_6$-$C_{12}$ aryl group, and a $C_4$-$C_{20}$ polyenyl group, respectively.

Also included are combinations of groups having carbon atoms and groups having hetero atoms, like e.g. an alkynyl group, preferably ethynyl, that is substituted with a silyl group, preferably a trialkylsilyl group.

The carbyl or hydrocarbyl group may be an acyclic group or a cyclic group. Where the carbyl or hydrocarbyl group is an acyclic group, it may be straight-chain or branched. Where the carbyl or hydrocarbyl group is a cyclic group, it may be a non-aromatic carbocyclic or heterocyclic group, or an aryl or heteroaryl group.

A non-aromatic carbocyclic group as referred to above and below is saturated or unsaturated and preferably has 4 to 30 ring C atoms. A non-aromatic heterocyclic group as referred to above and below preferably has 4 to 30 ring C atoms, wherein one or more of the C ring atoms are optionally replaced by a hetero atom, preferably selected from N, O, S, Si and Se, or by a -S(O)- or -$S(O)_2$- group. The non-aromatic carbo- and heterocyclic groups are mono- or polycyclic, may also contain fused rings, preferably contain 1, 2, 3 or 4 fused or unfused rings, and are optionally substituted with one or more groups L, wherein

L is selected from halogen, -CN, -NC, -NCO, -NCS, -OCN, -SCN, -C(=O)$NR^0R^{00}$, -C(=O)$X^0$, -C(=O)$R^0$, -$NH_2$, -$NR^0R^{00}$, -SH, -$SR^0$, -$SO_3H$, -$SO_2R^0$, -OH, -$NO_2$, -$CF_3$, -$SF_5$, optionally substituted silyl, or carbyl or hydrocarbyl with 1 to 40 C atoms that is optionally substituted and optionally comprises one or more hetero atoms, and is preferably alkyl, alkoxy, thioalkyl, alkylcarbonyl, alkoxycarbonyl, alkylcarbonyloxy or alkoxycarbonyloxy with 1 to 20 C atoms that is optionally fluorinated, $X^0$ is halogen, preferably F, Cl or Br, and $R^0$, $R^{00}$ have the meanings given above and below, and preferably denote H or alkyl with 1 to 12 C atoms.

Preferred substituents L are selected from halogen, most preferably F, or alkyl, alkoxy, oxaalkyl, thioalkyl, fluoroalkyl and fluoroalkoxy with 1 to 12 C atoms, or alkenyl or alkynyl with 2 to 12 C atoms.

Preferred non-aromatic carbocyclic or heterocyclic groups are tetrahydrofuran, indane, pyran, pyrrolidine, piperidine, cyclopentane, cyclohexane, cycloheptane, cyclopentanone, cyclohexanone, dihydrofuran-2-one, tetrahydropyran-2-one and oxepan-2-one.

An aryl group as referred to above and below preferably has 4 to 30 ring C atoms, is mono- or polycyclic and may also contain fused rings, preferably contains 1, 2, 3 or 4 fused or unfused rings, and is optionally substituted with one or more groups L as defined above and below.

A heteroaryl group as referred to above and below preferably has 4 to 30 ring C atoms, wherein one or more of the C ring atoms are replaced by a hetero atom, preferably selected from N, O, S, Si and Se, is mono- or polycyclic and may also contain fused rings, preferably contains 1, 2, 3 or 4 fused or unfused rings, and is optionally substituted with one or more groups L as defined above and below.

As used herein, "arylene" will be understood to mean a divalent aryl group, and "heteroarylene" will be understood to mean a divalent heteroaryl group, including all preferred meanings of aryl and heteroaryl as given above and below.

Preferred aryl and heteroaryl groups are phenyl in which, in addition, one or more CH groups may be replaced by N, naphthalene, thiophene, selenophene, thienothiophene, dithienothiophene, fluorene and oxazole, all of which can be unsubstituted, mono- or polysubstituted with L as defined above. Very preferred rings are selected from pyrrole, preferably N-pyrrole, furan, pyridine, preferably 2- or 3-pyridine, pyrimidine, pyridazine, pyrazine, triazole, tetrazole, pyrazole, imidazole, isothiazole, thiazole, thiadiazole, isoxazole, oxazole, oxadiazole, thiophene, preferably 2-thiophene, selenophene, preferably 2-selenophene, thieno[3,2-b]thiophene, thieno[2,3-b]thiophene, furo[3,2-b]furan, furo[2,3-b]furan, seleno[3,2-b]selenophene, seleno[2,3-b]selenophene, thieno[3,2-b]selenophene, thieno[3,2-b]furan, indole, isoindole, benzo[b]furan, benzo[b]thiophene, benzo[1,2-b;4,5-b']dithiophene, benzo[2,1-b;3,4-b']dithiophene, quinole, 2-methylquinole, isoquinole, quinoxaline, quinazoline, benzotriazole, benzimidazole, benzothiazole, benzisothiazole, benzisoxazole, benzoxadiazole, benzoxazole, benzothiadiazole, 4H-cyclopenta[2,1-b;3,4-b']dithiophene, 7H-3,4-dithia-7-silacyclopenta[a]pentalene, all of which can be unsubstituted, mono- or polysubstituted with L as defined above and below. Further examples of aryl and heteroaryl groups are those selected from the groups shown hereinafter.

An alkyl group or an alkoxy group, i.e., where the terminal $CH_2$ group is replaced by -O-, can be straight-chain or branched. It is preferably straight-chain, has 2, 3, 4, 5, 6, 7, 8, 12 or 16 carbon atoms and accordingly is preferably ethyl, propyl, butyl, pentyl, hexyl, heptyl, octyl, dodecyl or hexadecyl, ethoxy, propoxy, butoxy, pentoxy, hexoxy, heptoxy, octoxy, dodecoxy or hexadecoxy, furthermore methyl, nonyl, decyl, undecyl, tridecyl, tetradecyl, pentadecyl, nonoxy, decoxy, undecoxy, tridecoxy or tetradecoxy, for example.

An alkenyl group, i.e., wherein one or more $CH_2$ groups are replaced by - CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-,2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are $C_2$-$C_7$-1E-alkenyl, $C_4$-$C_7$-3E-alkenyl, $C_5$-$C_7$-4-alkenyl, $C_6$-$C_7$-5-alkenyl and $C_7$-6-alkenyl, in particular $C_2$-$C_7$-1E-alkenyl, $C_4$-$C_7$-3E-alkenyl and $C_5$-$C_7$-4-alkenyl. Examples for particularly preferred alkenyl groups are vinyl, 1E-propenyl, 1E-butenyl, 1E-pentenyl, 1E-hexenyl, 1E-heptenyl, 3-butenyl, 3E-pentenyl,

3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, i.e., where one $CH_2$ group is replaced by -O-, is preferably straight-chain 2-oxapropyl (=methoxymethyl), 2-(=ethoxymethyl) or 3-oxabutyl (=2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one $CH_2$ group is replaced by -O- and one $CH_2$ group is replaced by -C(O)-, these radicals are preferably neighboured. Accordingly these radicals together form a carbonyloxy group -C(O)-O- or an oxycarbonyl group -O-C(O)-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxyethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonyl-methyl, ethoxycarbonylmethyl, propoxycarbonylmethyl, butoxycarbonylmethyl, 2-(methoxycarbonyl)ethyl, 2-(ethoxycarbonyl)ethyl, 2-(propoxycarbonyl)-ethyl, 3-(methoxycarbonyl)propyl, 3-(ethoxycarbonyl)propyl, 4-(methoxycarbonyl)-butyl.

An alkyl group wherein two or more $CH_2$ groups are replaced by -O-and/or -C(O)O- can be straight-chain or branched. It is preferably straight-chain and has 3 to 12 C atoms. Accordingly it is preferably bis-carboxymethyl, 2,2-bis-carboxy-ethyl, 3,3-bis-carboxy-propyl, 4,4-bis-carboxybutyl, 5,5-bis-carboxy-pentyl, 6,6-bis-carboxy-hexyl, 7,7-bis-carboxyheptyl, 8,8-bis-carboxy-octyl, 9,9-bis-carboxy-nonyl, 10,10-bis-carboxydecyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxycarbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, i.e., where one $CH_2$ group is replaced by -S-, is preferably straight-chain thiomethyl ($-SCH_3$), 1-thioethyl ($-SCH_2CH_3$), 1-thiopropyl (= $-SCH_2CH_2CH_3$), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the $CH_2$ group adjacent to the $sp^2$ hybridised vinyl carbon atom is replaced.

A fluoroalkyl group is perfluoroalkyl $C_iF_{2i+1}$, wherein i is an integer from 1 to 15, in particular $CF_3$, $C_2F_5$, $C_3F_7$, $C_4F_9$, $C_5F_{11}$, $C_6F_{13}$, $C_7F_{15}$ or $C_8F_{17}$, very preferably $C_6F_{13}$, or partially fluorinated alkyl, preferably with 1 to 15 C atoms, in particular 1,1-difluoroalkyl, all of the aforementioned being straight-chain or branched.

Preferably "fluoroalkyl" means a partially fluorinated (i.e. not perfluorinated) alkyl group.

Alkyl, alkoxy, alkenyl, oxaalkyl, thioalkyl, carbonyl and carbonyloxy groups can be achiral or chiral groups. Particularly preferred chiral groups are 2-butyl (=1-methylpropyl), 2-methylbutyl, 2-methylpentyl, 3-methylpentyl, 2-ethylhexyl, 2-butyloctyl, 2-hexyldecyl, 2-octyldodecyl, 2-propylpentyl, in particular 2-methylbutyl, 2-methylbutoxy, 2-methylpentoxy, 3-methylpentoxy, 2-ethyl-hexoxy, 2-butyloctoxyo, 2-hexyldecoxy, 2-octyldodecoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-methoxyoctoxy, 6-methyloctoxy, 6-methyloctanoyloxy, 5-methylheptyloxy-carbonyl, 2-methylbutyryloxy, 3-methylvaleroyloxy, 4-methylhexanoyloxy, 2-chloropropionyloxy, 2-chloro-3-methylbutyryloxy, 2-chloro-4-methyl-valeryl-oxy, 2-chloro-3-methylvaleryloxy, 2-methyl-3-oxapentyl, 2-methyl-3-oxa-hexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-ethylhexyl, 2-butyloctyl, 2-hexyldecyl, 2-octyldodecyl, 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tert. butyl, isopropoxy, 2-methyl-propoxy and 3-methylbutoxy.

In a preferred embodiment, the alkyl groups are independently of each other selected from primary, secondary or tertiary alkyl or alkoxy with 1 to 30 C atoms, wherein one or more H atoms are optionally replaced by F, or aryl, aryloxy, heteroaryl or heteroaryloxy that is optionally alkylated or alkoxylated and has 4 to 30 ring atoms. Very preferred groups of this type are selected from the group consisting of the following formulae

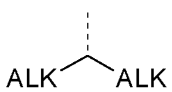
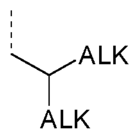
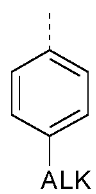
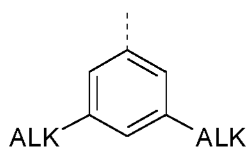

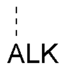 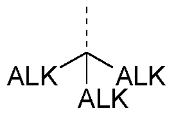 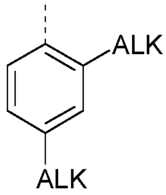 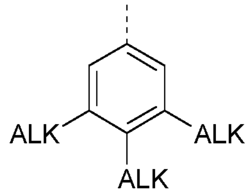

wherein "ALK" denotes optionally fluorinated, preferably linear, alkyl or alkoxy with 1 to 20, preferably 1 to 12 C-atoms, in case of tertiary groups very preferably 1 to 9 C atoms, and the dashed line denotes the link to the ring to which these groups are attached. Especially preferred among these groups are those wherein all ALK subgroups are identical.

As used herein, "halogen" or "hal" includes F, Cl, Br or I, preferably F, Cl or Br.

As used herein, -CO-, -C(=O)- and -C(O)- will be understood to mean a carbonyl group, i.e. a group having the structure

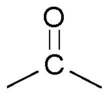 .

As used herein, $C=CR^1R^2$ will be understood to mean an ylidene group, i.e. a group having the structure

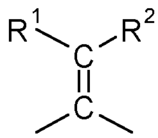 .

Above and below, $Y^1$ and $Y^2$ are independently of each other H, F, Cl or CN.

Above and below, $R^0$ and $R^{00}$ are independently of each other H or an optionally substituted carbyl or hydrocarbyl group with 1 to 40 C atoms, and preferably denote H or alkyl with 1 to 12 C-atoms.

Brief Description of the Drawings

**Fig. 1** shows the viscosity of a first BHJ formulation of Example 1.

**Fig. 2** shows the viscosity of a second BHJ formulation of Example 2.

**Fig. 3** shows the influence of nanopowder loading on performance and light stability of OPV cells prepared from BHJ formulations of Example 1 and of prior art.

Detailed Description

The mixture according to the present invention demonstrates one or more of the following improved properties compared to previously disclosed mixtures for BHJ OPV/OPD application:

i) The use of porous rigid support particles in the BHJ provides a rigid support to aid the formation of an interpenetrating network.

ii) The use of porous rigid support particles in the BHJ scatters light and enhances charge capture in the active layer.

iii) The use of porous rigid support particles in the BHJ provides a rigid support and enables greater stability towards thermal stress of the bulk heterojunction through mediation of the fullerene crystallisation and/or phase separation kinetic, thus stabilising the initial equilibrium thermodynamics in the BHJ.

iv) The use of porous rigid support particles in the BHJ provides a rigid support and enables greater stability towards

light illumination of the bulk heterojunction through mediation of the fullerene crystallisation and/or phase separation kinetic, thus stabilising the initial equilibrium thermodynamics in the BHJ.

v) The use of porous rigid support particles in the BHJ provides a rigid support and enables greater light stability of the bulk heterojunction through mediation of the fullerene 2+2 Diels Alder dimerisation reaction.

vi) The use of porous rigid support particles with different surface properties, size and surface area promotes the formation of an interpenetrating BHJ.

vii) The use of R groups on the surface of the particles enables to adjust surface properties, active layer diffusion properties, and dispersion properties in solution formulations to ensure a high performance and stable BHJ.

The nanoparticles in the mixtures according to the present invention are selected from rigid, porous nanoparticles, which are optionally substituted by one or more organic substituents at the porous surface of the particle.

In contrast to fullerene-functionalized particles used in BHJ OPV devices as described in US8519262B2, the n-type semiconductor, for example a fullerene, and the nanoparticles contained in the mixtures of the present invention are not chemically linked to each other, but are separate mixture components.

Preferred embodiments of the present invention include the following, including any combination thereof:

1) The p-type semiconductor is an organic semiconductor.

2) The p-type semiconductor is a conjugated organic polymer.

3) The n-type semiconductor is an organic semiconductor.

4) The n-type semiconductor is an organic small molecule.

5) The n-type semiconductor is a fullerene or a substituted fullerene.

6) The proportion of the nanoparticles is >0 and ≤40% by weight, preferably from 1 to 20%, very preferably from 1 to 15% by weight, of the solid components of the mixture, i.e. not including solvents.

7) The nanoparticles are spherical or essentially spherical.

8) The nanoparticles have irregular shape.

9) The nanoparticles have a diameter from 2 nm to 500 nm in case of spherical particles, or an equivalent spherical diameter in case of irregularly shaped particles.

10) The nanoparticles have a porous surface.

11) The nanoparticles have a porous surface with a Brunauer-Emmett-Teller (BET) surface area >25 $m^2/g$, preferably from 100 to 400 $m^2/g$.

12) The nanoparticles comprise, preferably consist of, fumed silica (also known as pyrogenic silica), very preferably Aerosil®.

13) The nanoparticles comprise, preferably consist of, an adsorbent or absorbent, which is a material capable of adsorbing or absorbing material, such as gases, liquids or dissolved solids, onto its surface.

14) The nanoparticles are substituted by one or more identical or different groups R, wherein

R is CN, an alkyl group with 1 to 50 C atoms, which is straight-chain, branched or cyclic, and in which one or more $CH_2$ groups are optionally replaced by -O-, -S-,-C(=O)-, -C(=S)-, -C(=O)-O-, -O-C(=O)-, -$NR^0$-, -C(=O)-$NR^0$-, -$NR^0$-C(=O)-, -$SiR^0R^{00}$-, -CF2-, -$CR^0$=$CR^{00}$-,-$CR^0$=N-, -N=N- or -C≡C- in such a manner that O and/or S atoms are not linked directly to one another, and/or in which one or more H atoms are optionally replaced by F, Cl, Br, I or CN and/or in which one or more H is replaced by a cationic or anionic group, or R is a saturated or unsaturated, non-aromatic carbo- or heterocyclic group, or an aryl, heteroaryl,

aryloxy or heteroaryloxy group, wherein each of the aforementioned cyclic groups has 5 to 20 ring atoms, is mono- or polycyclic, does optionally contain fused rings, and is optionally substituted by one or more identical or different groups L,

L is halogen, -CN, -NC, -NCO, -NCS, -OCN, -SCN,-C(=O)N$R^0R^{00}$, -C(=O)$X^0$, -C(=O)$R^0$, -$NH_2$, -N$R^0R^{00}$, -SH,-S$R^0$, -$SO_3H$, -$SO_2R^0$, -OH, -$NO_2$, -$CF_3$, -$SF_5$, optionally substituted silyl, or carbyl or hydrocarbyl with 1 to 40 C atoms that is optionally substituted and optionally comprises one or more hetero atoms, preferably alkyl, alkoxy, thioalkyl, alkylcarbonyl, alkylcarbonyloxy, alkoxycarbonyl or alkoxycarbonyloxy with 1 to 20 C atoms that is optionally fluorinated,

$R^0$, $R^{00}$ are independently of each other H or alkyl with 1 to 12 C atoms, or a silyl group with 1 to 20 Si atoms that is optionally alkylated,

$X^0$ is halogen, preferably F, Cl or Br.

In a preferred embodiment of the present invention, the nanoparticle is substituted by at least one group R selected from the following groups:

- the group consisting of straight-chain, branched or cyclic alkyl with 1 to 50, preferably 1 to 30, C atoms that is optionally fluorinated, very preferably selected from the group consisting of methyl, ethyl, propyl, butyl, pentyl, hexyl, heptyl, octyl, nonyl, decyl, undecyl, dodecyl, tridecyl, tetradecyl, pentadecyl, hexydecyl, heptadecyl and octadecyl,

- the group consisting of straight-chain or branched alkyl, alkoxy or sulfanylalkyl with 1 to 30 C atoms, and straight-chain or branched alkylcarbonyl, alkylcarbonyloxy or alkyloxycarbonyl with 2 to 30 C atoms, each of the aforementioned groups being unsubstituted or substituted by one or more F atoms,

- the group consisting of aryl, heteroaryl, aryloxy and heteroaryloxy, each of which is optionally fluorinated, alkylated or alkoxylated and has 4 to 30 ring atoms,

- the group consisting of straight-chain, branched or cyclic alkyl with 1 to 50, preferably 2 to 30 C atoms, in which one or more $CH_2$ or $CH_3$ groups are replaced by a cationic or anionic group,

- -N(Si$R^0R^{00}R^{000}$)$_2$ wherein $R^0$, $R^{00}$ and $R^{000}$ are independently of each other H or alkyl with 1 to 12 C atoms.

If one or more groups R denote an aryl(oxy) or heteroaryl(oxy) group, it is preferably selected from phenyl, pyrrole, furan, pyridine, thiazole, thiophene, thieno[3,2-b]thiophene or thieno[2,3-b]thiophene, each of which is optionally fluorinated, alkylated or alkoxylated.

In another preferred embodiment of the present invention, the nanoparticle is substituted by at least one group R selected from the following formulae:

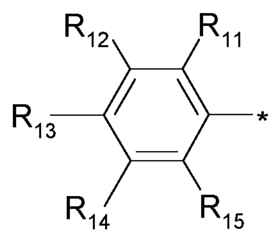

C-1

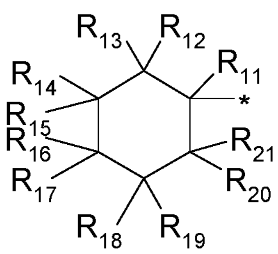

C-2

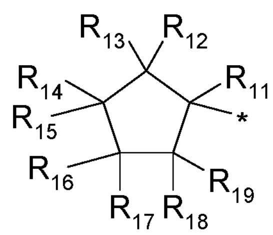

C-3

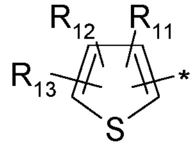

C-4

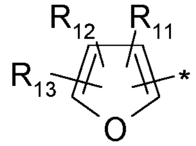

C-5

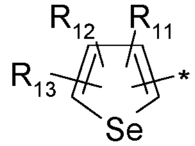

C-6

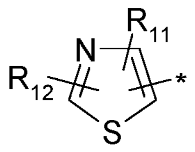

C-7

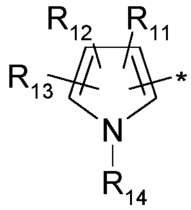

C-8

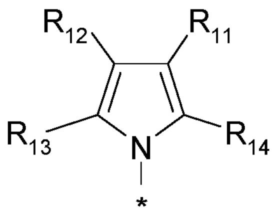

C-9

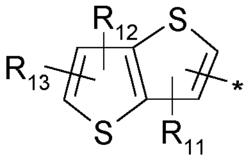

C-10

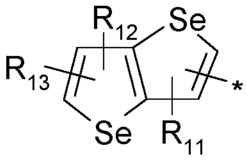

C-11

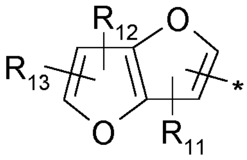

C-12

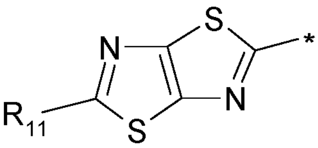

C-13

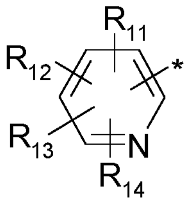

C-14

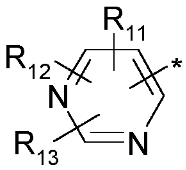

C-15

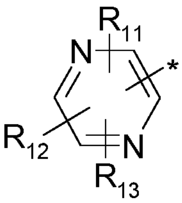

C-16

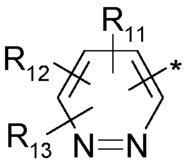

C-17

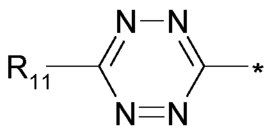

C-18

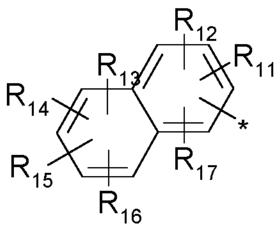

C-19

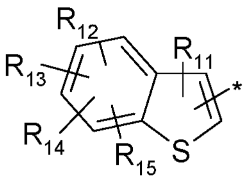

C-20

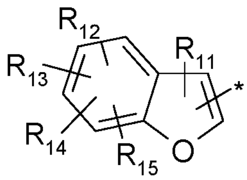

C-21

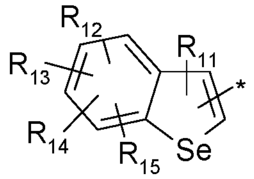

C-22

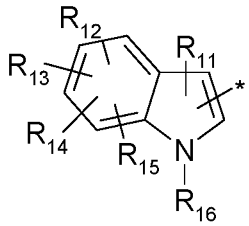

C-23

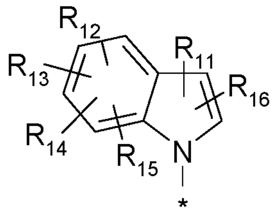

C-24

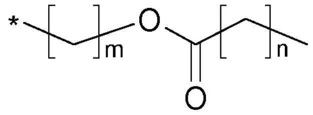

C-25

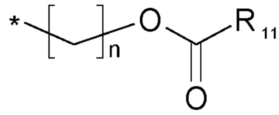

C-26

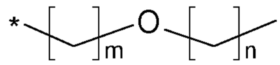

C-27

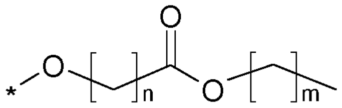

C-28

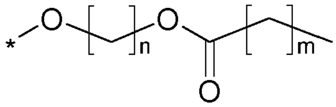

C-29

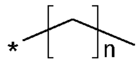

C-30

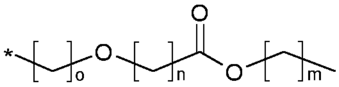

C-31

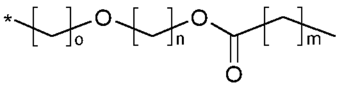

C-32

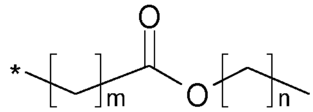

C-33

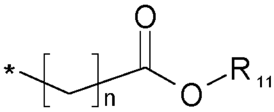

C-34

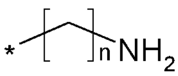

C-35

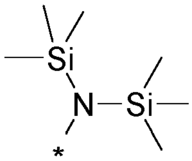

C-36

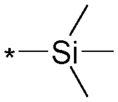

C-37

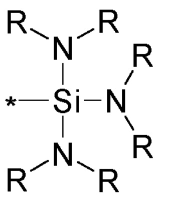

C-38

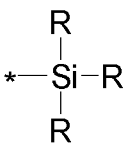

C-39

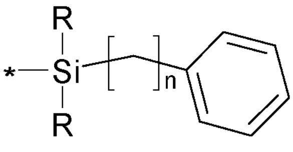

C-40

wherein

n is integer from 0 to 15, preferably from 0 to 9, very preferably from 0 to 5,

m is integer from 0 to 15, preferably from 0 to 9, very preferably from 0 to 5,

o is integer from 0 to 15, preferably from 0 to 9, very preferably from 0 to 5,

R, $R^{11}$-$R^{21}$ denote H, halogen, CN, an alkyl group with 1 to 50 C atoms, which is straight-chain, branched or cyclic, and in which one or more $CH_2$ groups are optionally replaced by -O-, -S-, -C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$, $-CR^0=N-$, -N=N-,or-C≡C- in such a manner that O and/or S atoms are not linked directly to one another, and/or in which one or more H atoms are optionally replaced by F, Cl, Br, I or CN and/or in which one or more H is replaced by a cationic or anionic group, or a saturated or unsaturated, non-aromatic carbo- or heterocyclic group, or an aryl, heteroaryl, aryloxy or heteroaryloxy group, wherein each of the aforementioned cyclic groups has 5 to 20 ring atoms, is mono- or polycyclic, does optionally contain fused rings, and is optionally substituted by one or more identical or different groups L as defined above

$R^0$, $R^{00}$ have the meanings given above.

Preferred substituents R are selected from formulae C-25 to C-40. Very preferred substituents R are those of formulae C-30 and C-36.

The cationic group is preferably selected from the group consisting of phosphonium, sulfonium, ammonium, uronium, thiouronium, guanidinium or heterocyclic cations such as imidazolium, pyridinium, pyrrolidinium, triazolium, morpholinium or piperidinium cation.

Preferred cationic groups are selected from the group consisting of tetraalkylammonium, tetraalkylphosphonium, N-alkylpyridinium, N,N-dialkylpyrrolidinium, 1,3-dialkylimidazolium, wherein "alkyl" preferably denotes a straight-chain or branched alkyl group with 1 to 12 C atoms.

Further preferred cationic groups are selected from the group consisting of the following formulae

imidazolium

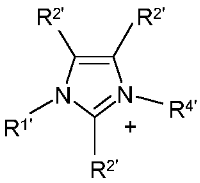

,

1H-pyrazolium

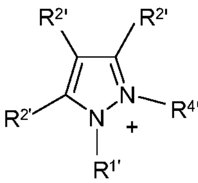

,

3H-pyrazolium

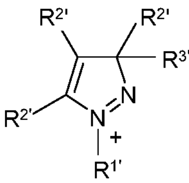

,

4H-pyrazolium

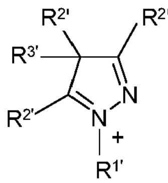

,

1-pyrazolinium

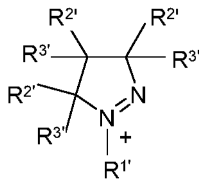

,

2-pyrazolinium

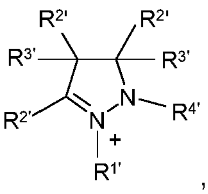

,

3-pyrazolinium

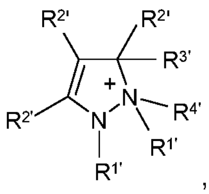

,

2,3-dihydroimidazolinium

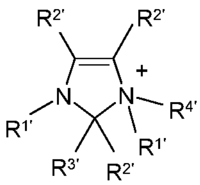

,

4,5-dihydroimidazolinium

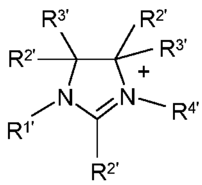

,

2,5-dihydroimidazolinium

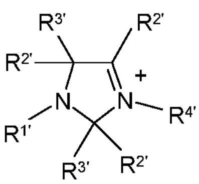

,

pyrrolidinium

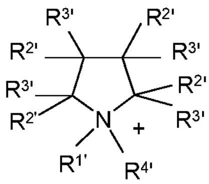

,

1,2,4-triazolium

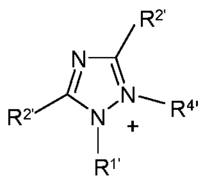

,

1,2,4-triazolium

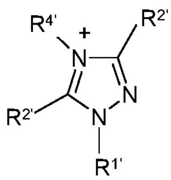

,

1,2,3-triazolium

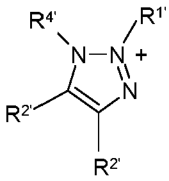

,

1,2,3-triazolium

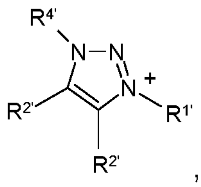

,

pyridinium

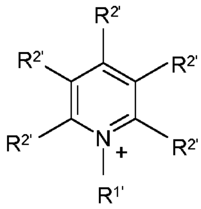

,

pyridazinium

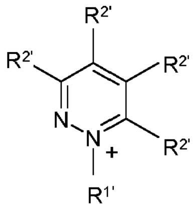

,

pyrimidinium

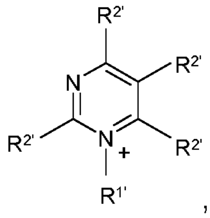

,

piperidinium

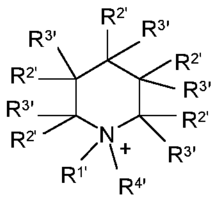

,

morpholinium

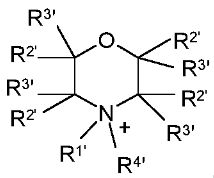

,

piperazinium

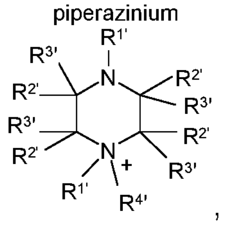

,

piperazinium

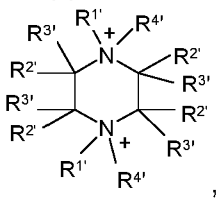

,

pyrazinium

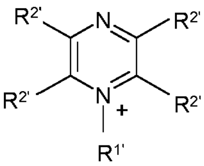

,

thiazolium

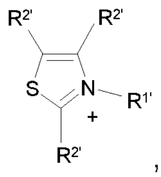

,

oxazolium

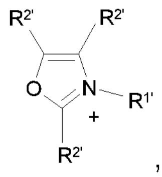

,

indolium

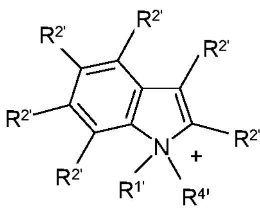

,

quinolinium

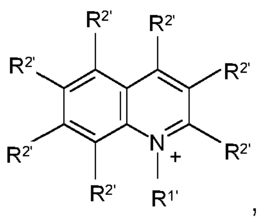

,

isoquinolinium

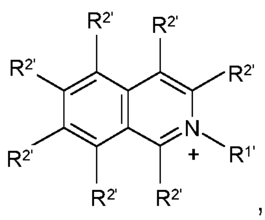

,

quinoxalinium

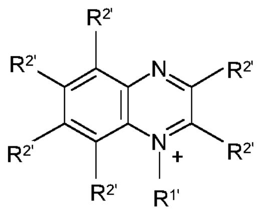

or

indolinium

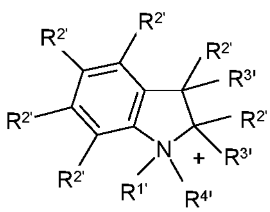

wherein $R^{1'}$, $R^{2'}$, $R^{3'}$ and $R^{4'}$ denote, independently of each other, H, a straight-chain or branched alkyl group with 1 to 12 C atoms or non-aromatic carbo- or heterocyclic group or an aryl or heteroaryl group, each of the aforementioned groups having 3 to 20, preferably 5 to 15, ring atoms, being mono- or polycyclic, and optionally being substituted by one or more identical or different substituents R as defined below, or denote a link to the respective group $R^{11-21}$.

In the above cationic groups of the above-mentioned formulae any one of the groups $R^{1'}$, $R^{2'}$, $R^{3'}$ and $R^{4'}$ (if they replace a $CH_3$ group) can denote a link to the group $R^1$, or two neighbored groups $R^{1'}$, $R^{2'}$, $R^{3'}$ or $R^{4'}$ (if they replace a $CH_2$ group) can denote a link to the respective group $R^{1-4}$.

The anionic group is preferably selected from the group consisting of borate, imide, phosphate, sulfonate,

sulfate, succinate, naphthenate or carboxylate, very preferably from phosphate, sulfonate or carboxylate.

Suitable and/or preferred substituted and unsubstituted nanoparticles can be selected either from commercially available materials, like Aerosil®, a pyrogenic silica available from Evonik Industries, or can be synthesized by methods known to the expert and described in the literature (Journal of Nanomaterials, 2012, vol. 2012, pp. 132424; Chem. Rev. 2008, vol. 108, pp. 3893-3957)

Methods of substitution of the nanoparticles by one or more groups R known to the expert and described in the literature, for example in Journal of Colloid and Interface Science 2003, vol. 264, pp. 354-361; Journal of Nanomaterials, 2012, vol. 2012, pp. 132424; Chem. Rev. 2008, vol. 108, pp. 3893-3957.

The p-type semiconductor as used in a mixture of the present invention is preferably selected from conjugated polymers.

Preferably the p-type semiconductor is a conjugated polymer comprising one or more units selected from the following formulae

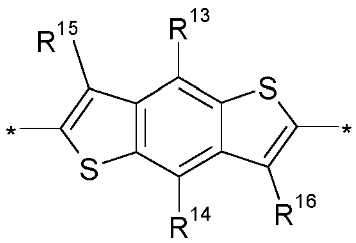

1

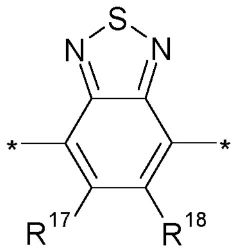

2

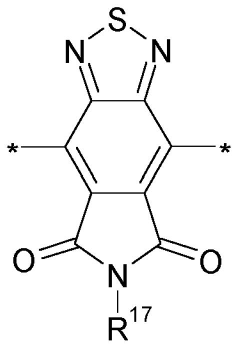

3

wherein $R^{13}$-$R^{17}$ have independently of each other one of the meanings given above.

Preferably the conjugated polymer comprises, in addition to the units of formula 1, 2 and/or 3, one or more spacer units Sp selected from the group consisting of the following formulae

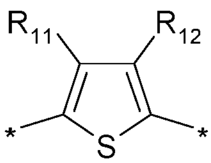

Sp1

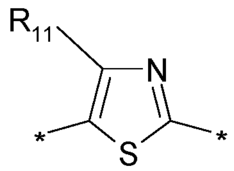

Sp2

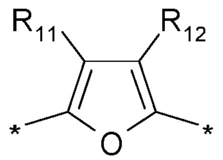

Sp3

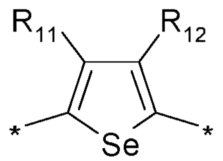

Sp4

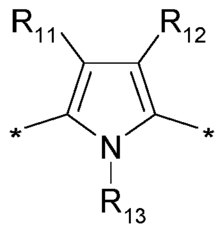

Sp5

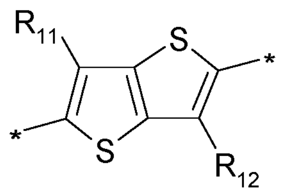

Sp6

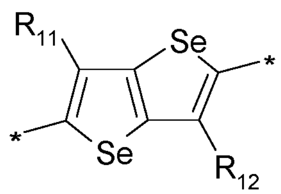

Sp7

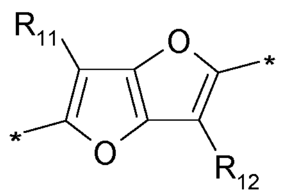

Sp8

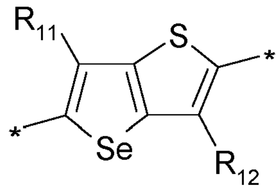

Sp9

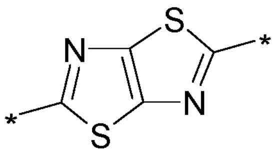

Sp10

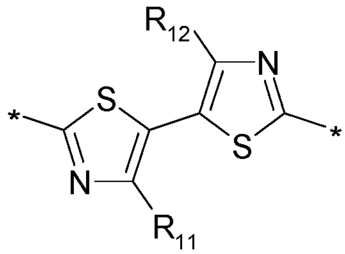

Sp11

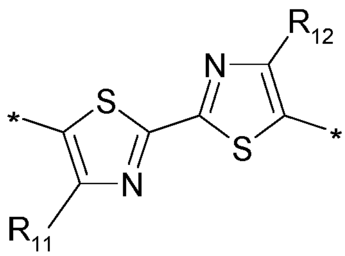

Sp12

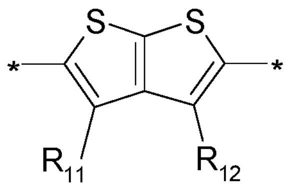

Sp13

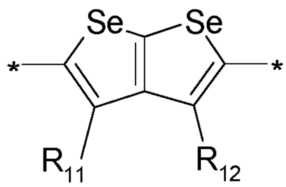

Sp14

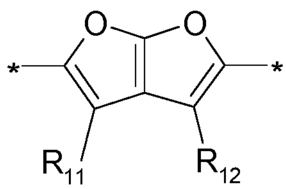

Sp15

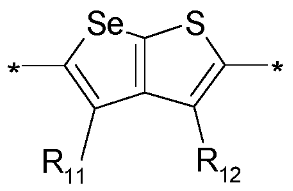

Sp16

wherein $R^{11}$ and $R^{12}$ have one of the meanings given above.

Preferred spacer units are selected from formula Sp1, Sp4 and Sp6, wherein preferably one of $R^{11}$ and $R^{12}$ is H or both $R^{11}$ and $R^{12}$ are H.

Preferred conjugated polymers comprise, very preferably consist of, one or more identical or different units selected from formulae D1 and D2 and one or more identical or different units selected from formula A1 and A2

-(D-Sp)- D1

-D- D2

-(A-Sp)- A1

-A- A2

wherein D denotes, on each occurrence identically or differently, a unit of formula 1, A denotes, on each occurrence identically or differently, a unit of formula 2 or 3, and Sp denotes, on each occurrence identically or differently, a unit selected from formulae Sp1 to Sp16, very preferably from formulae Sp1 and Sp6.

Preferred conjugated polymers consist of one or more units of formula 1, one or more units of formula 2 and/or 3, and one or more spacer units selected from formulae Sp1 to Sp16.

Very preferred are conjugated polymers selected from the following formulae

$-[(D\text{-}Sp)_x\text{-}(A\text{-}Sp)_y]_p-$ P1

$-[(D\text{-}Sp\text{-}A^1\text{-}Sp)_x\text{-}(D\text{-}Sp\text{-}A^2\text{-}Sp)_y]_p-$ P2

$-[(D\text{-}Sp\text{-}A^1\text{-}Sp)_x\text{-}(D\text{-}A^2)_y]_p-$ P3

wherein A, D and Sp are as defined in formula D1 and A1,

$A^1$ and $A^2$ have one of the meanings given for A in formula A1,

x and y denote the molar fraction of the respective unit,

x and y are each, independently of one another >0 and <1, with x+y=1, and

p is an integer >1.

Further preferred are conjugated polymers selected from the following subformulae

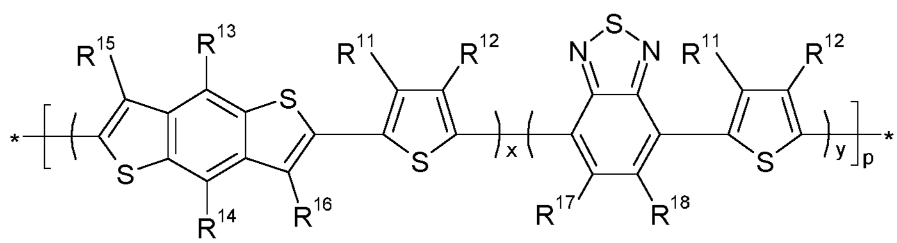

P1a

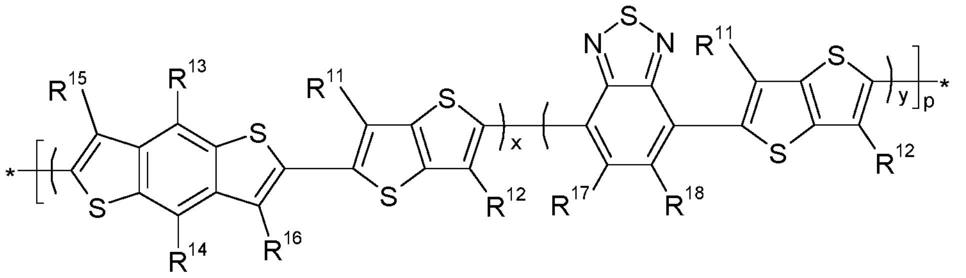

P1b

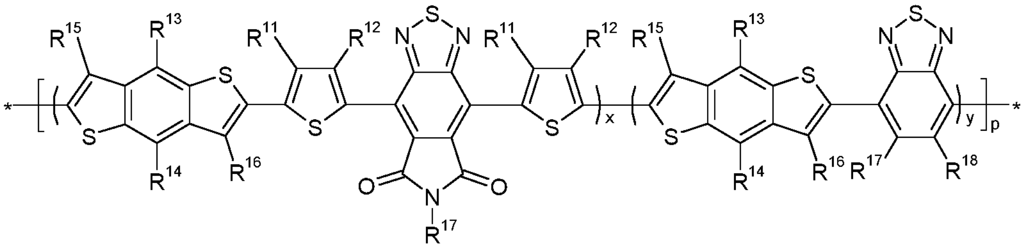

P3a

wherein $R^{11-16}$, x, y and p are as defined above.

Preferably $R^{11}$ and $R^{12}$ in formulae Sp1 to Sp16, P1, P2 and P3 and their subformulae are H.

Preferably $R^{13}$ and $R^{14}$ in formula 1, P1, P2 and P3 and their subformulae are different from H.

Preferably $R^{15}$ and $R^{16}$ in formula 1, P1, P2 and P3 and their subformulae are H.

Preferably $R^{17}$ and $R^{18}$ in formula 2, 3, P1, P2 and P3 and their subformulae are different from H.

Preferably $R^{11}$, $R^{12}$, $R^{13}$, $R^{14}$, $R^{15}$, $R^{16}$, $R^{17}$ and $R^{18}$ in formulae 1, 2, 3, Sp1-Sp16, P1, P2 and P3 and their subformulae, when being different from H, are selected from the following groups:

- the group consisting of straight-chain or branched alkyl with 1 to 30, preferably 1 to 20, C atoms that is optionally fluorinated,
- the group consisting of straight-chain or branched alkyl, alkoxy or sulfanylalkyl with 1 to 30, preferably 1 to 20, C atoms, and straight-chain or branched alkylcarbonyl, alkylcarbonyloxy or alkyloxycarbonyl with 2 to 30, preferably 2 to 20, C atoms, each of the aforementioned groups being unsubstituted or substituted by one or more F atoms.

Very preferably $R^{13}$ and $R^{14}$ in formula 1, P1, P2 and P3 denote -CO-O-$R^x$, with $R^x$ being straight-chain or branched alkyl with 1 to 20 C atoms that is optionally fluorinated.

Very preferably $R^{17}$ and $R^{18}$ in formula 2, 3, P1, P2 and P3 denote $R^x$ or - O$R^x$, with $R^x$ being straight-chain or branched alkyl with 1 to 20 C atoms that is optionally fluorinated.

In the polymers of formulae P1, P2 and P3 and their subformulae, x and y are preferably from 0.1 to 0.9, very preferably from 0.3 to 0.7, most preferably from 0.4 to 0.6.

In the conjugated polymers according to the present invention, the total number of repeating units pis preferably from 2 to 10,000. The total number of repeating units p is preferably $\geq$ 5, very preferably $\geq$ 10, most preferably $\geq$ 50, and preferably $\leq$ 500, very preferably $\leq$ 1,000, most preferably $\leq$ 2,000, including any combination of the aforementioned lower and upper limits of p.

The conjugated polymers of the present invention are preferably statistical or random copolymers.

Further preferred is conjugated polymer according to the present invention selected of formula PT

$R^{31}$-chain-$R^{32}$ PT

wherein "chain" denotes a polymer chain selected of formula P1, P2 or P3 or their subformulae, and $R^{31}$ and $R^{32}$ have independently of each other one of the meanings of $R^{11}$ as defined above, or denote, independently of each other, H, F, Br, Cl, I, -$CH_2$Cl, -CHO, -CR'=CR"$_2$, -SiR'R"R"', -SiR'X'X", -SiR'R"X', -SnR'R"R"', -BR'R", -B(OR')(OR"), -B$(OH)_2$, -O-$SO_2$-R', -C=CH, - C≡C-SiR'$_3$, -ZnX' or an endcap group, X' and X" denote halogen, R', R" and R'" have independently of each other one of the meanings of $R^0$ given in formula 1, and preferably denote alkyl with 1 to 12 C atoms, and two of R', R" and R'" may also form a cyclosilyl, cyclostannyl, cycloborane or cycloboronate group with 2 to 20 C atoms together with the respective hetero atom to which they are attached.

Preferred endcap groups $R^{31}$ and $R^{32}$ are H, $C_{1-20}$ alkyl, or optionally substituted $C_{6-12}$ aryl or $C_{2-10}$ heteroaryl, very preferably H or phenyl.

The conjugated polymer can be prepared for example by copolymerising one or more monomers selected from the following formulae in an aryl-aryl coupling reaction

$R^{33}$-D-$R^{34}$ MI

$R^{33}$-A-$R^{34}$ MII

$R^{33}$-Sp-$R^{34}$ MIII

wherein at least one monomer is selected of formula MI and at least one monomer is selected of formula Mil,

D denotes a unit of formula 1,

A denotes a unit of formula 2 or 3,

Sp denotes a spacer unit selected from formulae Sp1 to Sp16,

$R^{33}$ and $R^{34}$ are, independently of each other, selected from the group consisting of H which is preferably an activated C-H bond, Cl, Br, I, O-tosylate, O-triflate, O-mesylate, O-nonaflate, $-SiMe_2F$, $-SiMeF_2$, $-O-SO_2Z^1$, - $B(OZ^2)_2$, $-CZ^3=C(Z^3)_2$, -C=CH, - $C\equiv CSi(Z^1)_3$, $-ZnX^{00}$ and $-Sn(Z^4)_3$, wherein

$X^{00}$ is halogen, preferably Cl, Br or I, $Z^{1-4}$ are selected from the group consisting of alkyl, preferably $C_{1-10}$ alkyl and aryl, preferably $C_{6-12}$ aryl, each being optionally substituted, and two groups $Z^2$ may also form a cycloboronate group having 2 to 20 C atoms with the B- and O-atoms.

The monomers of formula MI-MIII can be co-polymerised with each other and/or with other suitable co-monomers.

The conjugated polymer according to the present invention can be synthesized according to or in analogy to methods that are known to the skilled person and are described in the literature. Other methods of preparation can be taken from the examples.

For example, the conjugated polymers can be suitably prepared by aryl-aryl coupling reactions, such as Yamamoto coupling, C-H activation coupling, Suzuki coupling, Stille coupling, Sonogashira coupling, Heck coupling or Buchwald coupling. Suzuki coupling, Stille coupling and Yamamoto coupling are especially preferred. The monomers which are polymerised to form the repeat units of the polymers can be prepared according to methods which are known to the person skilled in the art.

The n-type semiconductor as used in a mixture of the present invention can be an inorganic material such as zinc oxide ($ZnO_x$), zinc tin oxide (ZTO), titanium oxide ($TiO_x$), molybdenum oxide ($MoO_x$), nickel oxide ($NiO_x$), or cadmium selenide (CdSe), or an organic material such as graphene or a fullerene, a conjugated polymer or substituted fullerene, for example a (6,6)-phenyl-butyric acid methyl ester derivatized methano $C_{60}$ fullerene, also known as "PCBM-$C_{60}$" or "$C_{60}$PCBM", as disclosed for example in Science 1995, 270, 1789 and having the structure shown below, or structural analogous compounds with e.g. a $C_{70}$ fullerene group or an organic polymer (see for example Coakley, K. M. and McGehee, M. D. Chem. Mater. 2004, 16, 4533).

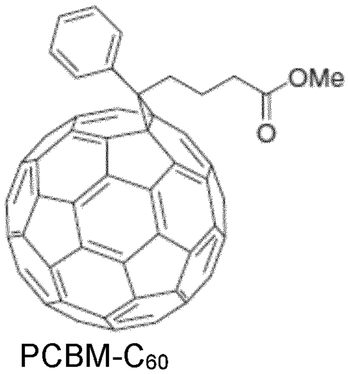

PCBM-$C_{60}$

Preferably the n-type semiconductor is a fullerene or a substituted fullerene.

Preferred fullerenes and substituted fullerenes are selected from PCBM-C60, PCBM-C70 and mixtures thereof.

Further preferred fullerenes and substituted fullerenes are selected of formula XII,

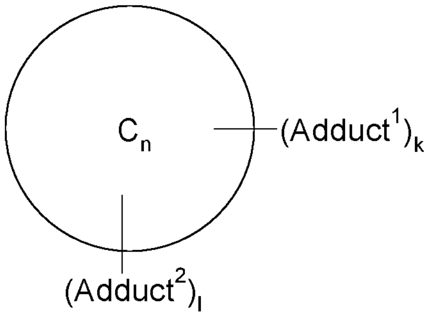

XII

wherein

$C_n$ denotes a fullerene composed of n carbon atoms, optionally with one or more atoms trapped inside,

Adduct[1] is a primary adduct appended to the fullerene $C_n$ with any connectivity,

Adduct2 is a secondary adduct, or a combination of secondary adducts, appended to the fullerene $C_n$ with any connectivity,

k is an integer ≥ 1,

and

l is 0, an integer ≥ 1, or a non-integer > 0.

In the formula XII and its subformulae, k preferably denotes 1, 2, 3 or, 4, very preferably 1 or 2.

The fullerene $C_n$ in formula XII and its subformulae may be composed of any number n of carbon atoms Preferably, in the compounds of formula XII and its subformulae the number of carbon atoms n of which the fullerene $C_n$ is composed is 60, 70, 76, 78, 82, 84, 90, 94 or 96, very preferably 60 or 70.

The fullerene $C_n$ in formula XII and its subformulae is preferably selected from carbon based fullerenes, endohedral fullerenes, or mixtures thereof, very preferably from carbon based fullerenes.

Suitable and preferred carbon based fullerenes include, without limitation, $(C_{60-Ih})$[5,6]fullerene, $(C_{70}\text{-}D_{5h})$[5,6]fullerene, $(C_{76\text{-}D2*})$[5,6]fullerene, $(C_{84\text{-}D2*})$[5,6]fullerene, $(C_{84\text{-}D2d})$[5,6]fullerene, or a mixture of two or more of the aforementioned carbon based fullerenes.

The endohedral fullerenes are preferably metallofullerenes. Suitable and preferred metallofullerenes include, without limitation, $La@C_{60}$, $La@C_{82}$, $Y@C_{82}$, $Sc_3N@C_{80}$, $Y_3N@C_{80}$, $Sc_3C_2@C_{80}$ or a mixture of two or more of the aforementioned metallofullerenes.

Preferably the fullerene $C_n$ is substituted at a [6,6] and/or [5,6] bond, preferably substituted on at least one [6,6] bond.

Preferably the fullerene or substituted fullerene, or the compound of formula XII, contains one or more primary and secondary adducts, or Adduct[1] and Adduct[2] in formula XII, selected from the following formulae

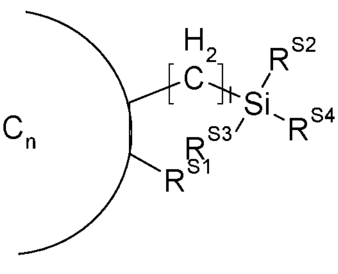

S-1

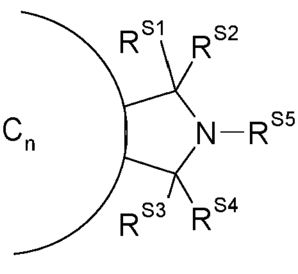

S-2

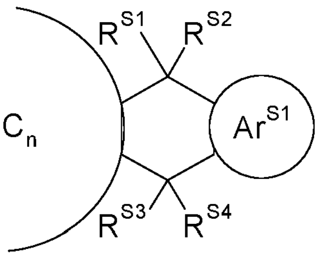

S-3

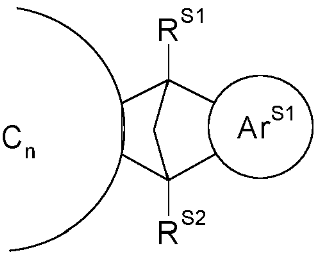

S-4

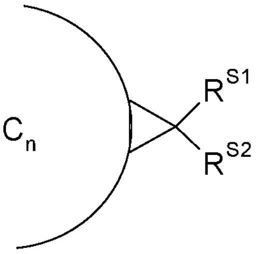

S-5

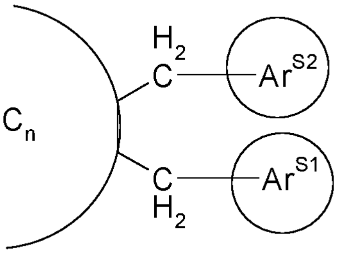

S-6

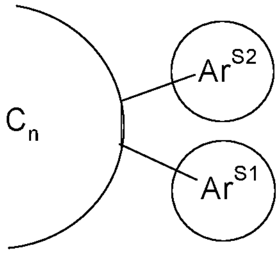

S-7

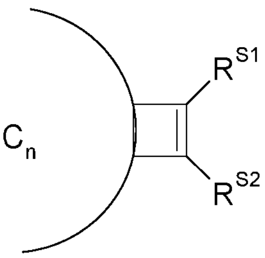

S-8

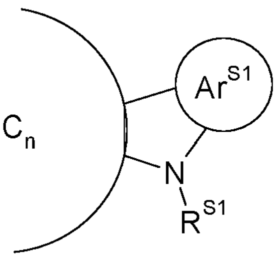

S-9

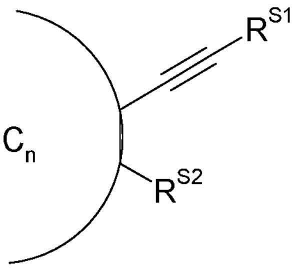

S-10

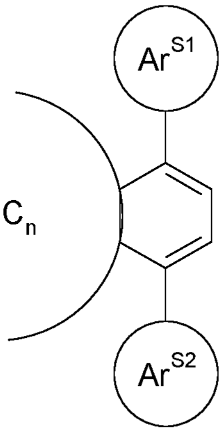

S-11

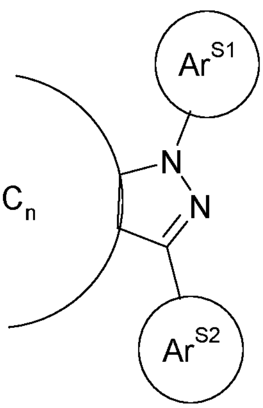

S-12

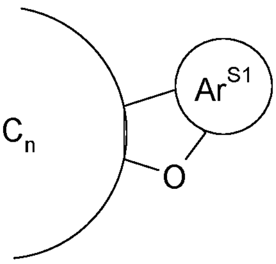

S-13

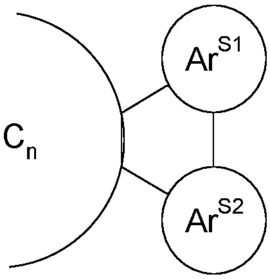

S-14

wherein

$Ar^{S1}$, $Ar^{S2}$ denote, independently of each other, an arylene or heteroarylene group with 5 to 20, preferably 5 to 15, ring atoms, which is mono- or polycyclic, and which is optionally substituted by one or more identical or different substituents having one of the meanings of $R^S$ as defined above and below.,

$R^{S1}$, $R^{S2}$, $R^{S3}$, $R^{S4}$ and $R^{S5}$ independently of each other denote H, CN or have one of the meanings of $R^{11}$ as defined above and below.

Preferably the fullerene or substituted fullerene, or the compound of formula XII, is selected from the following subformulae:

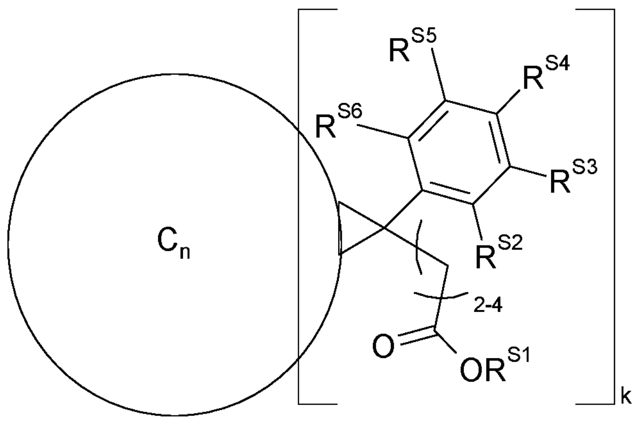

XIIa

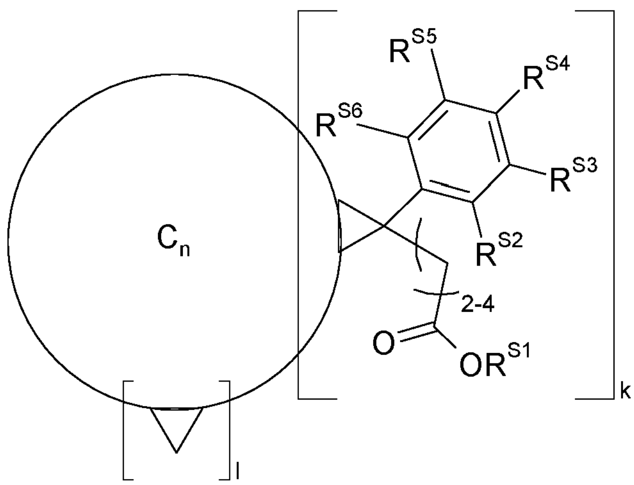

XIIb

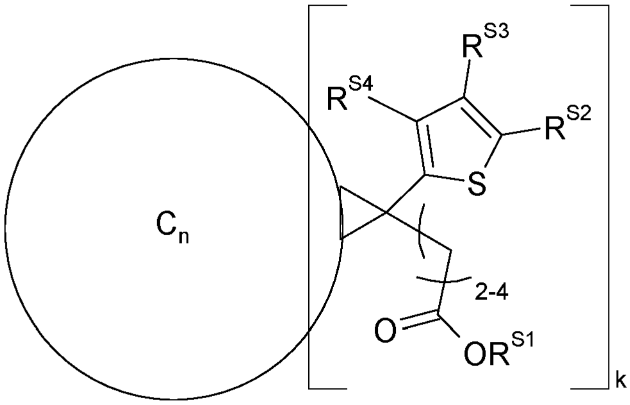

XIIc

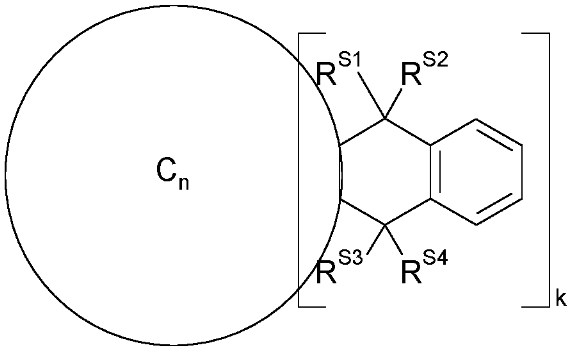

XIId

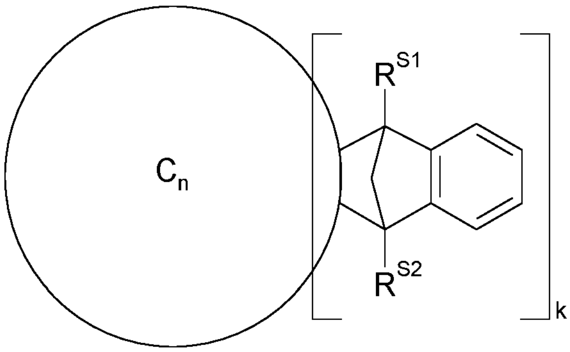

XIIe

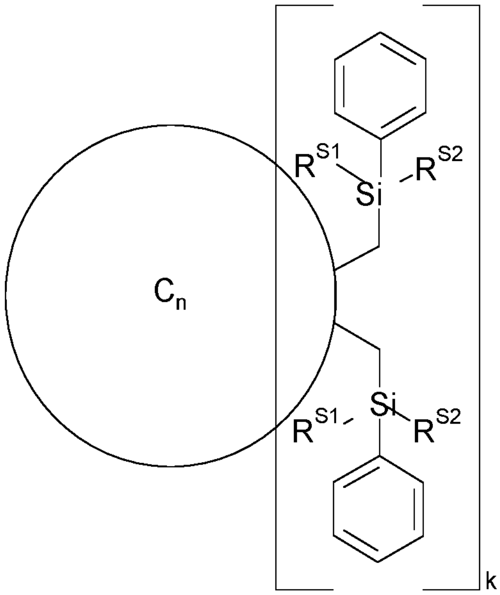

XIIf

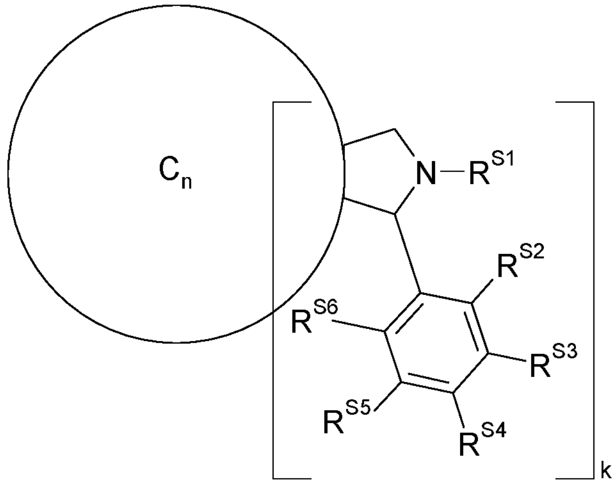

XIIg

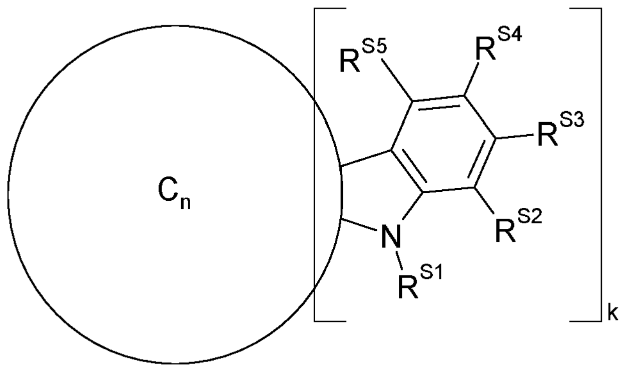

XIIh

wherein
$R^{S1}$, $R^{S2}$, $R^{S3}$, $R^{S4}$ $R^{S5}$ and $R^{S6}$ independently of each other denote H or have one of the meanings of $R^{11}$ as defined above and below, and k is as defined in formula XII.

Also preferably the polymer according to the present invention is blended with other type of n-type semiconductor such as graphene, a metal oxide, like for example, ZnOx, TiOx, ZTO, MoOx, NiOx, quantum dots, like for example, CdSe or CdS, or a conjugated polymer, like for example a polynaphthalenediimide or polyperylenediimide as described, for example, in WO2013142841 A1 to form the active layer in an OPV or OPD device.

In a mixture according to the present invention (i.e. excluding solvents), the concentration of the n-type semiconductor is preferably from 40 to 90% by weight, very preferably from 50 to 70% by weight.

In a mixture according to the present invention (i.e. excluding solvents), the concentration of the p-type semiconductor is preferably from 10 to 60% by weight, very preferably from 30 to 50% by weight.

In a mixture according to the present invention, the ratio p-type semiconductor: n-type semiconductor is preferably from 5:1 to 1:5 by weight, more preferably from 1:0.5 to 1:3 by weight, most preferably 1:1 to 1:2 by weight.

In another preferred embodiment of the present invention, the mixture further comprises one or more binders to adjust the rheological properties as described for example in WO 2005/055248A1. Suitable and preferred binders are polymeric binders, like for example polystyrene (PS), polypropylene (PP) and polymethylmethacrylate (PMMA). The binder may be added to the mixture in a concentration from 5 to 95% by weight of total solids (i.e. without solvents).

The mixture according to the present invention can be used together with other monomeric compounds, or polymers, having one or more of a semiconducting, charge transport, hole transport, electron transport, hole blocking, electron blocking, electrically conducting, photoconducting and light emitting property

Thus, another aspect of the invention relates to a mixture as defined above and below, further comprising one or more additional compounds, preferably having one or more of a semiconducting, charge transport, hole transport, electron transport, hole blocking, electron blocking, electrically conducting, photoconducting and light emitting property.

Another aspect of the present invention relates to a mixture as described above and below, further comprising one or more solvents, preferably selected from organic solvents.

Such a mixture is preferably used as a carrier for the preparation of a semiconducting layer, preferably the photoactive layer, of an OE device, like an OPV or OPD device.

In a mixture according to the present invention, the concentration of the solid components (including p-type semiconductor, n-type semiconductor and nanoparticles) is preferably from 0.1 to 10% by weight, more preferably 0.5 to 5% by weight.

The mixture according to the present invention preferably forms a solution.

The invention additionally provides an OE device comprising a mixture according to the present invention, and an OE device comprising a semiconducting or photoactive layer (hereinafter also referred to as "active layer"), comprising a mixture according to the present invention as described above and below.

Preferred OE devices are OFETs, TFTs, ICs, logic circuits, capacitors, RFID tags, OLEDs, OLETs, OPEDs, OPVs, OPDs, organic solar cells, DSSCs, perovskite based solar cells, laser diodes, photoconductors, photodetectors, electrophotographic devices, electrophotographic recording devices, organic memory devices, sensor devices, charge injection layers, Schottky diodes, planarising layers, antistatic films, conducting substrates and conducting patterns.

Especially preferred electronic device are OFETs, OLEDs, OPV and OPD devices, in particular bulk heterojunction (BHJ) OPV devices and OPD devices. In an OPV or OPD device, for example, the photoactive layer may comprise a mixture according to the present invention. In an OFET, for example, the active semiconductor channel between the drain and source may comprise a semiconducting layer comprising a mixture according to the present invention. As another example, in an OLED device, the charge (hole or electron) injection or transport layer may comprise may comprise a mixture according to the present invention.

The mixture according to the present invention is especially suitable as photoactive material for use in the photoactive layer of an OPV, BHJ OPV or OPD device. Therein the conjugated polymer(s) comprising units of formula 1 and 2 act as electron donor or p-type semiconductor component, and the fullerene(s) of formula F act as electron acceptor or n-type semiconductor component. The fullerene(s) and conjugated polymer(s) are preferably selected such that the mixture forms a bulk heterojunction.

The OPV or OPD device preferably further comprises a first transparent or semi-transparent electrode on a transparent or semi-transparent substrate on one side of the active layer, and a second metallic or semi-transparent electrode on the other side of the active layer.

In another preferred embodiment, the photoactive layer comprises a mixture according to the present invention that further comprises one or more organic or inorganic compounds or materials to enhance the device properties. Suitable and preferred example of such additional compounds or materials are selected from metal particles, such as Au or Ag nanoparticules or Au or Ag nanoprism for enhancements in light harvesting due to near-field effects (i.e. plasmonic effect) as described, for example in Adv. Mater. 2013, 25 (17), 2385-2396 and Adv. Ener. Mater. 10.1002/aenm.201400206, a molecular dopant such as 2,3,5,6-tetrafluoro-7,7,8,8-tetracyanoquinodimethane for enhancement in photoconductivity as described, for example in Adv. Mater. 2013, 25(48), 7038-7044, or a stabilising agent consisting of a UV absorption agent and/or anti-radical agent and/or antioxidant agent such as 2-hydroxybenzophenone, 2-hydroxyphenylbenzotriazole, oxalic acid anilides, hydroxyphenyl triazines, merocyanines, hindered phenol, N-arylthiomorpholine, N-aryl-thiomorpholine-1-oxide, N-aryl-thiomorpholine-1,1-dioxide, N-arylthiazolidine, N-aryl-thiazolidine-1-oxide, N-aryl-thiazolidine-1,1-dioxide and 1,4-diazabicyclo[2.2.2]octane as described, for example, in WO2012095796 A1 and in WO2013021971 A1.

The OPV or OPD device preferably further comprises a UV to visible photo-conversion layer such as described, for example, in J. Mater. Chem. 2011, 21, 12331 or a NIR to visible or IR to NIR photo-conversion layer such as described,

for example, in J. Appl. Phys. 2013, 113, 124509.

The OPV or OPD device may further comprise, between the active layer and an electrode, additional interfacial layer(s) acting as hole blocking layer, hole transporting layer, electron blocking layer and/or electron transporting layer, typically comprising a metal oxide (for example, $ZnO_x$, $TiO_x$, ZTO, $MoO_x$, $NiO_x$), a salt (example: LiF, NaF), a conjugated polymer electrolyte (for example: PEDOT:PSS or PFN), a conjugated polymer (for example: PTAA) or an organic compound (for example: NPB, $Alq_3$, TPD), can be inserted.

Preferably the OPV or OPD device comprises, between the active layer and the first or second electrode, one or more additional buffer layers acting as hole transporting layer and/or electron blocking layer, which comprise a material such as metal oxides, like for example, ZTO, $MoO_x$, $NiO_x$, a doped conjugated polymer, like for example PEDOT:PSS and polypyrrole-polystyrene sulfonate (PPy:PSS), a conjugated polymer, like for example polytriarylamine (PTAA), an organic compound, like for example substituted triaryl amine derivatives such as N,N'-diphenyl-N,N'-bis(1-naphthyl)(1,1'-biphenyl)-4,4'diamine (NPB), N,N'-diphenyl-N,N'-(3-methylphenyl)-1,1'-biphenyl-4,4'-diamine (TPD), graphene based materials, like for example, graphene oxide, reduced graphene oxide, graphene, graphene nanoribbons and graphene quantum dots or alternatively as hole blocking layer and/or electron transporting layer, which comprise a material such as metal oxide, like for example, $ZnO_x$, $TiO_x$, AZO (aluminium doped zinc oxide), a salt, like for example LiF, NaF, CsF, a conjugated polymer electrolyte, like for example poly[3-(6-trimethylammoniumhexyl)thiophene], poly(9,9-bis(2-ethylhexyl)-fluorene]-b-poly[3-(6-trimethylammoniumhexyl)thiophene], or poly[(9,9-bis(3'-(N,N-dimethylamino)propyl)-2,7-fluorene)-alt-2,7-(9,9-dioctylfluorene)], a polymer, like for example poly(ethyleneimine) or crosslinked N-containing compound derivatives or an organic compound, like for example tris(8-quinolinolato)-aluminium(III) ($Alq_3$), phenanthroline derivative or $C_{60}$ or $C_{70}$ based fullerenes, like for example, as described in Adv. Energy Mater. 2012, 2, 82-86.

To produce thin layers in OE devices, like BHJ OPV devices, a mixture or formulation according to the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing. For the fabrication of OPV devices and modules area printing method compatible with flexible substrates are preferred, for example slot dye coating, spray coating and the like.

When preparing a suitable solution or formulation containing a mixture with a fullerene (as n-type component) and a polymer (as p-type component) according to the present invention, a suitable solvent should be selected so as to ensure full dissolution of both the p-type and the n-type component, and to take into account the boundary conditions (for example rheological properties) introduced by the chosen printing method.

Organic solvents are generally used for this purpose. Typical solvents can be aromatic solvents, halogenated solvents or chlorinated solvents, including chlorinated aromatic solvents. Preferred solvents are aliphatic hydrocarbons, chlorinated hydrocarbons, aromatic hydrocarbons, ketones, ethers and mixtures thereof. Examples include, but are not limited to dichloromethane, trichloromethane, tetrachloromethane, chlorobenzene, o-dichlorobenzene, 1,2,4-trichlorobenzene, 1,2-dichloroethane, 1,1,1-trichloroethane, 1,1,2,2-tetrachloroethane, 1,8-diiodooctane, 1-chloronaphthalene, 1,8-octane-dithiol, anisole, 2-methylanisole, phenetol, 4-methyl-anisole, 3-methylanisole, 2,6-dimethylanisole, 2,5-dimethylanisole, 2,4-dimethylanisole, 3,5-dimethyl-anisole, 4-fluoroanisole, 3-fluoro-anisole, 3-trifluoro-methylanisole, 4-fluoro-3-methylanisole, 2-fluoroanisole, toluene, o-xylene, m-xylene, p-xylene, mixture of xylene o-, m-, and p-isomers, 1,2,4-trimethylbenzene, 1,2,3,4-tetra-methyl benzene, pentylbenzene, mesitylene, cumene, cymene, cyclohexylbenzene, diethylbenzene, cyclohexane, 1-methylnaphthalene, 2-methylnaphthalene, 1,2-dimethylnaphthalene, tetraline, decaline, indane, 1-methyl-4-(1-methylethenyl)-cyclohexene (d-Limonene), 6,6-dimethyl-2-methylenebicyclo[3.1.1]heptanes ($\beta$-pinene), 2,6-lutidine, 2-fluoro-m-xylene, 3-fluoro-o-xylene, 2-chloro-benzotrifluoride, 2-chloro-6-fluorotoluene, 2,3-dimethylpyrazine, 2-fluorobenzonitrile, 4-fluoroveratrol, 3-fluorobenzo-nitrile, 1-fluoro-3,5-dimethoxy-benzene, 3-fluorobenzotrifluoride, benzotrifluoride, trifluoromethoxy-benzene, 4-fluorobenzotrifluoride, 3-fluoropyridine, toluene, 2-fluoro-toluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluoro-benzene, 1-chloro-2,5-difluorobenzene, 4-chlorofluorobenzene, 2-chlorofluorobenzene, methyl benzoate, ethyl benzoate, nitrobenzene, benzaldehyde, benzonitrile, tetrahydrofuran, 1,4-dioxane, 1,3-dioxane, morpholine, acetone, methylethylketone, ethyl acetate, n-butyl acetate, N,N-dimethylaniline, N,N-dimethylformamide, N-methylpyrrolidinone, dimethylacetamide, dimethylsulfoxide and/or mixtures thereof.

Especially preferred are solvents selected from aliphatic or aromatic hydrocarbons, or mixtures thereof, which are non-chlorinated.

Further preferred are solvents selected from non-chlorinated aliphatic or aromatic hydrocarbons, or mixtures thereof, which contain less than 5% of halogenated but non-chlorinated (e.g. fluorinated, brominated or iodinated) aliphatic or aromatic hydrocarbons, like e.g. 1,8-diiodooctane.

Preferred solvents of this type are selected from 1,2,4-trimethylbenzene, 1,2,3,4-tetra-methyl benzene, pentylbenzene, mesitylene, cumene, cymene, cyclohexylbenzene, diethylbenzene, tetralin, decalin, 2,6-lutidine, N,N-dimethylformamide, 2,3-dimethylpyrazine, 2-methylanisole, phenetol, 4-methyl-anisole, 3-methylanisole, 2,5-dimethyl-anisole, 2,4-dimethylanisole, 3,5-dimethyl-anisole, N,N-dimethylaniline, ethyl benzoate, 1-methylnaphthalene, 2-methylnaphthalene, N-methylpyrrolidinone, dioxane, 4-isopropylbiphenyl, phenyl ether, 2-methylthiophene, pyridine, 1,8-octanedithiol, nitrobenzene, 1-chloronaphthalene, p-xylene, m-xylene, o-xylene or mixture of o-, m-, and p-isomers.

The OPV device can be of any OPV device type known from the literature (see e.g. Waldauf et al., Appl. Phys. Lett., 2006, 89, 233517).

A first preferred OPV device according to the invention comprises the following layers (in the sequence from bottom to top):

- optionally a substrate,
- a high work function electrode, preferably comprising a metal oxide, like for example ITO, serving as anode or a conducting grid
- an optional conducting polymer layer or hole transport layer, preferably comprising an organic polymer or polymer blend, for example PEDOT:PSS (poly(3,4-ethylenedioxythiophene): poly(styrenesulfonate), substituted triaryl amine derivatives, for example,TBD (N,N'-dyphenyl-N-N'-bis(3-methylphenyl)-1,1'biphenyl-4,4'-diamine) or NBD (N,N'-dyphenyl-N-N'-bis(1-napthylphenyl)-1,1'biphenyl-4,4'-diamine),
- a layer, also referred to as "photoactive layer", comprising a p-type and an n-type organic semiconductor, which can exist for example as a p-type/n-type bilayer or as distinct p-type and n-type layers, or as blend or p-type and n-type semiconductor, forming a BHJ,
- optionally a layer having electron transport properties, for example comprising LiF, $TiO_x$, $ZnO_x$, PFN, a poly(ethyleneimine) or crosslinked nitrogen containing compound derivatives or a phenanthroline derivatives
- a low work function electrode, preferably comprising a metal like for example aluminum, serving as cathode, wherein at least one of the electrodes, preferably the anode, is at least partially transparent to visible light, and wherein the photoactive layer contains a mixture according to the present invention.

A second preferred OPV device according to the invention is an inverted OPV device and comprises the following layers (in the sequence from bottom to top):

- optionally a substrate,
- a high work function metal or metal oxide electrode, comprising for example ITO, serving as cathode, or a conducting grid
- a layer having hole blocking properties, preferably comprising a metal oxide like $TiO_x$ or $ZnO_x$, or comprising an organic compound such as polymer like poly(ethyleneimine) or crosslinked nitrogen containing compound derivatives or phenanthroline derivatives,
- a photoactive layer comprising a p-type and an n-type organic semiconductor, situated between the electrodes, which can exist for example as a p-type/n-type bilayer or as distinct p-type and n-type layers, or as blend or p-type and n-type semiconductor, forming a BHJ,
- an optional conducting polymer layer or hole transport layer, preferably comprising an organic polymer or polymer blend, for example of PEDOT:PSS or substituted triaryl amine derivatives, for example, TBD or NBD,
- an electrode comprising a high work function metal like for example silver, serving as anode, wherein at least one of the electrodes, preferably the cathode, is at least partially transparent to visible light, and wherein the photoactive layer contains a mixture according to the present invention.

In the OPV devices of the present invention the p-type and n-type semiconductor materials are preferably selected from the materials, like the polymer/fullerene systems, as described above

When the photoactive layer is deposited on the substrate, it forms a BHJ that phase separates at nanoscale level. For discussion on nanoscale phase separation see Dennler et al, Proceedings of the IEEE, 2005, 93 (8), 1429 or Hoppe et al, Adv. Func. Mater, 2004, 14(10), 1005. An optional annealing step may be then necessary to optimize blend morpohology and consequently OPV device performance.

Another method to optimize device performance is to prepare formulations for the fabrication of OPV(BHJ) devices that may include additives with variable boiling points to promote phase separation in the right way. 1,8-Octanedithiol, 1,8-diiodooctane, nitrobenzene, 1-chloronaphthalene, N,N-dimethylformamide, dimethylacetamide, dimethylsulfoxide and other additives have been used to obtain high-efficiency solar cells. Examples are disclosed in J. Peet, et al, Nat. Mater., 2007, 6, 497 or Fréchet et al. J. Am. Chem. Soc., 2010, 132, 7595-7597.

As further illustrated in the non-limiting working examples, photovoltaic devices can be prepared which have a power conversion efficiency (PCE) of, for example, at least 2.5%, or at least 3.0%, or at least 4.0%, or at least 5.0%.

While there is no particular upper limit on the PCE, the PCE can be, for example, less than 20%, or less than 15%, or less than 10%.

Another preferred embodiment of the present invention relates to the use of a mixture according to the present invention as dye, hole transport layer, hole blocking layer, electron transport layer and/or electron blocking layer in a DSSC or a perovskite-based solar cells, and to a DSSC or perovskite-based solar cells comprising a mixture according to the present invention.

DSSCs and perovskite-based solar cells can be manufactured as described in the literature, for example in Chem. Rev. 2010, 110, 6595-6663, Angew. Chem. Int. Ed. 2014, 53, 2-15 or in WO2013171520A1.

The mixtures of the present invention can also be used as dye or pigment in other applications, for example as an ink dye, laser dye, fluorescent marker, solvent dye, food dye, contrast dye or pigment in coloring paints, inks, plastics, fabrics, cosmetics, food and other materials.

The mixtures and semiconducting layers of the present invention are also suitable for use as n-type semiconductor in other OE devices or device components, for example in the semiconducting channel of an OFET device, or in the buffer layer, electron transport layer (ETL) or hole blocking layer (HBL) of an OLED or OPV device.

Accordingly, the invention also provides an OFET comprising a gate electrode, an insulating (or gate insulator) layer, a source electrode, a drain electrode and an organic semiconducting channel connecting the source and drain electrodes, wherein the organic semiconducting channel comprises a mixture according to the present invention as semiconductor. Other features of the OFET are well known to those skilled in the art.

OFETs where an OSC material is arranged as a thin film between a gate dielectric and a drain and a source electrode, are generally known, and are described for example in US 5,892,244, US 5,998,804, US 6,723,394 and in the references cited in the background section. Due to the advantages, like low cost production using the solubility properties of the compounds according to the invention and thus the processibility of large surfaces, preferred applications of these FETs are such as integrated circuitry, TFT displays and security applications.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

An OFET device according to the present invention preferably comprises:

- a source electrode,
- a drain electrode,
- a gate electrode,
- a semiconducting layer,
- one or more gate insulator layers,
- optionally a substrate.

wherein the semiconductor layer comprises a mixture according to the present invention.

The OFET device can be a top gate device or a bottom gate device. Suitable structures and manufacturing methods of an OFET device are known to the skilled in the art and are described in the literature, for example in US 2007/0102696 A1.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoropolymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric constant) from 1.0 to 5.0, very preferably from 1.8 to 4.0 ("low k materials"), as disclosed for example in US 2007/0102696 A1 or US 7,095,044.

In security applications, OFETs and other devices with semiconducting materials according to the present invention, like transistors or diodes, can be used for RFID tags or security markings to authenticate and prevent counterfeiting of documents of value like banknotes, credit cards or ID cards, national ID documents, licenses or any product with monetry value, like stamps, tickets, shares, cheques etc.

Alternatively, the mixtures and semiconducting layers according to the invention can be used in OLEDs, for example in the buffer layer, ETL or HBL of an OLED. The OLED device can be used for example as the active display layer in a flat panel display device, or as the backlight of a flat panel display like for example a liquid crystal display. Common OLEDs are realized using multilayer structures. An emission layer is generally sandwiched between one or more electron-transport and/or hole-transport layers. By applying an electric voltage electrons and holes as charge

carriers move towards the emission layer where their recombination leads to the excitation and hence luminescence of the lumophor units contained in the emission layer.

The mixture or semiconducting layer according to the present invention may be employed in one or more of the ETL, HBL or buffer layer, especially their water-soluble derivatives (for example with polar or ionic side groups) or ionically doped forms. The processing of such layers, comprising a semiconductor material of the present invention, for the use in OLEDs is generally known by a person skilled in the art, see, e.g., Müller et al, Synth. Metals, 2000, 111-112, 31-34, Alcala, J. Appl. Phys., 2000, 88, 7124-7128, O'Malley et al, Adv. Energy Mater. 2012, 2, 82-86 and the literature cited therein.

According to another use, the mixtures according to this invention, especially those showing photoluminescent properties, may be employed as materials of light sources, e.g. in display devices, as described in EP 0 889 350 A1 or by C. Weder et al., Science, 1998, 279, 835-837.

A further aspect of the invention relates to both the oxidised and reduced form of a mixture according to this invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantation of the dopant into the semiconductor material.

When electrons are used as carriers, suitable dopants are for example halogens (e.g., $I_2$, $Cl_2$, $Br_2$, ICl, $ICl_3$, IBr and IF), Lewis acids (e.g., $PF_5$, $AsF_5$, $SbF_5$, $BF_3$, $BCl_3$, $SbCl_5$, $BBr_3$ and $SO_3$), protonic acids, organic acids, or amino acids (e.g., HF, HCl, $HNO_3$, $H_2SO_4$, $HClO_4$, $FSO_3H$ and $ClSO_3H$), transition metal compounds (e.g., $FeCl_3$, FeOCl, $Fe(ClO_4)_3$, $Fe(4\text{-}CH_3C_6H_4SO_3)_3$, $TiCl_4$, $ZrCl_4$, $HfCl_4$, $NbF_5$, $NbCl_5$, $TaCl_5$, $MoF_5$, $MoCl_5$, $WF_5$, $WCl_6$, $UF_6$ and $LnCl_3$ (wherein Ln is a lanthanoid), anions (e.g., $Cl^-$, $Br^-$, $I^-$, $I_3^-$, $HSO_4^-$, $SO_4^{2-}$, $NO_3^-$, $ClO_4^-$, $BF_4^-$, $PF_6^-$, $AsF_6^-$, $SbF_6^-$, $FeCl_4^-$, $Fe(CN)_6^{3-}$, and anions of various sulfonic acids, such as aryl-$SO_3^-$). When holes are used as carriers, examples of dopants are cations (e.g., $H^+$, $Li^+$, $Na^+$, $K^+$, $Rb^+$ and $Cs^+$), alkali metals (e.g., Li, Na, K, Rb, and Cs), alkalineearth metals (e.g., Ca, Sr, and Ba), $O_2$, $XeOF_4$, $(NO_2^+)$ $(SbF_6^-)$, $(NO_2^+)$ $(SbCl_6^-)$, $(NO_2^+)$ $(BF_4^-)$, $AgClO_4$, $H_2IrCl_6$, $La(NO_3)_3 \cdot 6H_2O$, $FSO_2OOSO_2F$, Eu, acetylcholine, $R_4N^+$, (R is an alkyl group), $R_4P^+$ (R is an alkyl group), $R_6As^+$ (R is an alkyl group), and $R_3S^+$ (R is an alkyl group).

The conducting form of a mixture of the present invention can be used as an organic "metal" in applications including, but not limited to, charge injection layers and ITO planarising layers in OLED applications, films for flat panel displays and touch screens, antistatic films, printed conductive substrates, patterns or tracts in electronic applications such as printed circuit boards and condensers.

According to another use, the mixtures according to the present invention can be used alone or together with other materials in or as alignment layers in LCD or OLED devices, as described for example in US 2003/0021913. The use of charge transport compounds according to the present invention can increase the electrical conductivity of the alignment layer. When used in an LCD, this increased electrical conductivity can reduce adverse residual dc effects in the switchable LCD cell and suppress image sticking or, for example in ferroelectric LCDs, reduce the residual charge produced by the switching of the spontaneous polarisation charge of the ferroelectric LCs. When used in an OLED device comprising a light emitting material provided onto the alignment layer, this increased electrical conductivity can enhance the electroluminescence of the light emitting material. The mixtures according to the present invention may also be combined with photoisomerisable compounds and/or chromophores for use in or as photoalignment layers, as described in US 2003/0021913 A1.

According to another use the mixtures according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W. McBranch, H. Wang, R. Helgeson, F. Wudl and D. G. Whitten, Proc. Natl. Acad. Sci. U.S.A., 1999, 96, 12287; D. Wang, X. Gong, P. S. Heeger, F. Rininsland, G. C. Bazan and A. J. Heeger, Proc. Natl. Acad. Sci. U.S.A., 2002, 99, 49; N. DiCesare, M. R. Pinot, K. S. Schanze and J. R. Lakowicz, Langmuir, 2002, 18, 7785; D. T. McQuade, A. E. Pullen, T. M. Swager, Chem. Rev., 2000, 100, 2537.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

All of the features disclosed in this specification may be combined in any combination, except combinations

where at least some of such features and/or steps are mutually exclusive. In particular, the preferred features of the invention are applicable to all aspects of the invention and may be used in any combination. Likewise, features described in non-essential combinations may be used separately (not in combination).

Above and below, unless stated otherwise percentages are percent by weight and temperatures are given in °C. The values of the dielectric constant ε ("permittivity") refer to values taken at 20°C and 1,000 Hz.

The invention will now be described in more detail by reference to the following examples, which are illustrative only and do not limit the scope of the invention.

## Examples

Organic photovoltaic (OPV) devices are fabricated on pre-patterned ITO-glass substrates (13Ω/sq.) purchased from LUMTEC Corporation. Substrates are cleaned using common solvents (acetone, iso-propanol, deionized-water) in an ultrasonic bath. A layer of commercially available PVE-002 (Merck) was applied as a uniform coating by doctor blade at 80 °C. The PVE-002 Films are then annealed at 100 °C for 10 minutes in air and then transferred into a Nitrogen atmosphere. Active material solutions (i.e. polymer + fullerene) are prepared to fully dissolve the solutes at a 30 mg.cm$^{-3}$ solution concentration in 1-methylnaphthalene (1MN), an additional quantity of porous particles are then added to this solution. Thin films are blade-coated in a nitrogen atmosphere to achieve active layer thicknesses between 50 and 1000 nm as measured using a profilometer. A short drying period follows to ensure removal of any residual solvent.

Typically, blade-coated films are dried at 60 °C or 90 °C for 2 minutes on a hotplate. Next the devices are transferred into an air atmosphere. On top of the active layer 0.9 cm$^{-3}$ of a conducting polymer poly(ethylene dioxythiophene) doped with poly(styrene sulfonic acid) [PEDOT:PSS Clevios HTL Solar SCA 246-10 (Heraeus)] was spread and uniformly coated by spin-coating at 1100 rpm for 130 seconds. Afterwards Ag (100 nm) cathodes are thermally evaporated through a shadow mask to define the cells. For the last step of the device fabrication, the devices were each encapsulated with a glass cover slide using UV-curing epoxy glue. Current-voltage characteristics are measured using a Keithley 2400 SMU while the solar cells are illuminated by a Newport Solar Simulator at 100 mW.cm$^{-2}$ white light. The solar simulator is equipped with AM1.5G filters. The illumination intensity is calibrated using a Si photodiode. All the device preparation and characterization is done in a dry-nitrogen atmosphere.

Table 1: summary of surface treated silica products.

| Aerosil® | Specific Surface Area (BET) | Surface substituent |
|---|---|---|
| R 805 | 150 ± 25 | 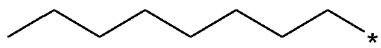 |
| R 812 | 220 ± 25 | 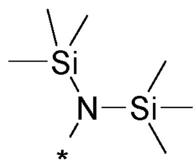 |
| R 972 | 110 ± 20 | 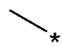 |

Power conversion efficiency (PCE) is calculated using the following expression

$$\eta = \frac{V_{oc} \times J_{sc} \times FF}{P_{in}}$$

where FF is defined as

$$FF = \frac{V_{\max} \times J_{\max}}{V_{oc} \times J_{sc}}$$

OPV device characteristics are measured for a mixture comprising Polymer 1 or Polymer 2, PCBM-C60 fullerene and nanoparticles as disclosed below.

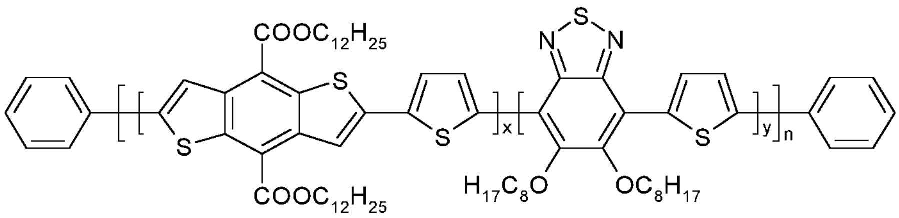

Polymer 1

Polymer 1 and its preparation are disclosed in WO 2011/131280.

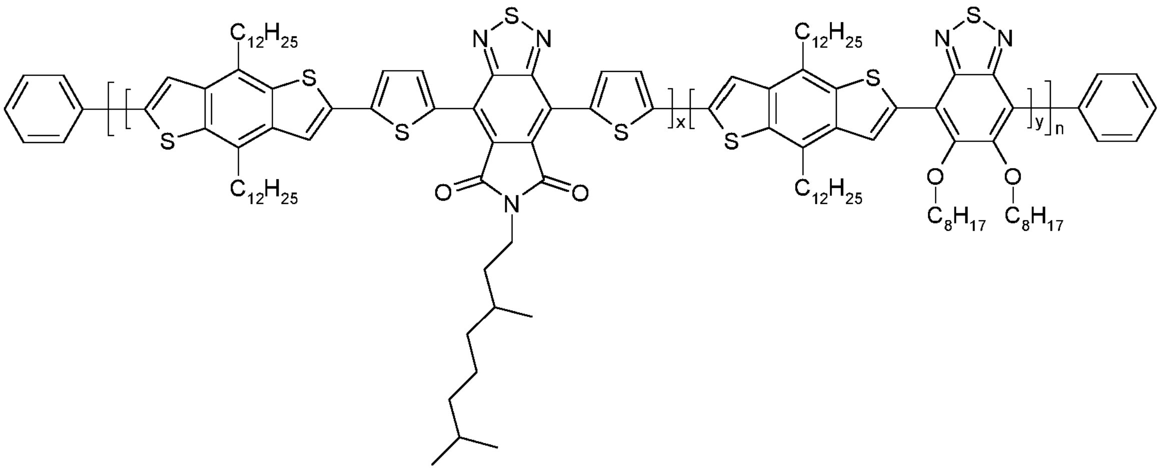

Polymer 2

Polymer 2 and its preparation are disclosed in WO 2014/202184.

Example 1

A formulation consisting of 10 mg.cm$^{-3}$ Polymer 1, 20mg/ml PCBM-C60 and 3 mg.cm$^{-3}$Aerosil® R 972 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 mW.cm$^{-2}$ under white light illumination in a solar simulator is equipped with AM1.5G filters. The performance measured as an average of seven 4.0 mm$^2$ devices is listed in Table 2.

Example 2

A formulation consisting of 10 mg.cm$^{-3}$ Polymer 1, 20 mg.cm$^{-3}$ PCBM-C60 and 9 mg.cm$^{-3}$ Aerosil® R 972 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 mW.cm$^{-2}$ under white light illumination in a solar simulator is equipped with AM1.5G filters. The performance measured as an average of six 4.0 mm$^2$ devices is listed in Table 2.

Example 3

A formulation consisting of 10 mg.cm$^{-3}$ Polymer 1, 20 mg.cm$^{-3}$ PCBM-C60 and 3 mg.cm$^{-3}$ Aerosil® R 812 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 mW.cm$^{-2}$ under white light illumination in a solar simulator is equipped with AM1.5G filters. The performance measured as an average of six 4.0 mm$^2$ devices is listed in Table 2.

Example 4

A formulation consisting of 10 $mg.cm^{-3}$ Polymer 1, 20 $mg.cm^{-3}$ PCBM-C60 and 3 $mg.cm^{-3}$ Aerosil® R 805 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of seven 4.0 $mm^2$ devices is listed in Table 2.

Example 5

A formulation consisting of 10 $mg.cm^{-3}$ Polymer 1, 20 $mg.cm^{-3}$ PCBM-C60 and 9 $mg.cm^{-3}$ Aerosil® R 805 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of five 4.0 $mm^2$ devices is listed in Table 2.

Example 6 (Comparison Example)

A formulation consisting of 10 $mg.cm^{-3}$ Polymer 1, and 20 $mg.cm^{-3}$ PCBM-C60 was prepared in 1-methylnaphthalene. The formulation was stirred overnight at 90 °C. The formulation was coated by doctor blade onto a PV-E002 layer supported by an ITO coated glass substrate at 90 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of eight 4.0 $mm^2$ devices is listed in Table 2.

Example 7

A formulation consisting of 5 $mg.cm^{-3}$ Polymer 2, 10 $mg.cm^{-3}$ PCBM-C60 and 3 $mg.cm^{-3}$ Aerosil® R 972 was prepared in mixture of ortho-xylene (75%) and 2,4-dimethylanisole (25%). The formulation was stirred overnight at 90 °C. The formulation was coated by doctor blade onto a PV-E002 layer supported by an ITO coated glass substrate at 60 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of five 4.0 $mm^2$ devices is listed in Table 2.

Example 8

A formulation consisting of 5 $mg.cm^{-3}$ Polymer 2, 10 $mg.cm^{-3}$ PCBM-C60 and 3 $mg.cm^{-3}$ Aerosil® R 805 was prepared in mixture of ortho-xylene (75%) and 2,4-dimethylanisole (25%). The formulation was stirred overnight at 90 °C. The formulation was coated by doctor blade onto a PV-E002 layer supported by an ITO coated glass substrate at 60 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of five 4.0 $mm^2$ devices is listed in Table 2.

Example 9 (Comparison Example)

A formulation consisting of 5 $mg.cm^{-3}$ Polymer 2, and 10 $mg.cm^{-3}$ PCBM-C60 was prepared in mixture of ortho-xylene (75%) and 2,4-dimethylanisole (25%). The formulation was stirred overnight at 90 °C. The formulation was coated by doctor blade onto a PV-E002 layer supported by an ITO coated glass substrate at 60 °C. The device was finalized with a PEDOT:PSS Clevios HTL Solar SCA 246-10 (Heraeus) layer followed by a 100 nm silver layer. The resulting device performance was measured at 100 $mW.cm^{-2}$ under white light illumination in a solar simulator is equipped with AM1.5G filters. The performance measured as an average of five 4.0 $mm^2$ devices is listed in Table 2.

Table 2:

| Example | Polymer | Nanopowder [concentration] | Voc (mV) | Jsc ($mA/cm^2$) | FF (%) | PCE (%) |
|---|---|---|---|---|---|---|
| 1 | 1 | R 972 [3 $\frac{mg}{cm^3}$] | 757 | -14.5 | 47.7 | 5.22 |
| 2 | 1 | R 972 [9 $\frac{mg}{cm^3}$] | 770 | -14.7 | 48.6 | 5.47 |
| 3 | 1 | R 812 [3 $\frac{mg}{cm^3}$] | 760 | -13.2 | 47.6 | 4.79 |
| 4 | 1 | R 805 [3 $\frac{mg}{cm^3}$] | 774 | -12.6 | 50.5 | 4.92 |
| 5 | 1 | R 805 [9 $\frac{mg}{cm^3}$] | 772 | -12.0 | 50.4 | 4.64 |
| 6* | 1 | None [0 $\frac{mg}{cm^3}$] | 748 | -13.1 | 41.2 | 4.03 |
| 7 | 2 | R 972 [3 $\frac{mg}{cm^3}$] | 796 | -12.5 | 41.8 | 4.14 |
| 8 | 2 | R 805 [3 $\frac{mg}{cm^3}$] | 785 | -14.5 | 40.5 | 4.59 |
| 9* | 2 | None [0 $\frac{mg}{cm^3}$] | 703 | -16.6 | 40.4 | 4.69 |
| * Comparison Example | | | | | | |

**Figure 1** shows the viscosity of a formulation measured at 90 °C versus shear rate. The formulation consists of 10 $mg.cm^{-3}$ Polymer 1 and 20 $mg.cm^{-3}$ PCBM-C60 in 1-methylnaphthalene. Aerosil® R972 was added to the formulations at 0 $mg{\cdot}cm^{-3}$ (Example 6), 3 $mg{\cdot}cm^{-3}$ (Example 1) and 9 $mg{\cdot}cm^{-3}$ (Example 2).

**Figure 2** shows the viscosity of a formulation measured at 1000 s-1 shear versus temperature. The formulation consists of 10 mg/ml Polymer 1 and 20mg/ml PCBM-C60 in 1-methylnaphthalene. Aerosil® R972 was added to the formulations at 0 $mg{\cdot}cm^{-3}$ (Example 6), 3 $mg{\cdot}cm^{-3}$ (Example 1) and 9 $mg{\cdot}cm^{-3}$ (Example 2).

**Figure 3** shows the influence of nanopowder loading on performance and light stability (exposed to continuous simulated AM1.5G). The formulation consists of 10 mg/ml Polymer 1 and 20mg/ml PCBM-C60 in 1-methylnaphthalene. Aerosil® R972 was added to the formulations at 0 $mg{\cdot}cm^{-3}$ (Example 6), 3 $mg{\cdot}cm^{-3}$ (Example 1) and 9 $mg{\cdot}cm^{-3}$ (Example 2).

The results in Table 2 illustrate an increase in initial performance for polymer 1 with the nanopowder additives by comparison to Example 6. This enhancement is dependent on surface substituent. For polymer 2, no initial enhancement is observed, however, the performance is similar to the reference performance (Example 9). The additives also influence the rheology of the formulation causing a favourable increase in the formulation viscosity across the operating temperature ranges (40 to 90 °C) and different shear rates (100 $s^{-1}$ to 1000 $s^{-1}$) (Figure 2 & 3). These added advantages show no disadvantage to operational OPV lifetime with the appropriate substituent (R 805 or R 972) at low concentrations (3 $mg{\cdot}cm^{-3}$ preferred) for polymer 1.

## Claims

1. A mixture for use in forming a solution, the mixture comprising a p-type semiconductor, an n-type semiconductor, and one or more nanoparticles, wherein the nanoparticles comprise silica, zeolite, carbon, activated carbon silsesquioxane, polysilsesquioxane, clay, or any combination of the aforementioned, **characterised in that** the nanoparticles are hydrophobic and **in that** the nanoparticles are substituted by one or more identical or different groups R, wherein

   R is CN or an alkyl group with 1 to 50 C atoms, which is straight-chain, branched or cyclic, and in which one or more $CH_2$ groups are optionally replaced by -O-, -S-,-C(=O)-,-C(=S)-, -C(=O)-O-, -O-C(=O)-, $-NR^0-$,

-C(=O)-NR$^0$-, -NR$^0$-C(=O)-, -SiR$^0$R$^{00}$-, -CF$_2$-, -CR$^0$=CR$^{00}$-,-CR$^0$=N-, -N=N- or-C≡C- in such a manner that O and/or S atoms are not linked directly to one another, and/or in which one or more H atoms are optionally replaced by F, Cl, Br, I or CN and/or in which one or more H is replaced by a cationic or anionic group, or R is a saturated or unsaturated, non-aromatic carbo- or heterocyclic group, or an aryl, heteroaryl, aryloxy or heteroaryloxy group, wherein each of the aforementioned cyclic groups has 5 to 20 ring atoms, is mono- or polycyclic, does optionally contain fused rings, and is optionally substituted by one or more identical or different groups L,
L is halogen, -CN, -NC, -NCO, -NCS, -OCN, -SCN,-C(=O)NR$^0$R$^{00}$, -C(=O)X$^0$, -C(=O)R$^0$, -NH$_2$, -NR$^0$R$^{00}$, -SH,-SR$^0$, -SO$_3$H, -SO$_2$R$^0$, -OH, -NO$_2$, -CF$_3$, -SF$_5$, optionally substituted silyl, or carbyl or hydrocarbyl with 1 to 40 C atoms that is optionally substituted and optionally comprises one or more hetero atoms, preferably alkyl, alkoxy, thioalkyl, alkylcarbonyl, alkylcarbonyloxy, alkoxycarbonyl or alkoxycarbonyloxy with 1 to 20 C atoms that is optionally fluorinated,
R$^0$, R$^{00}$ are independently of each other H or alkyl with 1 to 12 C atoms, or a silyl group with 1 to 20 Si atoms that is optionally alkylated,
X$^0$ is halogen, preferably F, Cl or Br, and **in that** the n-type semiconductor and the nanoparticles contained in the mixture are not chemically linked to each other but are separate mixture components.

**2.** The mixture according to claim 1, wherein the proportion of the nanoparticles is >0 and ≤40% by weight of the solid components of the mixture.

**3.** The mixture according to claim 1 or 2, wherein the nanoparticles comprise an insulating material.

**4.** The mixture according to any one of claims 1 to 3, wherein the nanoparticles are inert high surface area hydrophobic particles.

**5.** The mixture according to any one of claims 1 to 4, wherein the nanoparticles have a diameter from 2 nm to 500 nm in case of spherical particles, or an equivalent spherical diameter in case of irregularly shaped particles.

**6.** The mixture according to any one of claims 1 to 5, wherein the nanoparticles comprise silica.

**7.** The mixture according to any one of claims 1 to 6, wherein the nanoparticles comprise fumed silica.

**8.** The mixture according to any one of claims 1 to 7, wherein said groups R are selected from the following formulae

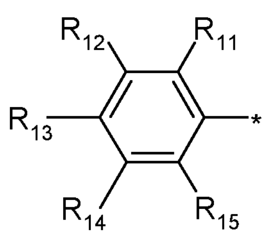
C-1

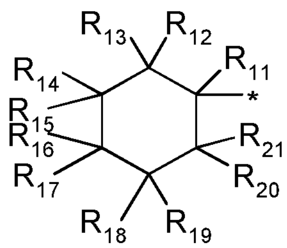
C-2

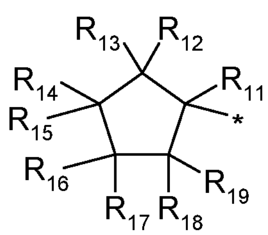
C-3

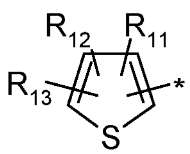
C-4

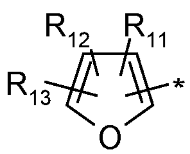
C-5

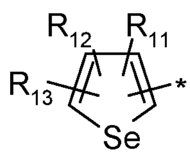
C-6

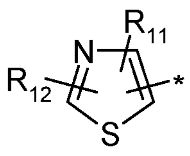
C-7

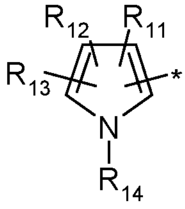
C-8

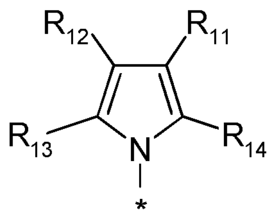
C-9

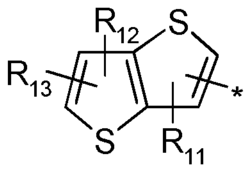
C-10

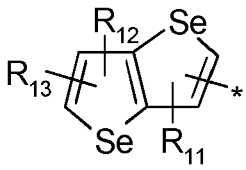
C-11

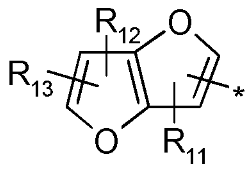
C-12

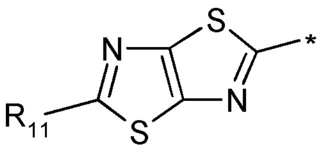
C-13

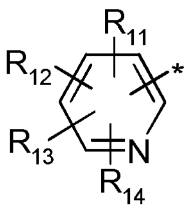
C-14

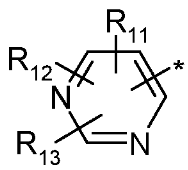
C-15

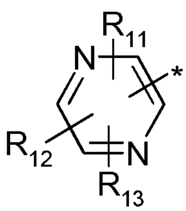
C-16

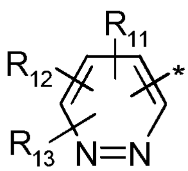
C-17

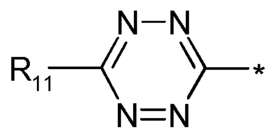
C-18

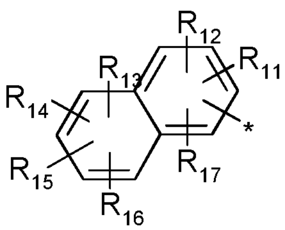
C-19

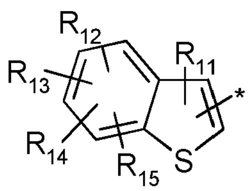
C-20

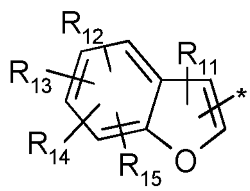
C-21

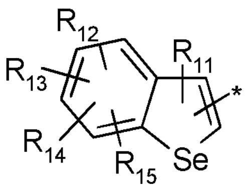

C-22

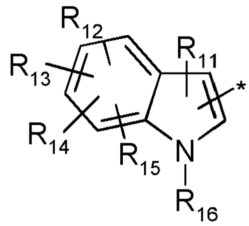

C-23

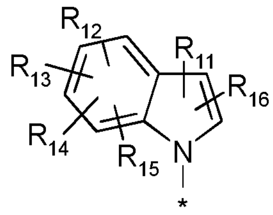

C-24

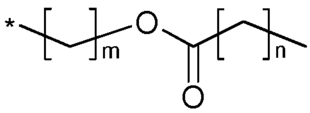

C-25

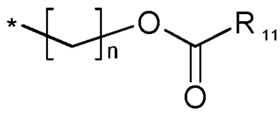

C-26

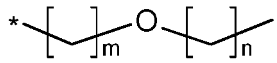

C-27

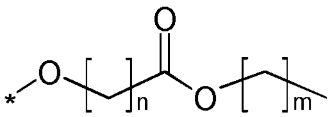

C-28

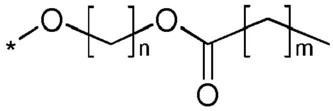

C-29

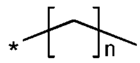

C-30

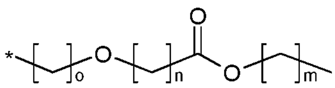

C-31

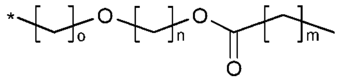

C-32

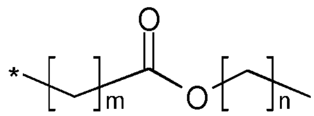

C-33

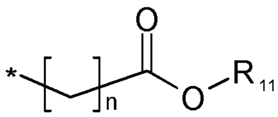

C-34

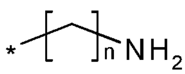

C-35

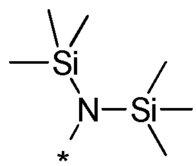

C-36

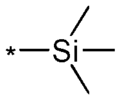

C-37

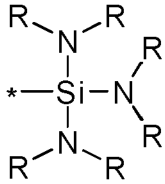

C-38

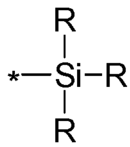

C-39

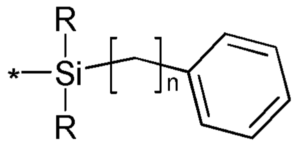

C-40

wherein

n is integer from 0 to 9, more preferably from 0 to 5;
m is integer from 0 to 9, more preferably from 0 to 5;
o is integer from 0 to 9, more preferably from 0 to 5;
R, $R^{11}$-$R^{21}$ denote H, halogen, CN, an alkyl group with 1 to 50 C atoms, which is straight-chain, branched or cyclic, and in which one or more $CH_2$ groups are optionally replaced by-O-, -S-, -C(=O)-, -C(=S)-, -C(=O)-O-, -O-C(=O)-, -$NR^0$-,-C(=O)-$NR^0$-, -$NR^0$-C(=O)-, -$SiR^0R^{00}$-, -$CF_2$-, -$CR^0$=$CR^{00}$-,-$CR^0$=N-, -N=N-,or -C≡C- in such a manner that O and/or S atoms are not linked directly to one another, and/or in which one or more H atoms are optionally replaced by F, Cl, Br, I or CN and/or in which one or more H is replaced by a cationic or anionic group, or a saturated or unsaturated, non-aromatic carbo- or heterocyclic group, or an aryl, heteroaryl, aryloxy or heteroaryloxy group, wherein each of the aforementioned cyclic groups has 5 to 20 ring atoms, is mono- or polycyclic, does optionally contain fused rings, and is optionally substituted by one or more identical or different groups L as defined above,
$R^0$, $R^{00}$ have the meanings given in claim 1.

**9.** The mixture according to any one of claims 1 to 8, wherein the nanoparticles have a porous surface with a BET surface area > 25 $m^2$/g.

**10.** The mixture according to any one of claims 1 to 9, wherein the p-type semiconductor is a conjugated polymer.

**11.** The mixture according to any one of claims 1 to 10, wherein the p-type semiconductor is a conjugated polymer comprising one or more units selected from the following formulae

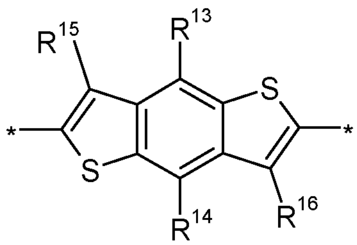
1

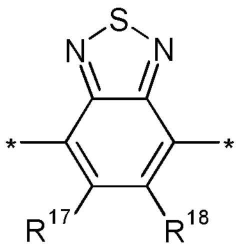
2

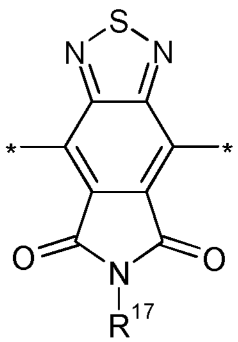
3

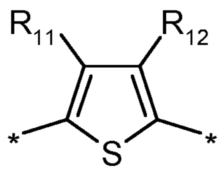

Sp1

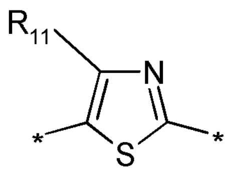

Sp2

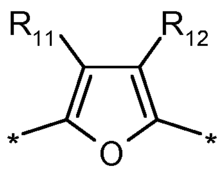

Sp3

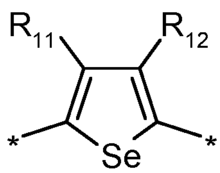

Sp4

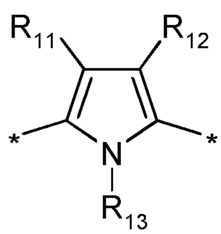

Sp5

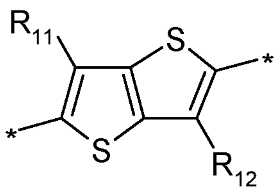

Sp6

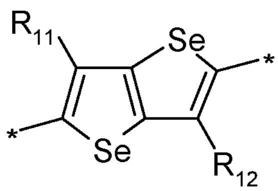

Sp7

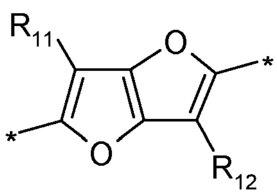

Sp8

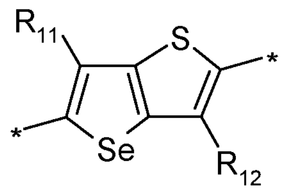

Sp9

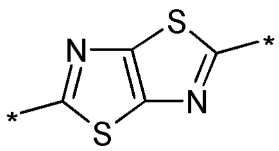

Sp10

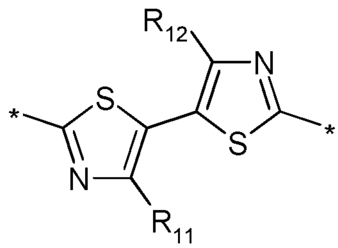

Sp11

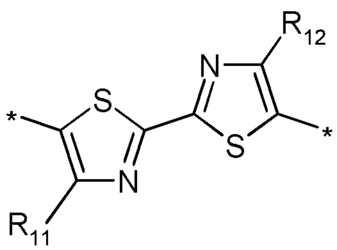

Sp12

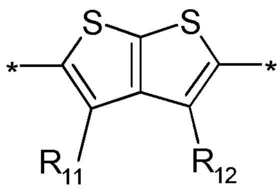

Sp13

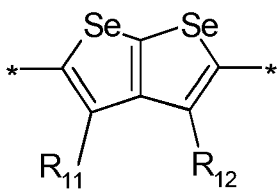

Sp14

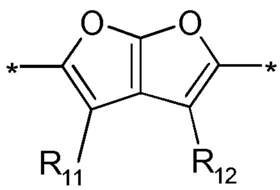

Sp15

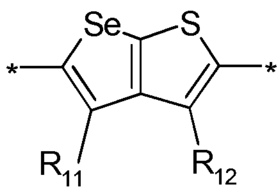

Sp16

wherein $R^{13}$-$R^{17}$ have independently of each other one of the meanings given in claim 8.

**12.** The mixture according to any one of claims 1 to 11, wherein the p-type semiconductor is a conjugated polymer selected from the following formulae

$$-[(D\text{-}Sp)_x\text{-}(A\text{-}Sp)_y]_p\text{-} \quad P1$$

$$-[(D\text{-}Sp\text{-}A^{1}\text{-}Sp)_x\text{-}(D\text{-}Sp\text{-}A^{2}\text{-}Sp)_y]_p\text{-} \quad P2$$

$$-[(D\text{-}Sp\text{-}A^{1}\text{-}Sp)_x\text{-}(D\text{-}A^{2})_y]_p\text{-} \quad P3$$

wherein

D denotes, on each occurrence identically or differently, a unit of formula 1 as defined in claim 11,
A denotes, on each occurrence identically or differently, a unit of formula 2 or 3 as defined in claim 11,
Sp denotes, on each occurrence identically or differently, a unit selected from formulae Sp1 to Sp16 as defined in claim 11,
$A^1$, $A^2$ have one of the meanings given for A,
x, y denote the molar fraction of the respective unit,
x and y are each, independently of one another >0 and <1, with x+y=1, and
p is an integer >1.

**13.** The mixture according to any one of claims 1 to 12, wherein the p-type semiconductor is a conjugated polymer selected from the following formulae

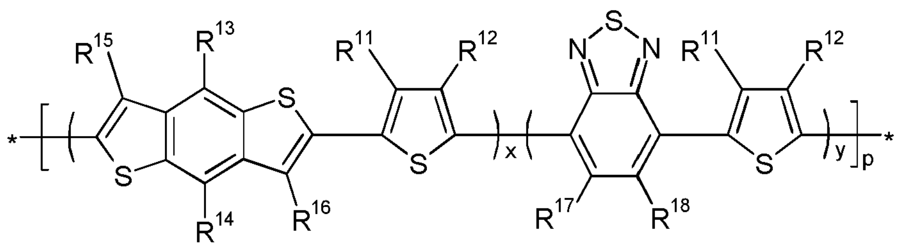
P1a

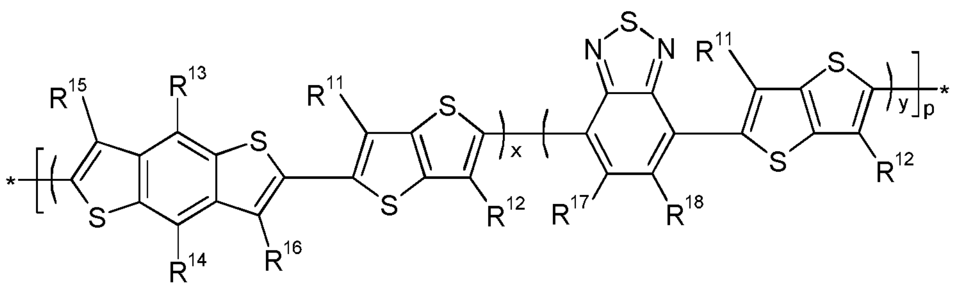
P1b

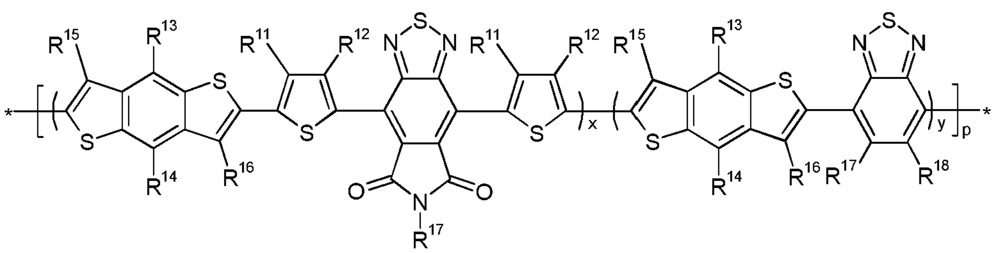
P3a

wherein $R^{11\text{-}16}$, x, y and p are as defined in claim 11 and 12.

**14.** The mixture according to any of claims 1 to 13, wherein the n-type semiconductor is a fullerene or substituted fullerene.

**15.** The mixture according to any of claims 1 to 14, wherein the n-type semiconductor is a fullerene or substituted

fullerene selected of formula XII

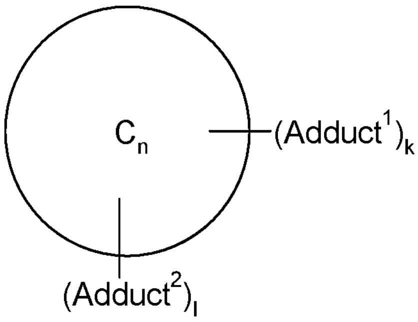

XII

wherein

$C_n$ denotes a fullerene composed of n carbon atoms, optionally with one or more atoms trapped inside,
$Adduct^1$ is a primary adduct appended to the fullerene $C_n$ with any connectivity,
Adduct2 is a secondary adduct, or a combination of secondary adducts, appended to the fullerene $C_n$ with any connectivity,
k is an integer ≥ 1, and
l is 0, an integer ≥ 1, or a non-integer > 0.

**16.** The mixture according to any of claims 1 to 15, wherein the n-type semiconductor is a fullerene or substituted fullerene containing one or more primary and secondary adducts, or $Adduct^1$ and $Adduct^2$, selected from the following formulae

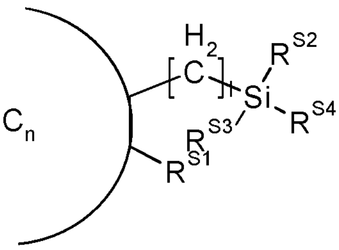

S-1

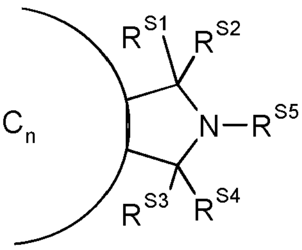

S-2

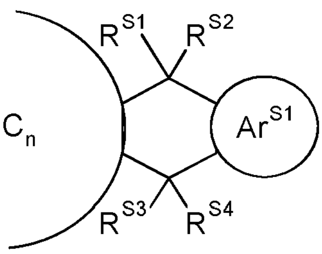

S-3

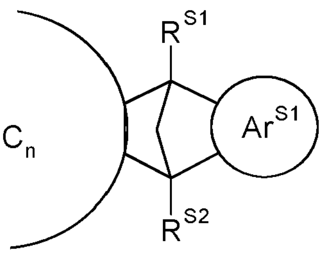

S-4

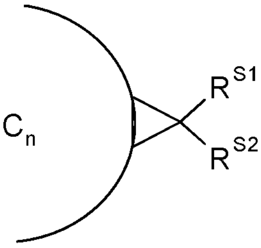 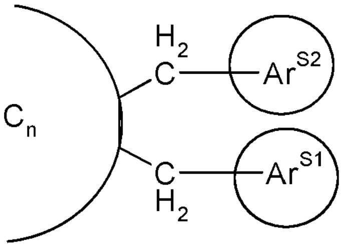 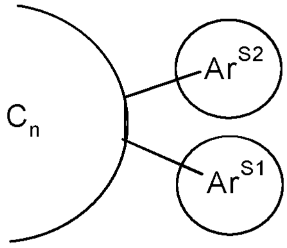

S-5 S-6 S-7

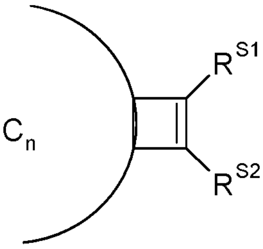 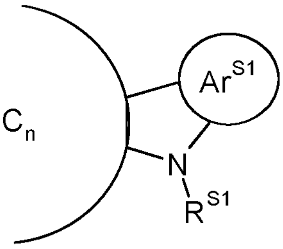 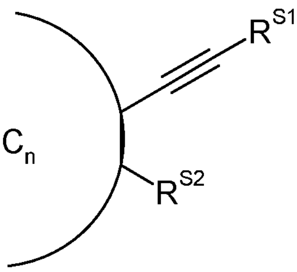

S-8 S-9 S-10

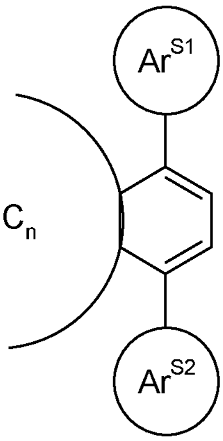 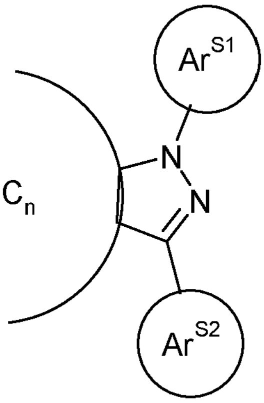 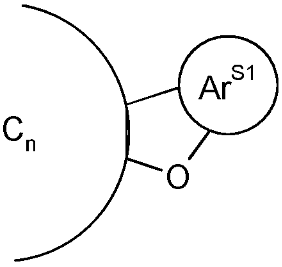

S-11 S-12 S-13

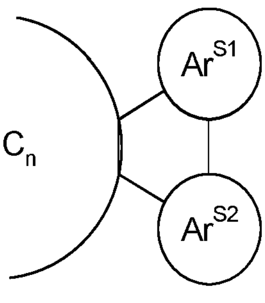

S-14

wherein

$Ar^{S1}$, $Ar^{S2}$ denote, independently of each other, an arylene or heteroarylene group with 5 to 20 ring atoms, which is mono- or polycyclic, and which is optionally substituted by one or more identical or different substituents having one of the meanings of $R^{11}$ as defined in claim 8,

$R^{S1}$, $R^{S2}$, $R^{S3}$, $R^{S4}$ and $R^{S5}$ independently of each other denote H, CN or have one of the meanings of $R^{11}$ as

defined in claim 8.

**17.** The mixture according to any of claims 1 to 16, wherein the n-type semiconductor is a fullerene or substituted fullerene selected from the following subformulae:

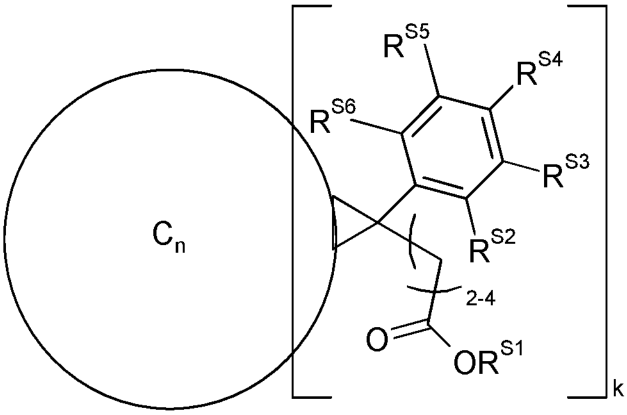

XIIa

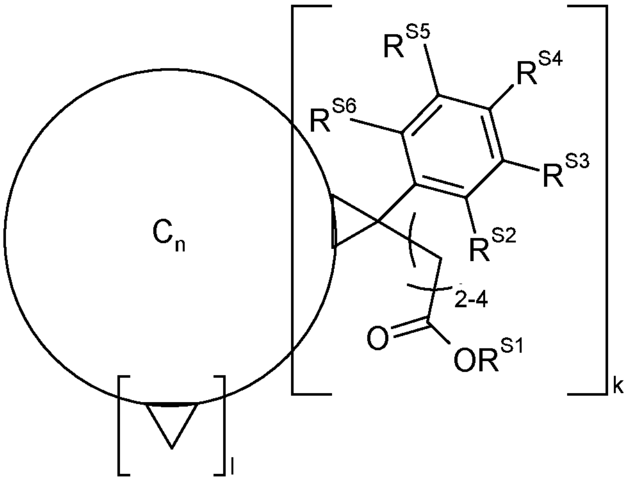

XIIb

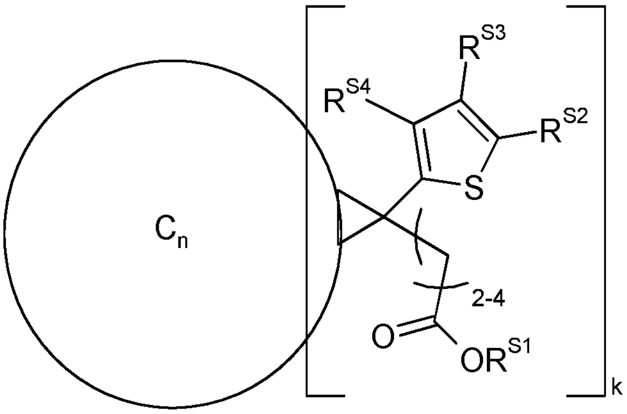

XIIc

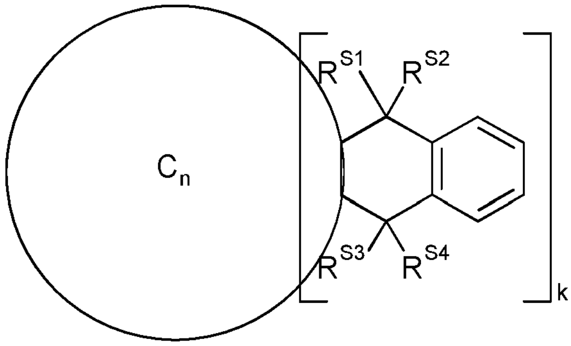

XIId

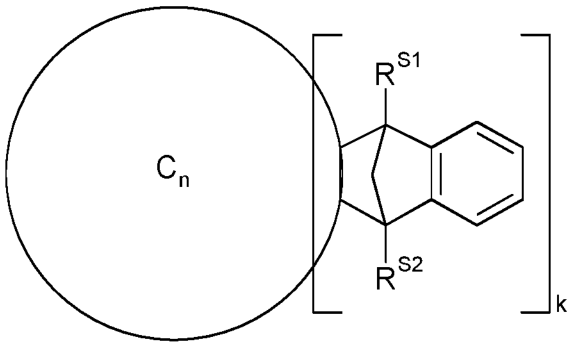

XIIe

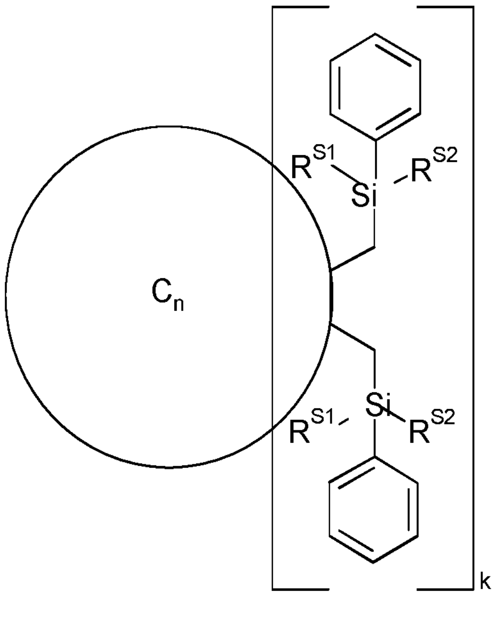

XIIf

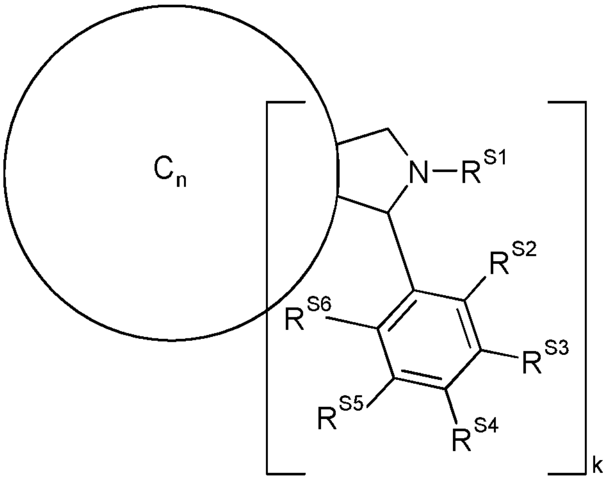

XIIg

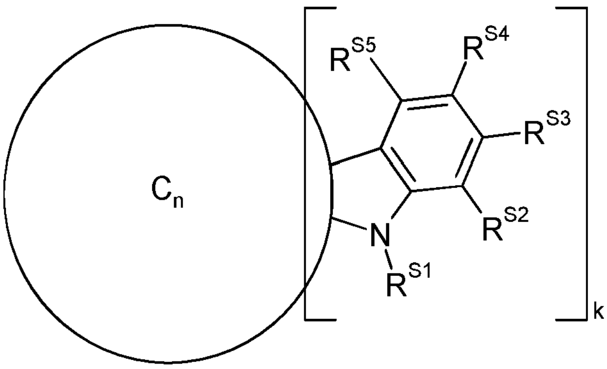

XIIh

wherein $R^{S1}$, $R^{S2}$, $R^{S3}$, $R^{S4}$ $R^{S5}$ and $R^{S6}$ independently of each other denote H or have one of the meanings of $R^{11}$ as defined in claim 8, and k is as defined in claim 15.

**18.** The mixture according to any of claims 1 to 17, wherein the n-type semiconductor is selected from PCBM-C60, PCBM-C70 and mixtures thereof.

**19.** The mixture according to any one of claims 1 to 18, further comprising one or more compounds which are selected from compounds having one or more of a semiconducting, charge transport, hole transport, electron transport, hole blocking, electron blocking, electrically conducting, photoconducting, photoactive and light emitting property.

**20.** A semiconducting, charge transport, electrically conducting, photoconducting, photoactive, thermoelectric or light emitting material, which comprises or consists of a mixture according to any one of claims 1 to 19.

**21.** Use of a mixture according to any one of claims 1 to 19 as semiconducting, charge transport, electrically conducting, photoconducting, photoactive, thermoelectric or light emitting material in an organic electronic (OE) device, or in a component of such an OE device, or in an assembly comprising such an OE device or such a component.

**22.** The mixture according to any one of claims 1 to 19, further comprising one or more solvents selected from organic solvents.

**23.** A method of preparing OE device, or a component thereof, or an assembly comprising it, using a mixture according to claim 22.

**24.** An OE device, or a component thereof, or an assembly comprising it, which comprises a mixture according to any one of claims 1 to 19 or a semiconducting, charge transport, electrically conducting, photoconducting, photoactive or light emitting material according to claim 20.

**25.** The OE device according to claim 24, which is an optical, electrooptical, electronic, photoactive, electroluminescent

or photoluminescent device.

26. The OE device according to claim 25, which is an organic field effect transistor (OFET), organic thin film transistor (OTFT), organic light emitting diode (OLED), organic light emitting transistor (OLET), organic photovoltaic device (OPV), organic photodetector (OPD), organic solar cell, dye sensitized solar cell (DSSC), perovskite based solar cell, laser diode, Schottky diode, photoconductor, photodetector or thermoelectric device.

27. The component according to claim 24, which is a charge injection layer, charge transport layer, interlayer, planarising layer, antistatic film, polymer electrolyte membrane (PEM), conducting substrate or conducting pattern.

28. The assembly according to claim 24, which is an integrated circuit (IC), radio frequency identification (RFID) tag, security marking or security device, flat panel display, backlight, electrophotographic device, electrophotographic recording device, organic memory device, sensor device, biosensor or biochip.

29. The OE device according to claim 26, which is a bulk heterojunction (BHJ) OPV device, or an inverted BHJ OPV device.

30. A BHJ which comprises, or is being formed from, a mixture according to any one of claims 1 to 19 and 22.

**Patentansprüche**

1. Gemisch zur Verwendung beim Bilden einer Lösung, wobei das Gemisch einen p-Typ-Halbleiter, einen n-Typ-Halbleiter, und ein oder mehrere Nanoteilchen umfasst, wobei die Nanoteilchen Siliciumdioxid, Zeolith, Kohlenstoff, aktivierten Kohlenstoff, Silsesquioxan, Polysilsesquioxan, Ton, oder eine Kombination der vorgenannten umfassen, **dadurch gekennzeichnet, dass** die Nanoteilchen hydrophob sind und dadurch, dass die Nanoteilchen durch eine oder mehrere gleiche oder verschiedene Gruppen R substituiert sind, wobei
R CN oder eine Alkylgruppe mit 1 bis 50 C-Atomen ist, die geradkettig, verzweigt oder cyclisch ist und in der eine oder mehrere $CH_2$-Gruppen gegebenenfalls so durch -O-, -S-, -C(=O)-, -C(=S)-, -C(=O)-O-, -O-C(=O)-, $-NR^0-$, $-C(=O)-NR^0-$, $-NR^0-C(=O)-$, $-SiR^0R^{00}-$, $-CF_2-$, $-CR^0=CR^{00}-$, $-CR^0=N-$, -N=N- oder -C≡C- ersetzt sind, dass O- und/oder S-Atome nicht direkt miteinander verbunden sind, und/oder in der ein oder mehrere H-Atome gegebenenfalls durch F, Cl, Br, I oder CN ersetzt sind, und/oder in der ein oder mehrere H durch eine kationische oder anionische Gruppe ersetzt ist, oder R eine gesättigte oder ungesättigte, nichtaromatische carbo- oder heterocyclische Gruppe, oder eine Aryl-, Heteroaryl-, Aryloxy- oder Heteroaryloxy-Gruppe ist, wobei jede der vorgenannten cyclischen Gruppen 5 bis 20 Ringatome aufweist, mono- oder polycyclisch ist, gegebenenfalls kondensierte Ringe enthält und gegebenenfalls durch eine oder mehrere gleiche oder verschiedene Gruppen L substituiert ist,
L Halogen, -CN, -NC, -NCO, -NCS, -OCN, -SCN, $-C(=O)NR^0R^{00}$, $-C(=O)X^0$, $-C(=O)R^0$, $- NH_2$, $-NR^0R^{00}$, -SH, $-SR^0$, $-SO_3H$, $-SO_2R^0$, -OH, $-NO_2$, $-CF_3$, $-SF_5$, gegebenenfalls substituiertes Silyl, oder Carbyl oder Hydrocarbyl mit 1 bis 40 C-Atomen, das gegebenenfalls substituiert ist und gegebenenfalls ein oder mehrere Heteroatome umfasst, vorzugsweise Alkyl, Alkoxy, Thioalkyl, Alkylcarbonyl, Alkylcarbonyloxy, Alkoxycarbonyl oder Alkoxycarbonyloxy mit 1 bis 20 C-Atomen ist, das gegebenenfalls fluoriert ist,
$R^0$, $R^{00}$ unabhängig voneinander H oder Alkyl mit 1 bis 12 C-Atomen, oder eine Silylgruppe mit 1 bis 20 Si-Atomen sind, die gegebenenfalls alkyliert ist,
$X^0$ Halogen, vorzugsweise F, Cl oder Br ist,
und dadurch, dass der n-Typ-Halbleiter und die Nanoteilchen, die in dem Gemisch enthalten sind, nicht chemisch miteinander verbunden sind, sondern getrennte Gemischbestandteile sind.

2. Gemisch nach Anspruch 1, wobei der Anteil der Nanoteilchen >0 und ≤40 Gewichts% der festen Bestandteile des Gemischs ist.

3. Gemisch nach Anspruch 1 oder 2, wobei die Nanoteilchen ein isolierendes Material umfassen.

4. Gemisch nach einem der Ansprüche 1 bis 3, wobei die Nanoteilchen inerte hydrophobe Teilchen mit großer spezifischer Oberfläche sind.

5. Gemisch nach einem der Ansprüche 1 bis 4, wobei die Nanoteilchen im Falle von kugelförmigen Teilchen einen Durchmesser von 2 nm bis 500 nm, oder im Falle von unregelmäßig geformten Teilchen einen äquivalenten Kugeldurchmesser aufweisen.

6. Gemisch nach einem der Ansprüche 1 bis 5, wobei die Nanoteilchen Siliciumdioxid umfassen.

7. Gemisch nach einem der Ansprüche 1 bis 6, wobei die Nanoteilchen pyrogenes Siliciumdioxid umfassen.

8. Gemisch nach einem der Ansprüche 1 bis 7, wobei die Gruppen R aus den folgenden Formeln ausgewählt sind

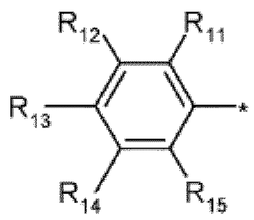

C-1

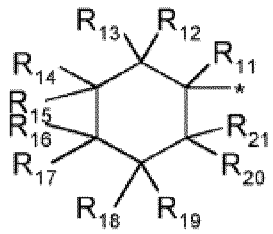

C-2

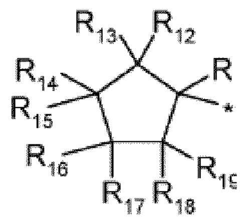

C-3

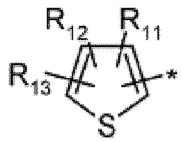

C-4

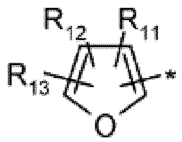

C-5

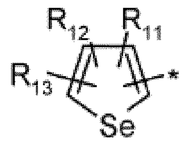

C-6

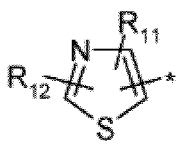

C-7

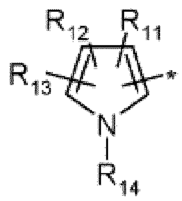

C-8

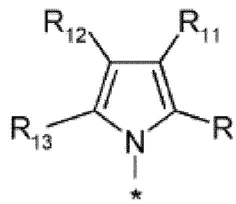

C-9

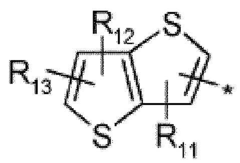

C-10

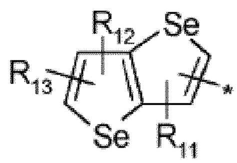

C-11

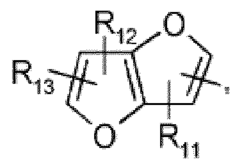

C-12

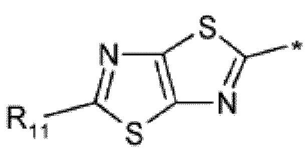

C-13

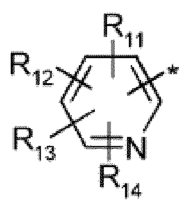

C-14

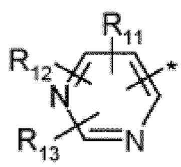

C-15

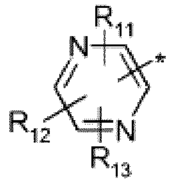
C-16

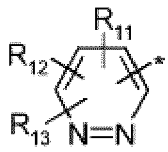
C-17

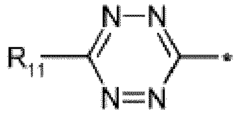
C-18

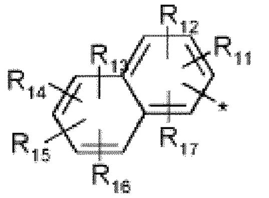
C-19

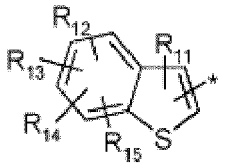
C-20

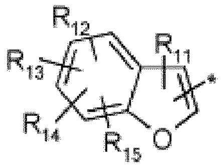
C-21

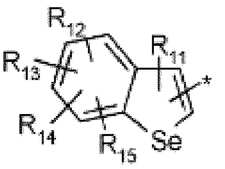
C-22

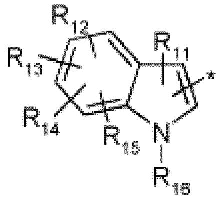
C-23

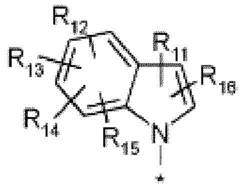
C-24

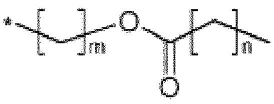
C-25

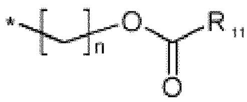
C-26

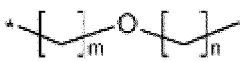
C-27

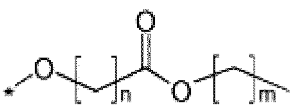
C-28

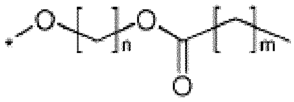
C-29

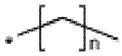
C-30

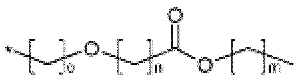
C-31

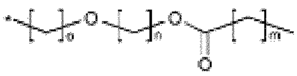
C-32

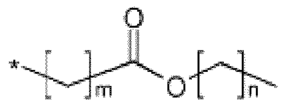
C-33

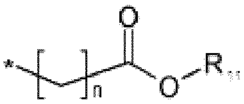
C-34

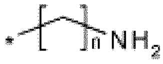
C-35

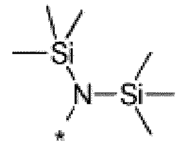
C-36

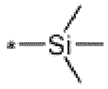

C-37

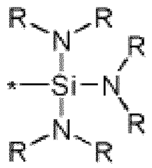

C-38

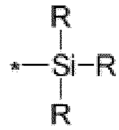

C-39

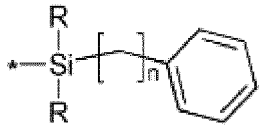

C-40

wobei

n eine ganze Zahl von 0 bis 9, bevorzugter von 0 bis 5 ist;
m eine ganze Zahl von 0 bis 9, bevorzugter von 0 bis 5 ist;
o eine ganze Zahl von 0 bis 9, bevorzugter von 0 bis 5 ist;
R, $R^{11}$-$R^{21}$ H, Halogen, CN, eine Alkylgruppe mit 1 bis 50 C-Atomen, die geradkettig, verzweigt oder cyclisch ist und in der eine oder mehrere $CH_2$-Gruppen gegebenenfalls so durch -O-, -S-, -C(=O)-, -C(=S)-, -C(=O)-O-, -O-C(=O)-, -$NR^0$-, -C(=0)-$NR^0$-, -$NR^0$-C(=O)-, - $SiR^0R^{00}$-, -CF2-, -$CR^0$=$CR^{00}$-, -$CR^0$=N-, -N=N- oder -C≡C- ersetzt sind, dass O- und/oder S-Atome nicht direkt miteinander verbunden sind, und/oder in der ein oder mehrere H-Atome gegebenenfalls durch F, Cl, Br, I oder CN ersetzt sind, und/oder in der ein oder mehrere H durch eine kationische oder anionische Gruppe ersetzt ist, oder eine gesättigte oder ungesättigte, nichtaromatische carbo- oder heterocyclische Gruppe, oder eine Aryl-, Heteroaryl-, Aryloxy- oder Heteroaryloxy-Gruppe bezeichnen, wobei jede der vorgenannten cyclischen Gruppen 5 bis 20 Ringatome aufweist, mono- oder polycyclisch ist, gegebenenfalls kondensierte Ringe enthält und gegebenenfalls durch eine oder mehrere gleiche oder verschiedene Gruppen L, wie oben definiert, substituiert ist,
$R^0$, $R^{00}$ die in Anspruch 1 gegebenen Bedeutungen besitzen.

9. Gemisch nach einem der Ansprüche 1 bis 8, wobei die Nanoteilchen eine poröse Oberfläche mit einer spezifischen BET-Oberfläche > 25 $m^2$/g aufweisen.

10. Gemisch nach einem der Ansprüche 1 bis 9, wobei der p-Typ-Halbleiter ein konjugiertes Polymer ist.

11. Gemisch nach einem der Ansprüche 1 bis 10, wobei der p-Typ-Halbleiter ein konjugiertes Polymer ist, das eine oder mehrere Einheiten umfasst, ausgewählt aus den folgenden Formeln

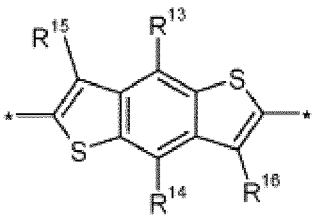

1

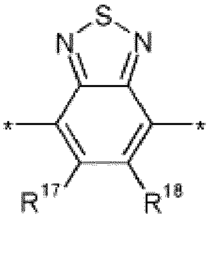

2

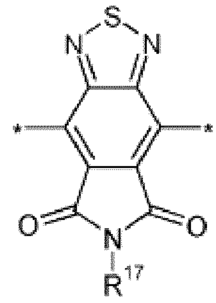

3

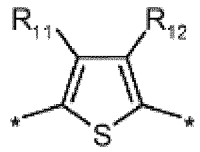

Sp1

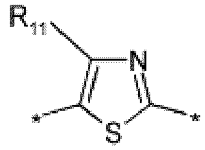

Sp2

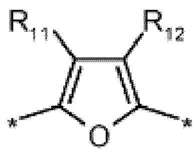

Sp3

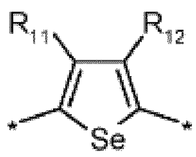

Sp4

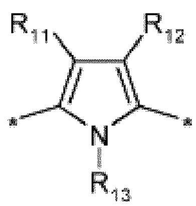

Sp5

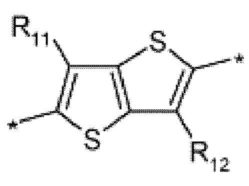

Sp6

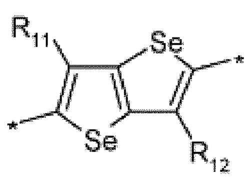

Sp7

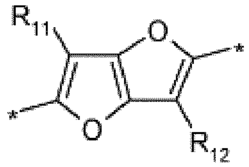

Sp8

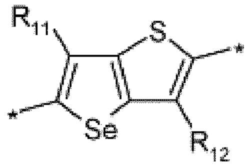

Sp9

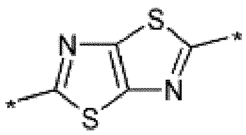

Sp10

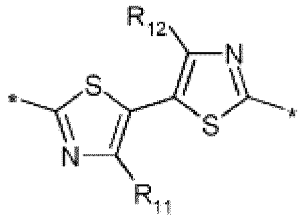

Sp11

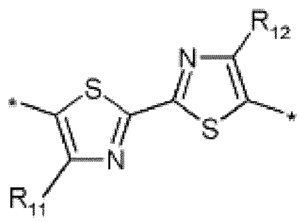

Sp12

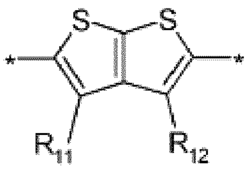

Sp13

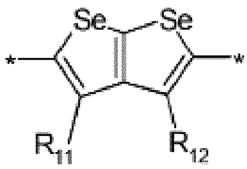

Sp14

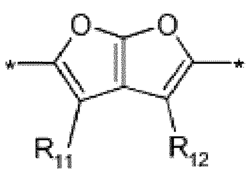

Sp15

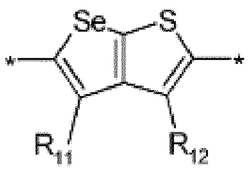

Sp16

wobei $R^{13}$-$R^{17}$ unabhängig voneinander eine der in Anspruch 8 gegebenen Bedeutungen besitzen.

**12.** Gemisch nach einem der Ansprüche 1 bis 11, wobei der p-Typ-Halbleiter ein konjugiertes Polymer ist, ausgewählt aus den folgenden Formeln

$-[(D\text{-}Sp)_x\text{-}(A\text{-}Sp)_y]_p-$ P1

-[(D-Sp-$A^l$-Sp)w(D-Sp-$A^2$-$Sp)_V$j,p- P2

$-[(D\text{-}Sp\text{-}A^1\text{-}Sp)_x\text{-}(D\text{-}A^2)_y]_p-$ P3

wobei

D bei jedem Auftreten gleich oder verschieden eine Einheit der Formel 1, wie in Anspruch 11 definiert, bezeichnet,
A bei jedem Auftreten gleich oder verschieden eine Einheit der Formel 2 oder 3, wie in Anspruch 11 definiert, bezeichnet,
Sp bei jedem Auftreten gleich oder verschieden eine Einheit bezeichnet, ausgewählt aus den Formeln Sp1 bis Sp16, wie in Anspruch 11 definiert,
$A^1$, $A^2$ eine der für A gegebenen Bedeutungen besitzt,
x, y den Molenbruch der jeweiligen Einheit bezeichnen,
x und y jeweils unabhängig voneinander >0 und <1 sind, wobei x+y=1, und
p eine ganze Zahl >1 ist.

**13.** Gemisch nach einem der Ansprüche 1 bis 12, wobei der p-Typ-Halbleiter ein konjugiertes Polymer ist, ausgewählt aus den folgenden Formeln

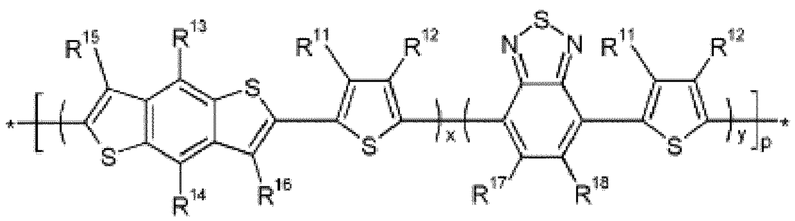

P1a

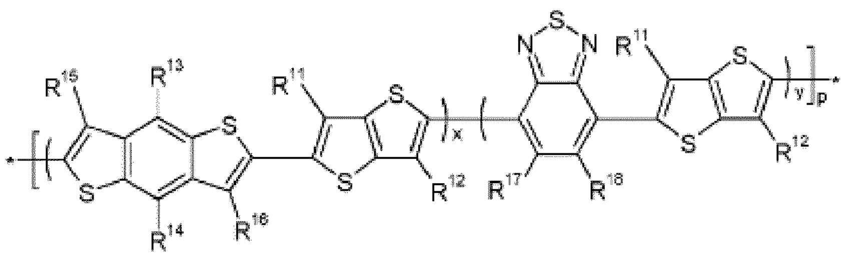

P1b

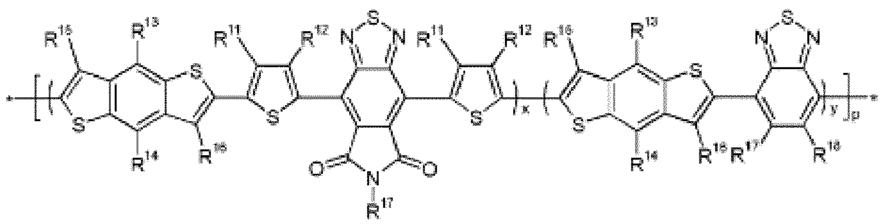

P3a

wobei $R^{11-16}$, x, y und p wie in Anspruch 11 und 12 definiert sind.

**14.** Gemisch nach einem der Ansprüche 1 bis 13, wobei der n-Typ-Halbleiter ein Fulleren oder substituiertes Fulleren ist.

**15.** Gemisch nach einem der Ansprüche 1 bis 14, wobei der n-Typ-Halbleiter ein Fulleren oder substituiertes Fulleren ist, ausgewählt aus Formel XII

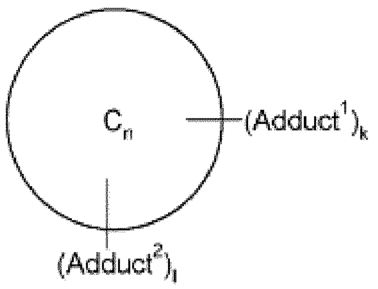

XII

wobei

$C_n$ ein aus n Kohlenstoffatomen bestehendes Fulleren, gegebenenfalls mit einem oder mehreren darin gefangenen Atomen, bezeichnet,
$Adduct^1$ ein primäres Addukt ist, das mit einer beliebigen Bindung an das Fulleren $C_n$ angehängt ist,
$Adduct^2$ ein sekundäres Addukt oder eine Kombination sekundärer Addukte ist, das/die mit einer beliebigen Bindung an das Fulleren $C_n$ angehängt ist,
k eine ganze Zahl $\geq 1$ ist, und
l 0, eine ganze Zahl $\geq 1$, oder eine nicht ganze Zahl $> 0$ ist.

**16.** Gemisch nach einem der Ansprüche 1 bis 15, wobei der n-Typ-Halbleiter ein Fulleren oder substituiertes Fulleren ist, das ein oder mehrere primäre und sekundäre Addukte, oder $Adduct^1$ und $Adduct^2$ enthält, ausgewählt aus den folgenden Formeln

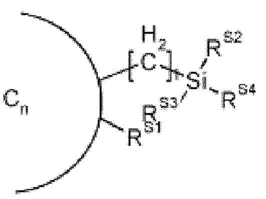

S-1

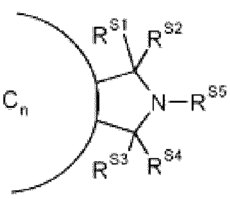

S-2

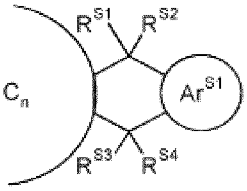

S-3

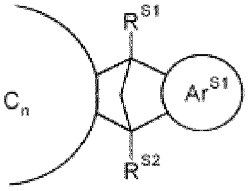

S-4

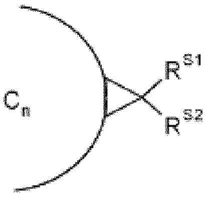

S-5

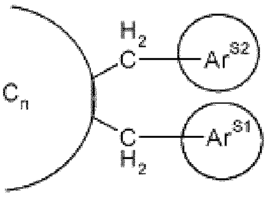

S-6

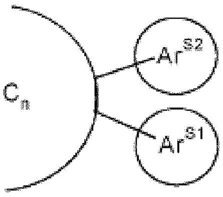

S-7

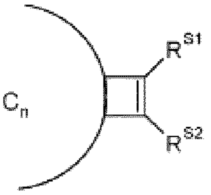

S-8

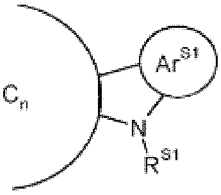

S-9

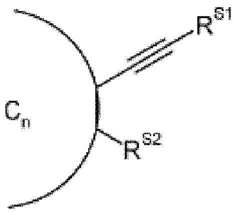

S-10

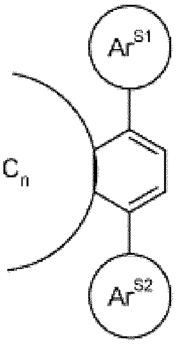

S-11

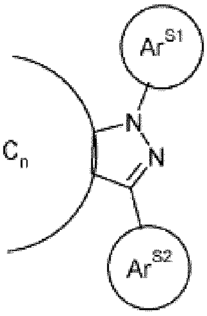

S-12

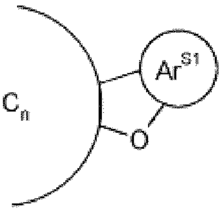

S-13

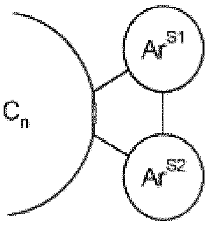

S-14

wobei

$Ar^{S1}$, $Ar^{S2}$ unabhängig voneinander eine Arylen- oder Heteroarylengruppe mit 5 bis 20 Ringatomen bezeichnen, die mono- oder polycyclisch ist und die gegebenenfalls durch einen oder mehrere gleiche oder verschiedene Substituenten substituiert ist, die eine der Bedeutungen von $R^{11}$, wie in Anspruch 8 definiert, besitzen,
$R^{S1}$, $R^{S2}$, $R^{S3}$, $R^{S4}$ und $R^{S5}$ unabhängig voneinander H, CN bezeichnen oder eine der Bedeutungen von $R^{11}$, wie in Anspruch 8 definiert, besitzen.

**17.** Gemisch nach einem der Ansprüche 1 bis 16, wobei der n-Typ-Halbleiter ein Fulleren oder substituiertes Fulleren ist, ausgewählt aus den folgenden Teilformeln:

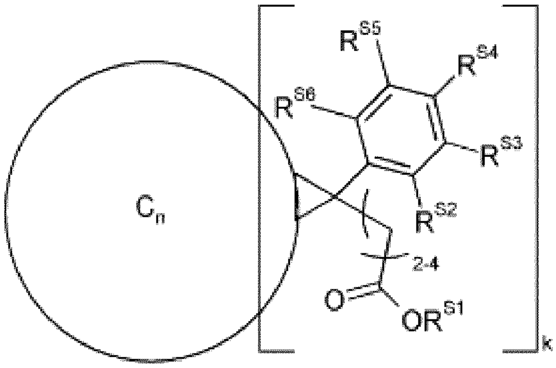

XIIa

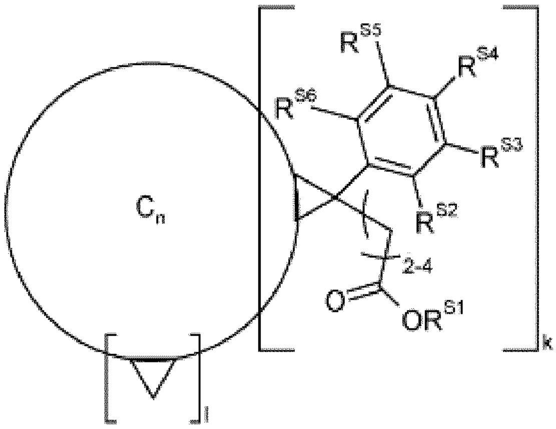

XIIb

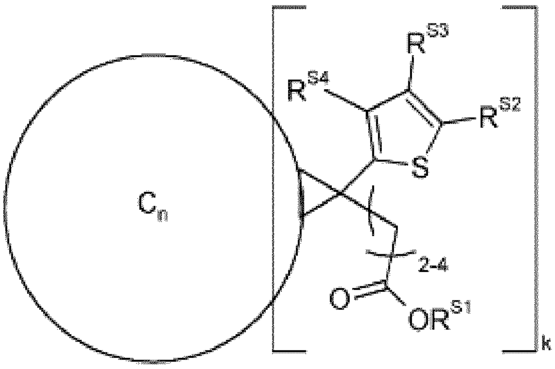

XIIc

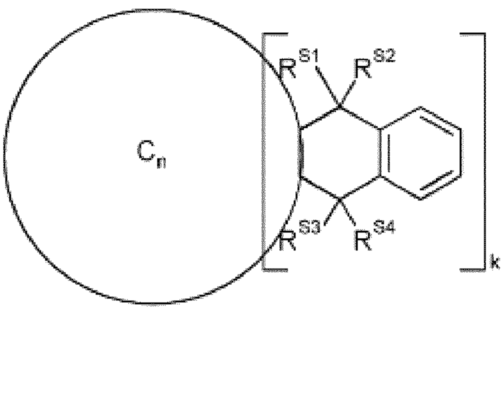

XIId

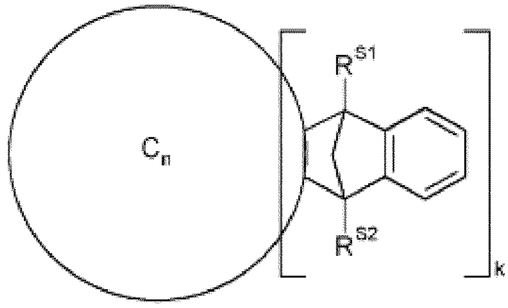

XIIe

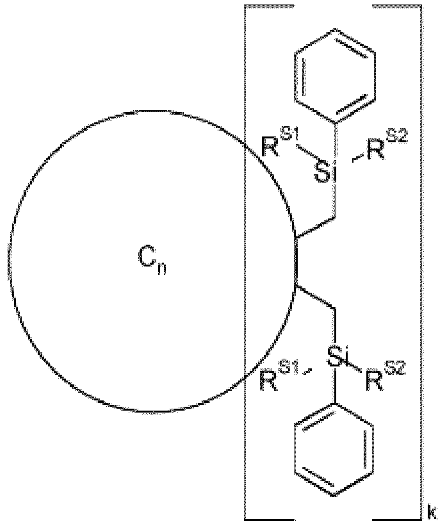

XIIf

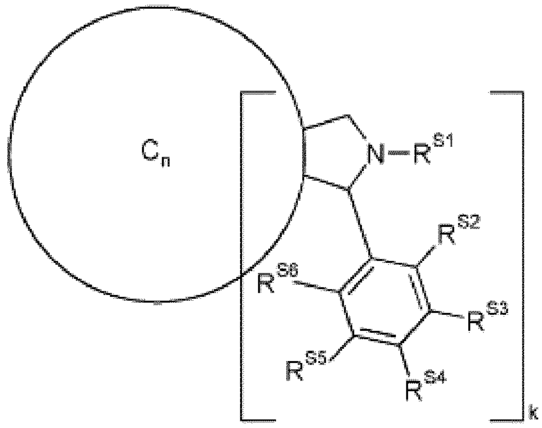

XIIg

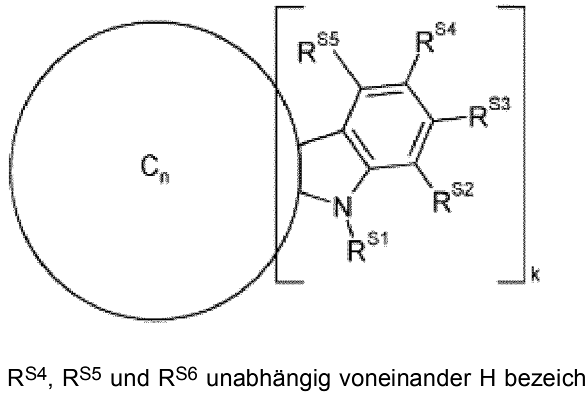

XIIh

wobei $R^{S1}$, $R^{S2}$, $R^{S3}$, $R^{S4}$, $R^{S5}$ und $R^{S6}$ unabhängig voneinander H bezeichnen oder eine der Bedeutungen

von $R^{11}$, wie in Anspruch 8 definiert, besitzen,
und k wie in Anspruch 15 definiert ist.

**18.** Gemisch nach einem der Ansprüche 1 bis 17, wobei der n-Typ-Halbleiter ausgewählt ist aus PCBM-C60, PCBM-C70 und Gemischen davon.

**19.** Gemisch nach einem der Ansprüche 1 bis 18, weiter eine oder mehrere Verbindungen umfassend, die aus Verbindungen mit einer oder mehreren aus einer halbleitenden, ladungstransportierenden, lochtransportierenden, elektronentransportierenden, lochsperrenden, elektronensperrenden, elektrisch leitenden, photoleitenden, photoaktiven und lichtemittierenden Eigenschaft ausgewählt sind.

**20.** Halbleitendes, ladungstransportierendes, elektrisch leitendes, photoleitendes, photoaktives, thermoelektrisches oder lichtemittierendes Material, das ein Gemisch nach einem der Ansprüche 1 bis 19 umfasst oder daraus besteht.

**21.** Verwendung eines Gemischs nach einem der Ansprüche 1 bis 19 als halbleitendes, ladungstransportierendes, elektrisch leitendes, photoleitendes, photoaktives, thermoelektrisches oder lichtemittierendes Material in einer organischen elektronischen (OE) Vorrichtung, oder in einem Bauteil einer solchen OE-Vorrichtung, oder in einer Baugruppe, die eine solche OE-Vorrichtung oder ein solches Bauteil umfasst.

**22.** Gemisch nach einem der Ansprüche 1 bis 19, weiter ein oder mehrere Lösungsmittel umfassend, die aus organischen Lösungsmitteln ausgewählt sind.

**23.** Verfahren zur Herstellung einer OE-Vorrichtung oder eines Bauteils davon oder einer sie umfassenden Baugruppe unter Verwendung eines Gemischs nach Anspruch 22.

**24.** OE-Vorrichtung oder Bauteil davon oder sie umfassende Baugruppe, die/das ein Gemisch nach einem der Ansprüche 1 bis 19 oder ein halbleitendes, ladungstransportierendes, elektrisch leitendes, photoleitendes, photoaktives oder lichtemittierendes Material nach Anspruch 20 umfasst.

**25.** OE-Vorrichtung nach Anspruch 24, bei der es sich um eine optische, elektrooptische, elektronische, photoaktive, elektrolumineszierende oder photolumineszierende Vorrichtung handelt.

**26.** OE-Vorrichtung nach Anspruch 25, bei der es sich um eine(n) organischen Feldeffekttransistor (OFET), organischen Dünnfilmtransistor (OTFT), organische Leuchtdiode (OLED), organischen Leuchttransistor (OLET), organische Photovoltaikvorrichtung (OPV), organischen Photodetektor (OPD), organische Solarzelle, Farbstoffsolarzelle (DSSC), Perowskit-basierte Solarzelle, Laserdiode, Schottky-Diode, Photoleiter, Photodetektor oder thermoelektrische Vorrichtung handelt.

**27.** Bauteil nach Anspruch 24, bei dem es sich um ein(e/n) Ladungsinjektionsschicht, Ladungstransportschicht, Zwischenschicht, Planarisierungsschicht, antistatischen Film, Polymerelektrolyt-Membran (PEM), leitendes Substrat oder leitendes Muster handelt.

**28.** Baugruppe nach Anspruch 24, bei der es sich um ein(e/n) integrierte Schaltung (IC), Funkfrequenz-Identifikations-(RFID) Etikett, Sicherheitsmarkierung oder Sicherheitsvorrichtung, Flachdisplay, Hintergrundbeleuchtung, elektrofotografische Vorrichtung, elektrofotografische Aufzeichnungsvorrichtung, organische Speichervorrichtung, Sensorvorrichtung, Biosensor oder Biochip handelt.

**29.** OE-Vorrichtung nach Anspruch 26, bei der es sich um eine Bulk-Heterojunction- (BHJ) OPV-Vorrichtung, oder eine invertierte BHJ-OPV-Vorrichtung handelt.

**30.** BHJ, der ein Gemisch nach einem der Ansprüche 1 bis 19 und 22 umfasst oder daraus gebildet ist.

## Revendications

**1.** Mélange pour une utilisation dans la formation d’une solution, le mélange comprenant un semi-conducteur de type p, un semi-conducteur de type n, et une ou plusieurs nanoparticules, dans lequel les nanoparticules comprennent de la silice, une zéolite, du carbone, du charbon actif, un silsesquioxane, un polysilsesquioxane, une argile, ou toute

combinaison des susmentionnés, **caractérisé en ce que** les nanoparticules sont hydrophobes et **en ce que** les nanoparticules sont substituées par un ou plusieurs groupes R identiques ou différents, dans lequel
R est un CN ou un groupe alkyle comportant 1 à 50 atomes de C, qui est à chaîne linéaire, ramifié ou cyclique, et dans lequel un ou plusieurs groupes $CH_2$ sont optionnellement remplacés par -O-, -S-,-C(=O)-, -C(=S)-, -C(=O)-O-, -O-C(=O)-, $-NR^0-$, - $C(=O)-NR^0-$, $-NR^0-C(=O)-$, $-SiR^0R^{00}-$, $-CF_2-$, $-CR^0=CR^{00}-$, $-CR^0=N-$, -N=N- ou -C≡C- de telle manière que les atomes de O et/ou de S ne sont pas liés directement les uns aux autres, et/ou dans lequel un ou plusieurs atomes de H sont optionnellement remplacés par F, Cl, Br, I ou CN et/ou dans lequel un ou plusieurs H est remplacé par un groupe cationique ou anionique, ou R est un groupe carbo- ou hétérocyclique non aromatique, saturé ou insaturé, ou un groupe aryle, hétéroaryle, aryloxy ou hétéroaryloxy, dans lequel chacun des groupes cycliques susmentionnés comporte 5 à 20 atomes de noyau, est mono- ou polycyclique, contient optionnellement des noyaux fusionnés, et est optionnellement substitué par un ou plusieurs groupes L identiques ou différents,
L est un halogène, -CN, -NC, -NCO, -NCS, -OCN, -SCN, $-C(=O)NR^0R^{00}$, $-C(=O)X^0$, - $C(=O)R^0$, $-NH_2$, $-NR^0R^{00}$, -SH,$-SR^0$, $-SO_3H$, $-SO_2R^0$, -OH, $-NO_2$, $-CF_3$, $-SF_5$, un silyle optionnellement substitué, ou un carbyle ou un hydrocarbyle comportant 1 à 40 atomes de C qui est optionnellement substitué et comprend optionnellement un ou plusieurs hétéro atomes, de préférence un alkyle, un alcoxy, un thioalkyle, un alkylcarbonyle, un alkylcarbonyloxy, un alcoxycarbonyle ou un alcoxycarbonyloxy comportant 1 à 20 atomes de C qui est optionnellement fluoré,
$R^0$, $R^{00}$ sont indépendamment l'un de l'autre un H ou un alkyle comportant 1 à 12 atomes de C, ou un groupe silyle comportant 1 à 20 atomes de Si qui est optionnellement alkylé,
$X^0$ est un halogène, de préférence F, Cl ou Br,
et **en ce que** le semi-conducteur de type n et les nanoparticules contenues dans le mélange ne sont pas liés chimiquement les uns aux autres mais sont des composants de mélange séparés.

**2.** Mélange selon la revendication 1, dans lequel la proportion des nanoparticules est > 0 et ≤ 40 % en poids des composants solides du mélange.

**3.** Mélange selon la revendication 1 ou 2, dans lequel les nanoparticules comprennent un matériau isolant.

**4.** Mélange selon l'une quelconque des revendications 1 à 3, dans lequel les nanoparticules sont des particules hydrophobes inertes à surface élevé.

**5.** Mélange selon l'une quelconque des revendications 1 à 4, dans lequel les nanoparticules présentent un diamètre de 2 nm à 500 nm en cas de particules sphériques, ou un diamètre sphérique équivalent en cas de particules de forme irrégulière.

**6.** Mélange selon l'une quelconque des revendications 1 à 5, dans lequel les nanoparticules comprennent de la silice.

**7.** Mélange selon l'une quelconque des revendications 1 à 6, dans lequel les nanoparticules comprennent de la silice sublimée.

**8.** Mélange selon l'une quelconque des revendications 1 à 7, dans lequel lesdits groupes R sont choisis parmi les formules suivantes

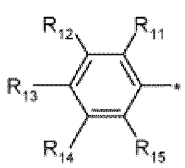
C-1

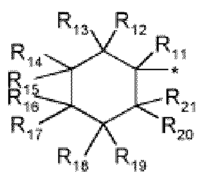
C-2

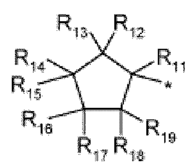
C-3

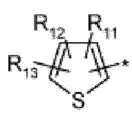
C-4

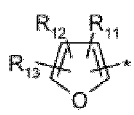
C-5

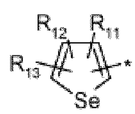
C-6

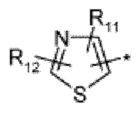
C-7

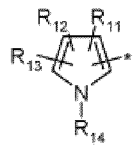
C-8

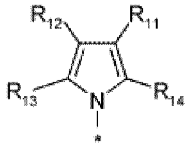
C-9

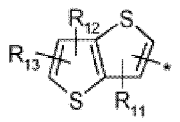
C-10

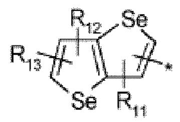
C-11

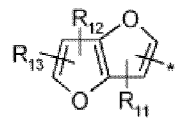
C-12

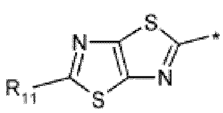
C-13

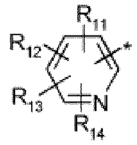
C-14

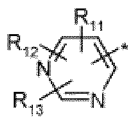
C-15

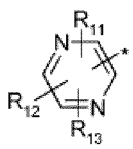
C-16

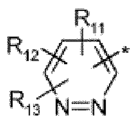
C-17

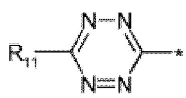
C-18

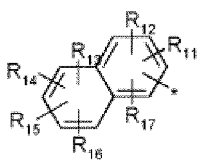
C-19

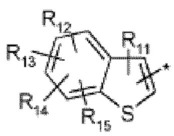
C-20

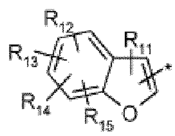
C-21

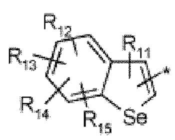
C-22

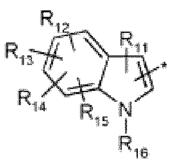
C-23

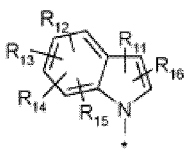
C-24

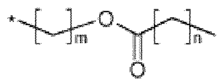
C-25

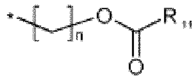
C-26

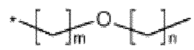
C-27

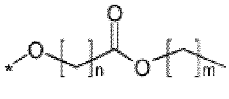
C-28

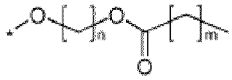
C-29

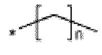
C-30

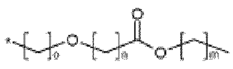
C-31

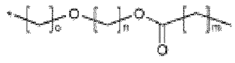
C-32

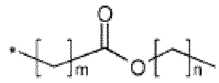
C-33

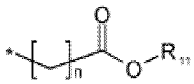
C-34

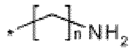
C-35

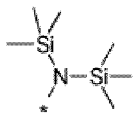
C-36

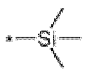
C-37

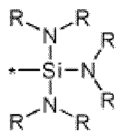
C-38

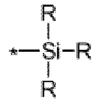
C-39

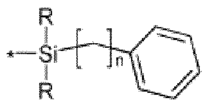
C-40

dans lequel

n est un nombre entier de 0 à 9, plus préférentiellement de 0 à 5 ;
m est un nombre entier de 0 à 9, plus préférentiellement de 0 à 5 ;
o est un nombre entier de 0 à 9, plus préférentiellement de 0 à 5 ;
R, $R^{11}$ à $R^{21}$ désignent un H, un halogène, CN, un groupe alkyle comportant 1 à 50 atomes de C, qui est à chaîne linéaire, ramifié ou cyclique, et dans lequel un ou plusieurs groupes $CH_2$ sont optionnellement remplacés par -O-, -S-, -C(=O)-, -C(=S)-, -C(=O)-O-, -OC(=O)-, $-NR^0-$, $-C(=O)-NR^0-$, $-NR^0-C(=O)-$, $-SiR^0R^{00}-$, $-CF_2-$, $-CR^0=CR^{00}-$, $-CR^0=N-$, -N=N- ou - C≡C- de telle manière que les atomes de O et/ou de S ne sont pas liés directement les uns aux autres, et/ou dans lequel un ou plusieurs atomes de H sont optionnellement remplacés par F, Cl, Br, I ou CN et/ou dans lequel un ou plusieurs H est remplacé par un groupe cationique ou anionique, ou un groupe carbo- ou hétérocyclique non aromatique, saturé ou insaturé, ou un groupe aryle, hétéroaryle, aryloxy ou hétéroaryloxy, dans lequel chacun des groupes cycliques susmentionnés comporte 5 à 20 atomes de noyau, est mono- ou polycyclique, contient optionnellement des noyaux fusionnés, et est optionnellement substitué par un ou plusieurs groupes L identiques ou différents tels que définis ci-dessus,
$R^0$, $R^{00}$ présentent les significations données dans la revendication 1.

**9.** Mélange selon l'une quelconque des revendications 1 à 8, dans lequel les nanoparticules présentent une surface poreuse ayant une surface BET > 25 $m^2/g$.

**10.** Mélange selon l'une quelconque des revendications 1 à 9, dans lequel le semi-conducteur de type p est un polymère conjugué.

**11.** Mélange selon l'une quelconque des revendications 1 à 10, dans lequel le semi-conducteur de type p est un polymère conjugué comprenant une ou plusieurs unités choisies parmi les formules suivantes

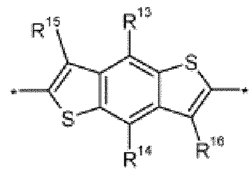

1

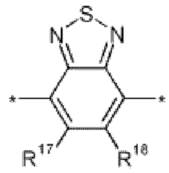

2

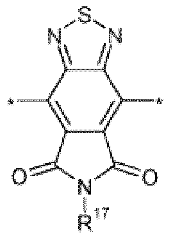

3

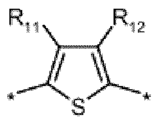

Sp1

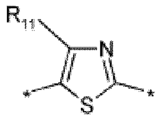

Sp2

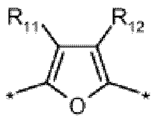

Sp3

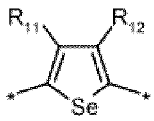

Sp4

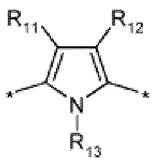

Sp5

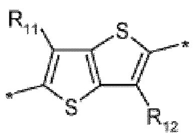

Sp6

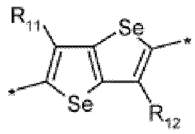

Sp7

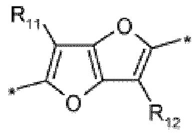

Sp8

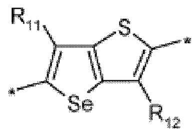

Sp9

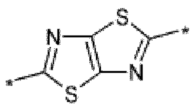

Sp10

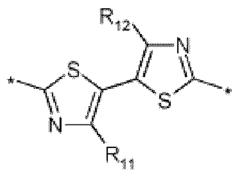

Sp11

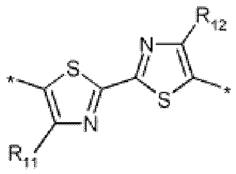

Sp12

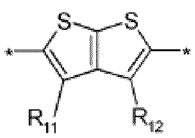

Sp13

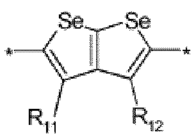

Sp14

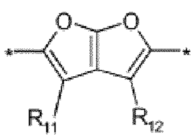

Sp15

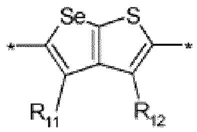

Sp16

dans lequel $R^{13}$ à $R^{17}$ présentent indépendamment les uns des autres l'une des significations données dans la revendication 8.

**12.** Mélange selon l'une quelconque des revendications 1 à 11, dans lequel le semi-conducteur de type p est un polymère conjugué choisi parmi les formules suivantes

$-[(D\text{-}Sp)_x\text{-}(A\text{-}Sp)_y]_p-$ P1

$-[(D\text{-}Sp\text{-}A^1\text{-}Sp)_x\text{-}(D\text{-}Sp\text{-}A^2\text{-}Sp)_y]_p-$ P2

$-[(D\text{-}Sp\text{-}A^1\text{-}Sp)_x\text{-}(D\text{-}A^2)_y]_p-$ P3

dans lequel

D désigne, à chaque occurrence de manière identique ou de manière différente, une unité de formule 1 selon la revendication 11,
A désigne, à chaque occurrence de manière identique ou de manière différente, une unité de formule 2 ou 3 selon la revendication 11,
Sp désigne, à chaque occurrence de manière identique ou de manière différente, une unité choisie parmi les formules Sp1 à Sp16 selon la revendication 11,
$A^1$, $A^2$ présentent l'une des significations données pour A,
x, y désignent la fraction molaire de l'unité respective,
x et y sont chacun, indépendamment l'un de l'autre > 0 et < 1, avec x + y = 1, et
p est un nombre entier > 1.

**13.** Mélange selon l'une quelconque des revendications 1 à 12, dans lequel le semi-conducteur de type p est un polymère conjugué choisi parmi les formules suivantes

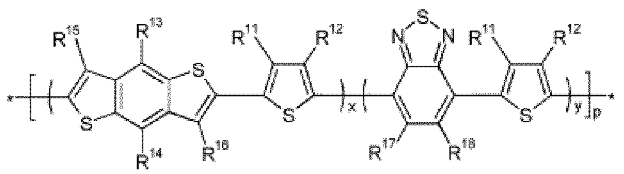

P1a

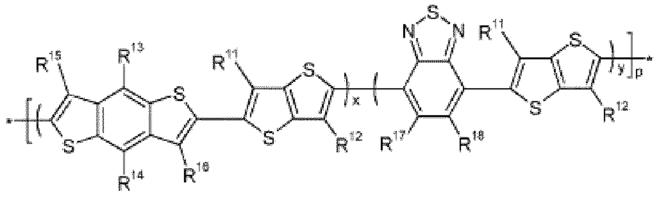

P1b

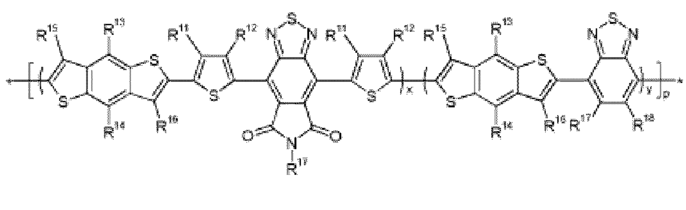

P3a

dans lequel $R^{11-16}$, x, y et p sont selon la revendication 11 et 12.

**14.** Mélange selon l'une quelconque des revendications 1 à 13, dans lequel le semi-conducteur de type n est un fullerène ou un fullerène substitué.

**15.** Mélange selon l'une quelconque des revendications 1 à 14, dans lequel le semi-conducteur de type n est un fullerène ou un fullerène substitué choisi parmi la formule XII

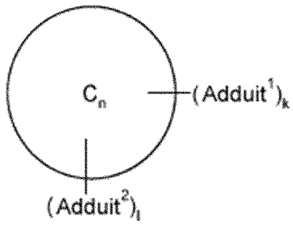

XII

dans lequel

$C_n$ désigne un fullerène composé de n atomes de carbone, comportant optionnellement un ou plusieurs atomes piégés à l'intérieur,
$Adduit^1$ est un adduit primaire annexé au fullerène $C_n$ avec toute connectivité,
$Adduit^2$ est un adduit secondaire, ou une combinaison d'adduits secondaires, annexés au fullerène $C_n$ avec toute connectivité,
k est un nombre entier $\geq 1$, et
l vaut 0, un nombre entier $\geq 1$, ou un nombre non entier $> 0$.

**16.** Mélange selon l'une quelconque des revendications 1 à 15, dans lequel le semi-conducteur de type n est un fullerène ou un fullerène substitué contenant un ou plusieurs adduits primaires et secondaires, ou $Adduit^1$ et $Adduit^2$, choisis parmi les formules suivantes

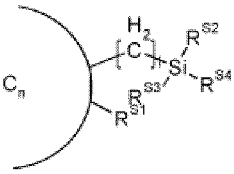

S-1

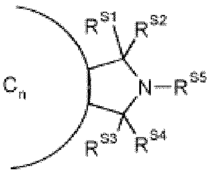

S-2

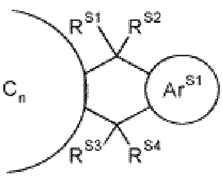

S-3

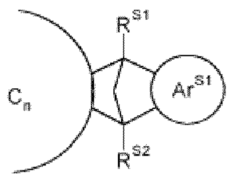

S-4

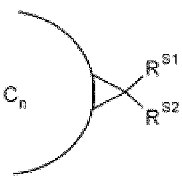

S-5

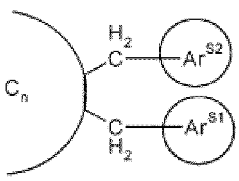

S-6

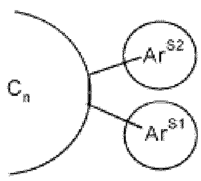

S-7

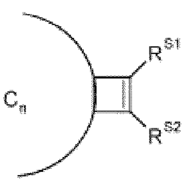

S-8

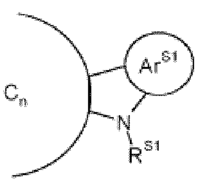

S-9

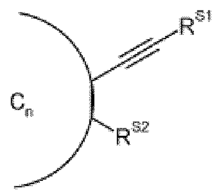

S-10

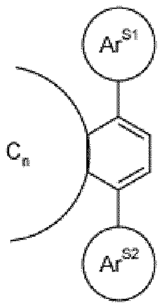

S-11

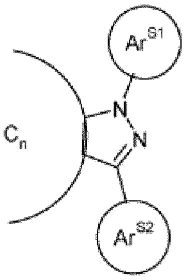

S-12

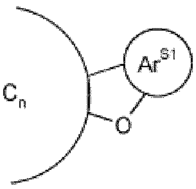

S-13

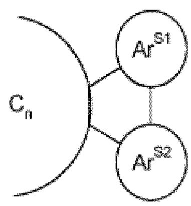

S-14

dans lequel

$Ar^{S1}$, $Ar^{S2}$ désignent, indépendamment l'un de l'autre, un groupe arylène ou hétéroarylène comportant 5 à 20 atomes de noyau, qui est mono- ou polycyclique, et qui est optionnellement substitué par un ou plusieurs substituants identiques ou différents présentant l'une des significations de $R^{11}$ selon la revendication 8,
$R^{S1}$, $R^{S2}$, $R^{S3}$, $R^{S4}$ et $R^{S5}$ indépendamment les uns des autres désignent un H, CN ou présentent l'une des significations de $R^{11}$ selon la revendication 8.

**17.** Mélange selon l'une quelconque des revendications 1 à 16, dans lequel le semi-conducteur de type n est un fullerène ou un fullerène substitué choisi parmi les sousformules suivantes :

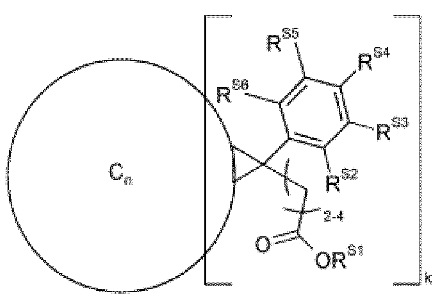

XIIa

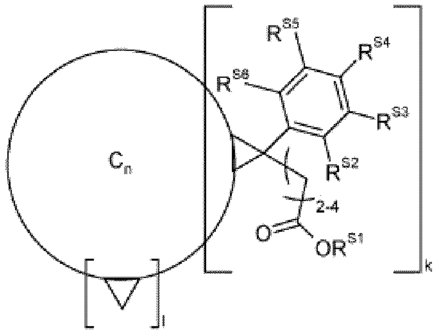
XIIb

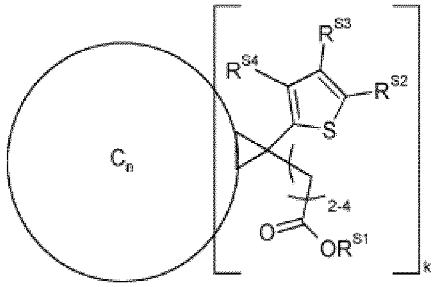
XIIc

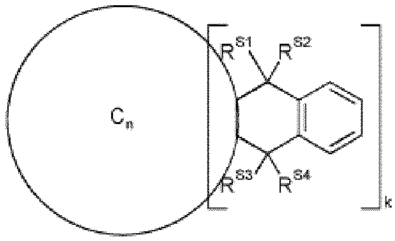
XIId

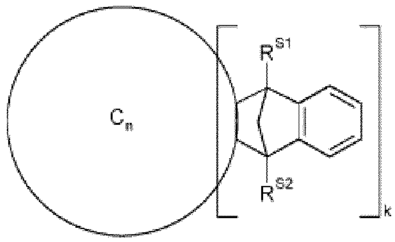
XIIe

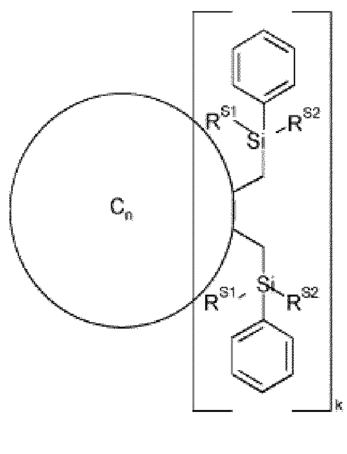
XIIf

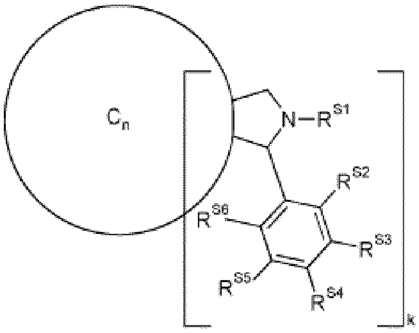

XIIg

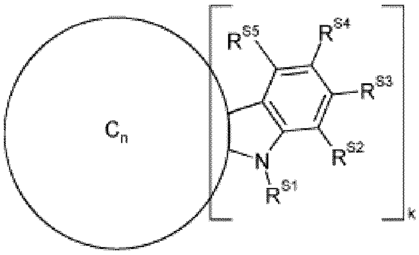

XIIh

dans lequel $R^{S1}$, $R^{S2}$, $R^{S3}$, $R^{S4}$, $R^{S5}$ et $R^{S6}$ indépendamment les uns des autres désignent un H ou présentent l'une des significations de $R^{11}$ selon la revendication 8, et k est selon la revendication 15.

**18.** Mélange selon l'une quelconque des revendications 1 à 17, dans lequel le semi-conducteur de type n est choisi parmi PCBM-C60, PCBM-C70 et des mélanges de ceux-ci.

**19.** Mélange selon l'une quelconque des revendications 1 à 18, comprenant en outre un ou plusieurs composés qui sont choisis parmi les composés présentant une ou plusieurs d'une propriété semi-conductrice, de transport de charges, de transport de trous, de transport d'électrons, de blocage de trous, de blocage d'électrons, de conduction électrique, de photoconduction, photoactive et électroluminescente.

**20.** Matériau semi-conducteur, de transport de charges, électroconducteur, photoconducteur, photoactif, thermoélectrique ou électroluminescent, qui comprend ou est constitué d'un mélange selon l'une quelconque des revendications 1 à 19.

**21.** Utilisation d'un mélange selon l'une quelconque des revendications 1 à 19 en tant que matériau semi-conducteur, de transport de charges, électroconducteur, photoconducteur, photoactif, thermoélectrique ou électroluminescent dans un dispositif électronique organique (EO), ou dans un composant d'un tel dispositif EO, ou dans un assemblage comprenant un tel dispositif EO ou un tel composant.

**22.** Mélange selon l'une quelconque des revendications 1 à 19, comprenant en outre un ou plusieurs solvants choisis parmi les solvants organiques.

**23.** Procédé de préparation d'un dispositif EO, ou d'un composant de celui-ci, ou d'un assemblage le comprenant, utilisant un mélange selon la revendication 22.

**24.** Dispositif EO, ou composant de celui-ci, ou assemblage le comprenant, qui comprend un mélange selon l'une quelconque des revendications 1 à 19 ou un matériau semi-conducteur, de transport de charges, électroconducteur, photoconducteur, photoactif, thermoélectrique ou électroluminescent selon la revendication 20.

**25.** Dispositif EO selon la revendication 24, qui est un dispositif optique, électrooptique, électronique, photoactif, électroluminescent ou photoluminescent.

**26.** Dispositif EO selon la revendication 25, qui est un transistor à effet de champ organique (OFET), un transistor en couche mince organique (OTFT), une diode électroluminescente organique (OLED), un transistor électroluminescent

organique (OLET), un dispositif photovoltaïque organique (OPV), un photodétecteur organique (OPD), une cellule solaire organique, une cellule solaire à colorant (DSSC), une cellule solaire à base de pérovskite, une diode laser, une diode Schottky, un photoconducteur, un photodétecteur ou un dispositif thermoélectrique.

**27.** Composant selon la revendication 24, qui est une couche d'injection de charges, une couche de transport de charges, une couche intermédiaire, une couche de planarisation, un film antistatique, une membrane d'électrolyte polymère (PEM), un substrat conducteur ou un motif conducteur.

**28.** Assemblage selon la revendication 24, qui est un circuit intégré (CI), une étiquette d'identification par radiofréquence (RFID), un dispositif de marquage de sécurité ou de sécurité, un dispositif d'affichage à écran plat, un rétroéclairage, un dispositif électrophotographique, un dispositif d'enregistrement électrophotographique, un dispositif de mémoire organique, un dispositif de capteur, un biocapteur ou une biopuce.

**29.** Dispositif EO selon la revendication 26, qui est un dispositif OPV à hétérojonction massive (BHJ), ou un dispositif OPV à BHJ inverse.

**30.** BHJ qui comprend, ou est formée à partir d'un mélange selon l'une quelconque des revendications 1 à 19 et 22.

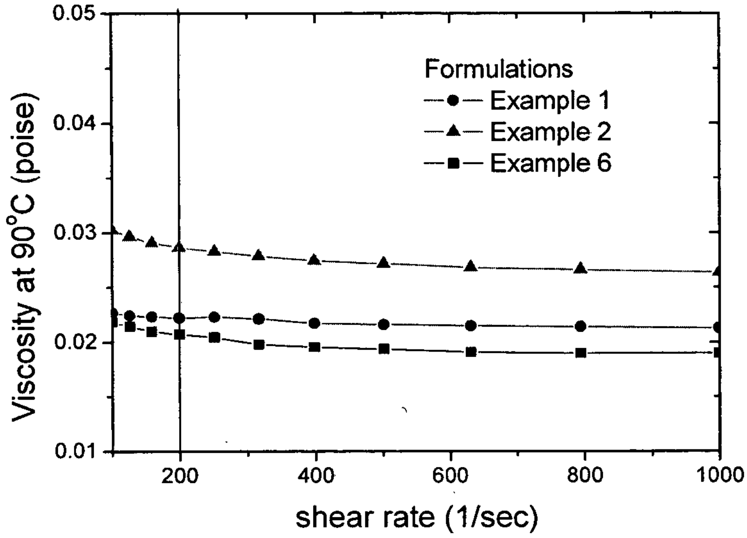
Viscosity at 90°C (poise)
0.05
0.04
0.03
0.02
0.01
200
400
600
800
1000
shear rate (1/sec)
Formulations
Example 1
Example 2
Example 6

Fig. 1

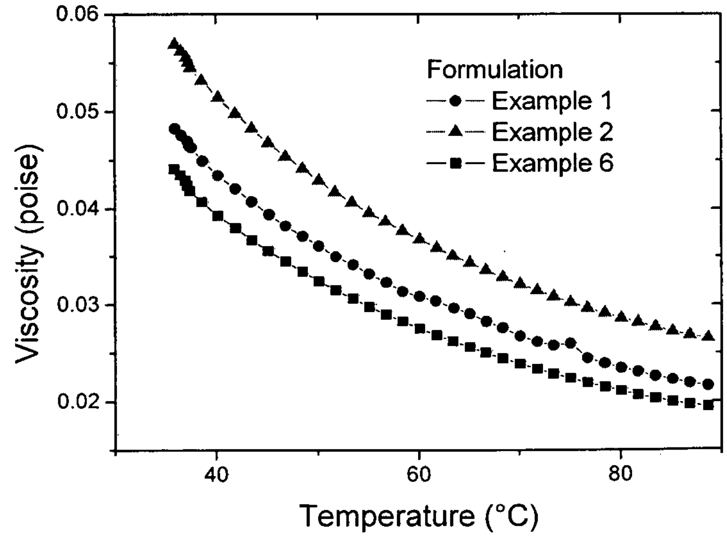
Viscosity (poise)
0.06
0.05
0.04
0.03
0.02
40
60
80
Temperature (°C)
Formulation
Example 1
Example 2
Example 6

Fig.2

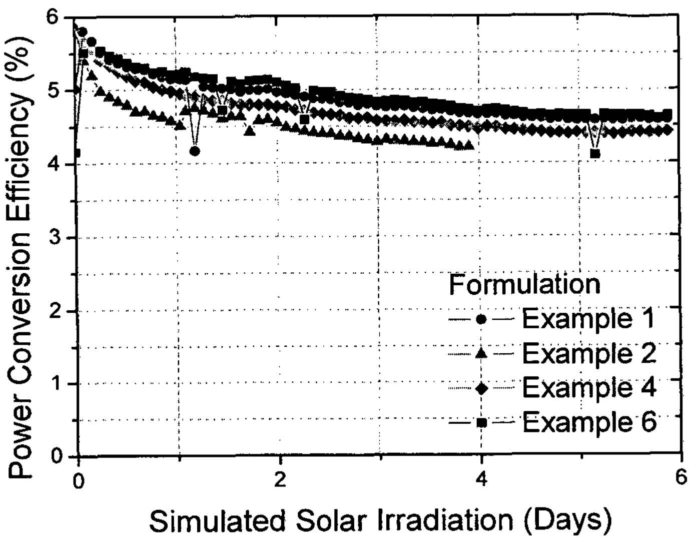
Power Conversion Efficiency (%)
Simulated Solar Irradiation (Days)
Formulation
Example 1
Example 2
Example 4
Example 6
0
1
2
3
4
5
6
0
2
4
6

**Fig.3**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 8519262 B2
- US 2011132440 A
- WO 2015006473 A
- WO 2013142841 A1
- WO 2005055248 A1
- WO 2012095796 A1
- WO 2013021971 A1
- WO 2013171520 A1
- US 5892244 A
- US 5998804 A
- US 6723394 B
- US 20070102696 A1
- US 7095044 B
- EP 0889350 A1
- EP 0528662 A
- US 5198153 A
- WO 9621659 A
- US 20030021913 A
- US 20030021913 A1
- WO 2011131280 A
- WO 2014202184 A


### Non-patent literature cited in the description


- *J. Am. Chem. Soc.,* 2008, vol. 130, 3619-3623
- *ACS Nano,* 2009, vol. 3 (6), 1415-1422
- *J. Mater. Chem.,* 2012, vol. 22, 24417-24423
- *Chem. Mater.,* 2009, vol. 21, 2598-2600
- *J. Am. Chem. Soc.,* 1938, vol. 60 (2), 309-319
- *J. Am. Chem. Soc.,* 1940, vol. 62 (7), 1723-1732
- *Langmuir,* 1998, vol. 14, 2097-2111
- *Pure Appl. Chem.,* 1996, vol. 68, 2291
- International Union of Pure and Applied Chemistry. Compendium of Chemical Technology. Gold Book, 19 August 2012, 477, , 480
- **J. THEWLIS.** Concise Dictionary of Physics. Pergamon Press, 1973
- *Pure Appl. Chem.,* 1994, vol. 66, 1134
- **J. M. G. COWIE.** Polymers: Chemistry & Physics of Modern Materials. Blackie, 1991
- *Journal of Nanomaterials,* 2012, vol. 2012, 132424
- *Chem. Rev.,* 2008, vol. 108, 3893-3957
- *Journal of Colloid and Interface Science,* 2003, vol. 264, 354-361
- *Science,* 1995, vol. 270, 1789
- **COAKLEY, K. M. ; MCGEHEE, M. D.** *Chem. Mater.,* 2004, vol. 16, 4533
- *Adv. Mater.,* 2013, vol. 25 (17), 2385-2396
- *Adv. Mater.,* 2013, vol. 25 (48), 7038-7044
- *J. Mater. Chem.,* 2011, vol. 21, 12331
- *J. Appl. Phys.,* 2013, vol. 113, 124509
- *Adv. Energy Mater.,* 2012, vol. 2, 82-86
- **WALDAUF et al.** *Appl. Phys. Lett.,* 2006, vol. 89, 233517
- **DENNLER et al.** *Proceedings of the IEEE,* 2005, vol. 93 (8), 1429
- **HOPPE et al.** *Adv. Func. Mater,* 2004, vol. 14 (10), 1005
- **J. PEET et al.** *Nat. Mater.,* 2007, vol. 6, 497
- **FRÉCHET et al.** *J. Am. Chem. Soc.,* 2010, vol. 132, 7595-7597
- *Chem. Rev.,* 2010, vol. 110, 6595-6663
- *Angew. Chem. Int. Ed.,* 2014, vol. 53, 2-15
- **MÜLLER et al.** *Synth. Metals,* 2000, vol. 111-112, 31-34
- **ALCALA.** *J. Appl. Phys.,* 2000, vol. 88, 7124-7128
- **O'MALLEY et al.** *Adv. Energy Mater.,* 2012, vol. 2, 82-86
- **C. WEDER et al.** *Science,* 1998, vol. 279, 835-837
- **L. CHEN ; D. W. MCBRANCH ; H. WANG ; R. HELGESON ; F. WUDL ; D. G. WHITTEN.** *Proc. Natl. Acad. Sci. U.S.A.,* 1999, vol. 96, 12287
- **D. WANG ; X. GONG ; P. S. HEEGER ; F. RININSLAND ; G. C. BAZAN ; A. J. HEEGER.** *Proc. Natl. Acad. Sci. U.S.A.,* 2002, vol. 99, 49
- **N. DICESARE ; M. R. PINOT ; K. S. SCHANZE ; J. R. LAKOWICZ.** *Langmuir,* 2002, vol. 18, 7785
- **D. T. MCQUADE ; A. E. PULLEN ; T. M. SWAGER.** *Chem. Rev.,* 2000, vol. 100, 2537